(19) Europäisches Patentamt
European Patent Office
Office européen des brevets

(11) EP 3 339 331 B1

(12) **EUROPEAN PATENT SPECIFICATION**

(45) Date of publication and mention of the grant of the patent:
**16.02.2022 Bulletin 2022/07**

(21) Application number: **16836996.5**

(22) Date of filing: **04.08.2016**

(51) International Patent Classification (IPC):
***C08F 2/44*** $^{(2006.01)}$ ***C08F 2/48*** $^{(2006.01)}$
***G03F 7/004*** $^{(2006.01)}$ ***G03F 7/031*** $^{(2006.01)}$

(52) Cooperative Patent Classification (CPC):
**C08F 2/44; C08F 2/48; G03F 7/004; G03F 7/031**

(86) International application number:
**PCT/JP2016/073011**

(87) International publication number:
**WO 2017/030005 (23.02.2017 Gazette 2017/08)**

(54) **COMPOSITION**

ZUSAMMENSETZUNG

COMPOSITION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.08.2015 JP 2015160662**

(43) Date of publication of application:
**27.06.2018 Bulletin 2018/26**

(73) Proprietor: **Adeka Corporation**
**Tokyo 116-8554 (JP)**

(72) Inventors:
- **MIHARA, Taiki**
**Tokyo 116-8554 (JP)**
- **KANEHARA, Yukiko**
**Tokyo 116-8554 (JP)**
- **MATSUI, Izumi**
**Tokyo 116-8554 (JP)**

(74) Representative: **Forstmeyer, Dietmar**
**BOETERS & LIECK**
**Oberanger 32**
**80331 München (DE)**

(56) References cited:
**WO-A1-2013/008652**
**WO-A1-2014/021023**
**WO-A1-2015/152153**
**JP-A- H07 295 222**
**JP-A- 2014 130 186**
**JP-A- 2015 131 937**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 339 331 B1

## Description

### Technical Field

The present invention relates to a composition containing a latent antioxidant that has a specific structure, is inactive at room temperature and is capable of being activated to exhibit its function when heated to a predetermined temperature; and a polymerization initiator that has a specific structure.

### Background Art

Photosensitive compositions are widely used for paints, coating materials, various kinds of resists, and the like.

Patent Literature 1 discloses a photosensitive colored composition for a color filter, the composition containing an antioxidant, and Patent Literature 2 discloses a photosensitive resin composition containing a phenol antioxidant. These Patent Literatures state that these compositions can exhibit improved heat resistance, but there are no statement therein that high sensitivity and high transparency can be provided through the use of a latent antioxidant.

### Citation List

### Patent Literatures

Patent Literature 1: JP 2012-247591A
Patent Literature 2: JP 2014-052424A

### Summary of Invention

### Technical Problem

Therefore, an object of the present invention is to provide a composition having excellent sensitivity and transparency.

### Solution to Problem

As a result of in-depth research, the inventors of the present invention have found that a composition containing:

(i) a latent antioxidant (A), wherein the latent antioxidant (A) has a skeleton represented by General Formula (III) below:

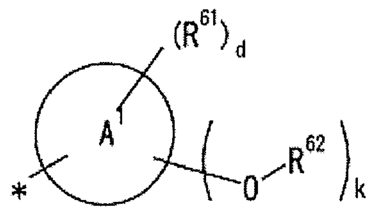
(III)

wherein

ring $A^1$ represents a five-membered or six-membered hydrocarbon ring or heterocycle,
$R^{61}$, independently for each occurence, represents a hydrogen atom, a halogen atom, a cyano group, a hydroxyl group, a nitro group, a carboxyl group, an optionally substituted alkyl group having 1 to 40 carbon atoms, an aryl group having 6 to 20 carbon atoms, an arylalkyl group having 7 to 20 carbon atoms, or a heterocycle-containing group having 2 to 20 carbon atoms,
$R^{62}$, independently for each occurence, represents an alkyl group having 1 to 20 carbon atoms, an alkenyl group having 2 to 20 carbon atoms, an aryl group having 6 to 20 carbon atoms, an arylalkyl group having 7 to 20 carbon atoms, a heterocycle-containing group having 2 to 20 carbon atoms, or a trialkylsilyl group,
a methylene group in the alkyl group or the arylalkyl group represented by $R^{61}$ and $R^{62}$ is optionally replaced

with a group obtained by combining groups selected from the group consisting of a carbon-carbon double bond, -O-, -S-, -CO-, -O-CO-, -CO-O-, -O-CO-O-, -O-CO-O-, -S-CO-, -CO-S-, -S-CO-O-, -O-CO-S-, -CO-NH-, -NH-CO-, -NH-CO-O-, -NR'-, -S-S-, and $-SO_2-$ on the condition that oxygen atoms are not adjacent to each other when combined, R' representing a hydrogen atom or an alkyl group having 1 to 8 carbon atoms,
a plurality of the $R^{61}$ are optionally linked together to form a benzene ring or a naphthalene ring,
d represents an integer from 1 to 4, and
k represents an integer from 1 to 4, a total of d and k being not more than the possible maximum number of substituents with which ring $A^1$ is optionally substituted; and

(ii) a polymerization initiator (B) including one or more oxime ester compounds represented by General Formula (I) below can achieve the above-described object, and thus have accomplished the present invention.

[Chem. 1]

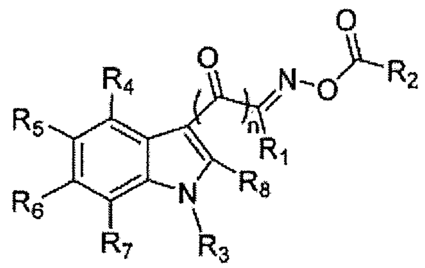

(I)

wherein

$R^1$ and $R^2$ independently represent $R^{11}$, $OR^{11}$, $COR^{11}$, $SR^{11}$, $CONR^{12}R^{13}$, or CN,
$R^{11}$, $R^{12}$, and $R^{13}$ independently represent a hydrogen atom, an alkyl group having 1 to 20 carbon atoms, an aryl group having 6 to 30 carbon atoms, an arylalkyl group having 7 to 30 carbon atoms, or a heterocycle-containing group having 2 to 20 carbon atoms,
a hydrogen atom in the group represented by $R^{11}$, $R^{12}$, and $R^{13}$ is optionally further replaced with $R^{21}$, $OR^{21}$, $COR^{21}$, $SR^{21}$, $NR^{22}R^{23}$, $CONR^{22}R^{23}$, $NR^{22}OR^{23}$, $NCOR^{22}0COR^{23}$ , $NR^{22}COR^{21}$, $OCOR^{21}$, $COOR^{21}$, $SCOR^{21}$, $OCSR^{21}$, $COSR^{21}$, $CSOR^{21}$, a hydroxyl group, a nitro group, CN, a halogen atom, or $COOR^{21}$,
$R^{21}$, $R^{22}$, and $R^{23}$ independently represent a hydrogen atom, an alkyl group having 1 to 20 carbon atoms, an aryl group having 6 to 30 carbon atoms, an arylalkyl group having 7 to 30 carbon atoms, or a heterocycle-containing group having 2 to 20 carbon atoms,
a hydrogen atom in the group represented by $R^{21}$, $R^{22}$, and $R^{23}$ is optionally further replaced with a hydroxyl group, a nitro group, CN, a halogen atom, a hydroxyl group, or a carboxyl group,
a methylene group of an alkylene moiety in the group represented by $R^{11}$, $R^{12}$, $R^{13}$, $R^{21}$, $R^{22}$, and $R^{23}$ is optionally replaced with -O-, -S-, -COO-, -OCO-, -OCOO-, $-CONR^{24}-$, $-NR^{24}-$, $-NR^{24}CO-$, $-NR^{24}COO-$, $-OCONR^{24}-$, -SCO-, -COS-, -OCS-, or -SCOO-,
$R^{24}$ represents a hydrogen atom, an alkyl group having 1 to 20 carbon atoms, an aryl group having 6 to 30 carbon atoms, an arylalkyl group having 7 to 30 carbon atoms, or a heterocycle-containing group having 2 to 20 carbon atoms,
an alkyl moiety in the group represented by $R^{11}$, $R^{12}$, $R^{13}$, $R^{21}$, $R^{22}$, $R^{23}$, and $R^{24}$ optionally has a branched side chain or is optionally a cyclic alkyl,
$R^3$ represents a hydrogen atom, an alkyl group having 1 to 20 carbon atoms, an aryl group having 6 to 30 carbon atoms, an arylalkyl group having 7 to 30 carbon atoms, or a heterocycle-containing group having 2 to 20 carbon atoms, an alkyl moiety in the group represented by $R^3$ optionally having a branched side chain or optionally being a cyclic alkyl, and pairs of $R^3$ and $R^7$, $R^3$ and $R^8$, $R^4$ and $R^5$, $R^5$ and $R^6$, and $R^6$ and $R^7$ each optionally forming a ring together,
a hydrogen atom in the group represented by $R^3$ is optionally further replaced with $R^{21}$, $OR^{21}$, $COR^{21}$, $SR^{21}$, $NR^{22}R^{23}$, $CONR^{22}R^{23}$, $NR^{22}OR^{23}$, $NCOR^{22}OCOR^{23}$, $NR^{22}COR^{21}$, $OCOR^{21}$, $COOR^{21}$, $SCOR^{21}$, $OCSR^{21}$, $COSR^{21}$, $CSOR^{21}$, a hydroxyl group, a nitro group, CN, a halogen atom, or $COOR^{21}$,
$R^4$, $R^5$, $R^6$, and $R^7$ independently represent $R^{11}$, $OR^{11}$, $SR^{11}$, $COR^{14}$, $CONR^{15}R^{16}$, $NR^{12}COR^{11}$, $OCOR^{11}$, $COOR^{14}$, $SCOR^{11}$, $OCSR^{11}$, $COSR^{14}$, $CSOR^{11}$, a hydroxyl group, CN, or a halogen atom, pairs of $R^4$ and $R^5$, $R^5$ and $R^6$, and $R^6$ and $R^7$ each optionally forming a ring together,
a hydrogen atom in the group represented by $R^4$, $R^5$, $R^6$, and $R^7$ is optionally further replaced with $R^{21}$, $OR^{21}$, $COR^{21}$, $SR^{21}$, $NR^{22}R^{23}$, $CONR^{22}R^{23}$, $NR^{22}0R^{23}$, $NCOR^{22}OCOR^{23}$ , $NR^{22}COR^{21}$, $OCOR^{21}$, $COOR^{21}$, $SCOR^{21}$,

$OCSR^{21}$, $COSR^{21}$, $CSOR^{21}$, a hydroxyl group, a nitro group, CN, a halogen atom, or $COOR^{21}$,
$R^{14}$, $R^{15}$, and $R^{16}$ represent a hydrogen atom or an alkyl group having 1 to 20 carbon atoms,
an alkyl moiety in the group represented by $R^{14}$, $R^{15}$, and $R^{16}$ optionally has a branched side chain or is optionally a cyclic alkyl,
$R^8$ represents $R^{11}$, $OR^{11}$, $SR^{11}$, $COR^{11}$, $CONR^{12}R^{13}$, $NR^{12}COR^{11}$, $OCOR^{11}$, $COOR^{11}$, $SCOR^{11}$, $OCSR^{11}$, $COSR^{11}$, $CSOR^{11}$, a hydroxyl group, CN, or a halogen atom, and
n represents 0 or 1.

Advantageous Effects of Invention

The composition according to the present invention containing a latent antioxidant having a specific structure and a polymerization initiator having a specific structure has excellent sensitivity and transparency.

Description of Embodiments

Hereinafter, a composition of the present invention will be described based on a preferred embodiment.
The composition of the present invention contains a latent antioxidant (A) and a polymerization initiator (B) including one or more oxime ester compounds represented by General Formula (I) above. These components will be described in that order below.

Latent Antioxidant (A)

The latent antioxidant (A) used in the composition of the present invention is an antioxidant that is inactive at room temperature or in a prebaking step and is capable of being activated when heated at 100 to 250°C or heated at 80 to 200°C in the presence of an acid/base catalyst to eliminate the protecting group. The latent antioxidant (A) has a skeleton represented by General Formula (III) below because it is easy to synthesize, has high heat resistance, and enhances the effects of the present invention.

[Chem. 2]

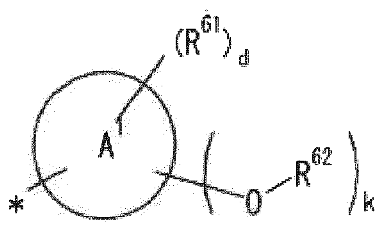

(III)

wherein, ring $A^1$ represents a five-membered or six-membered hydrocarbon ring or heterocycle,

$R^{61}$, independently for each occurence, represents a hydrogen atom, a halogen atom, a cyano group, a hydroxyl group, a nitro group, a carboxyl group, an optionally substituted alkyl group having 1 to 40 carbon atoms, an aryl group having 6 to 20 carbon atoms, an arylalkyl group having 7 to 20 carbon atoms, or a heterocycle-containing group having 2 to 20 carbon atoms,
$R^{62}$, independently for each occurence, represents an alkyl group having 1 to 20 carbon atoms, an alkenyl group having 2 to 20 carbon atoms, an aryl group having 6 to 20 carbon atoms, an arylalkyl group having 7 to 20 carbon atoms, a heterocycle-containing group having 2 to 20 carbon atoms, or a trialkylsilyl group,
a methylene group in the alkyl group or the arylalkyl group represented by $R^{61}$ and $R^{62}$ is optionally replaced with a group obtained by combining groups selected from the group consisting of a carbon-carbon double bond, -O-, -S-, -CO-, -O-CO-, -CO-O-, -O-CO-O-, -O-CO-O-, -S-CO-, -CO-S-, -S-CO-O-, -O-CO-S-, -CO-NH-, -NH-CO-, -NH-CO-O-, -NR'-, -S-S-, and $-SO_2-$ on the condition that oxygen atoms are not adjacent to each other when combined, R' representing a hydrogen atom or an alkyl group having 1 to 8 carbon atoms,
a plurality of $R^{61}$ are optionally linked together to form a benzene ring or a naphthalene ring,
d represents an integer from 1 to 4, and
k represents an integer from 1 to 4, a total of d and k being not more than the possible maximum number of substituents with which ring $A^1$ is opsionally substituted.

Among the latent antioxidants having a skeleton represented by General Formula (III) above, latent antioxidants represented by General Formula (III-A) below are preferable because they have particularly high heat resistance.

[Chem. 3]

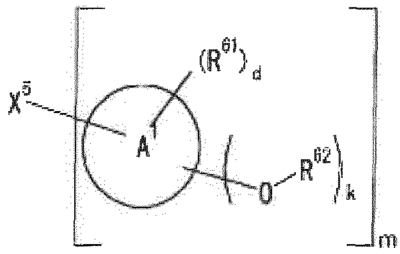

(III-A)

wherein, ring $A^1$, $R^{61}$, $R^{62}$, d, and k are the same as defined for General Formula (III) above, m represents an integer from 1 to 10, and

$X^5$ represents a direct bond or an m-valent atom, inorganic group, or organic group.

For the ring represented by $A^1$ in General Formulae (III) and (III-A) above, examples of the five-membered hydrocarbon ring include cyclopentadiene. Examples of the five-membered heterocycle include furan, thiophene, pyrrole, pyrrolidine, pyrazolidine, pyrazole, imidazole, imidazolidine, oxazole, isoxazole, isooxazolidine, thiazole, isothiazole, and isothiazolidine. Examples of the six-membered hydrocarbon ring include benzene. Examples of the six-membered heterocycle include piperidine, piperazine, morpholine, thiomorpholine, pyridine, pyrazine, pyrimidine, pyridazine, and triazine. These rings are optionally condensed with one or more other rings or substituted, and examples thereof include quinoline, isoquinoline, indole, julolidine, benzoxazole, benzotriazole, azulene, naphthalene, anthracene, fluorene, perylene, and pylene.

Examples of the halogen atom represented by $R^{61}$ include fluorine, chlorine, bromine, and iodine (hereinafter, the same holds true for all the halogen atoms).

Examples of the alkyl group having 1 to 40 carbon atoms represented by $R^{61}$ include methyl, ethyl, propyl, isopropyl, butyl, sec-butyl, tert-butyl, iso-butyl, amyl, iso-amyl, tert-amyl, cyclopentyl, hexyl, 2-hexyl, 3-hexyl, cyclohexyl, 4-methylcyclohexyl, heptyl, 2-heptyl, 3-heptyl, iso-heptyl, tert-heptyl. 1-octyl, iso-octyl, tert-octyl, and adamantyl. Examples of the alkyl group having 1 to 20 carbon atoms represented by $R^{62}$ include alkyl groups having a predetermined number of carbon atoms out of the above-mentioned alkyl groups.

Examples of the substituent with which the alkyl group having 1 to 40 carbon atoms represented by $R^{61}$ may be substituted include ethylenically unsaturated groups such as vinyl, allyl, acryl, and methacryl; halogen atoms such as fluorine, chlorine, bromine, and iodine; acyl groups such as acetyl, 2-chloroacetyl, propionyl, octanoyl, acryloyl, methacryloyl, phenylcarbonyl (benzoyl), phthaloyl, 4-trifluoromethylbenzoyl, pivaloyl, salicyloyl, oxaloyl, stearoyl, methoxycarbonyl, ethoxycarbonyl, t-butoxycarbonyl, n-octadecyloxycarbonyl, and carbamoyl; acyloxy groups such as acetyloxy and benzoyloxy; an amino group and substituted amino groups such as, ethylamino, dimethylamino, diethylamino, butylamino, cyclopentylamino, 2-ethylhexylamino, dodecylamino, anilino, chlorophenylamino, toluidino, anisidino, N-methyl-anilino, diphenylamino, naphthylamino, 2-pyridylamino, methoxycarbonylamino, phenoxycarbonylamino, acetylamino, benzoylamino, formylamino, pivaloylamino, lauroylamino, carbamoylamino, N,N-dimethylaminocarbonylamino, N,N-diethylaminocarbonylamino, morpholinocarbonylamino, methoxycarbonylamino, ethoxycarbonylamino, t-butoxycarbonylamino, n-octadecyloxycarbonylamino, N-methyl-methoxycarbonylamino, phenoxycarbonylamino, sulfamoylamino, N,N-dimethylaminosulfonylamino, methylsulfonylamino, butylsulfonylamino, and phenylsulfonylamino; a sulfonamide group, a sulfonyl group, a carboxyl group, a cyano group, a sulfo group, a hydroxyl group, a nitro group, a mercapto group, an imido group, a carbamoyl group, a sulfonamide group, a phosphonate group, a phosphate group, and salts of a carboxyl group, a sulfo group, a phosphonate group, and a phosphate group.

Examples of the aryl group having 6 to 20 carbon atoms represented by $R^{61}$ and $R^{62}$ include phenyl, naphthyl, anthracenyl, phenanthryl, fluorenyl, indenyl, 2-methylphenyl, 3-methylphenyl, 4-methylphenyl, 4-vinylphenyl, 3-iso-propylphenyl, 4-iso-propylphenyl, 4-butylphenyl, 4-iso-butylphenyl, 4-tert-butylphenyl, 4-hexylphenyl, 4-cyclohexylphenyl, 4-octylphenyl, 4-(2-ethylhexyl)phenyl, 4-stearylphenyl, 2,3-dimethylphenyl, 2,4-dimethylphenyl, 2,5-dimethylphenyl, 2,6-dimethylphenyl, 3,4-dimethylphenyl, 3,5-dimethylphenyl, 2,4-di-tert-butylphenyl, 2,5-di-tert-butylphenyl, 2,6-di-tert-butylphenyl, 2,4-di-tert-pentylphenyl, 2,5-di-tert-amylphenyl, 2,5-di-tert-octylphenyl, 2,4-dicumylphenyl, 4-cyclohexylphenyl, (1,1′-biphenyl)-4-yl, 2,4,5-trimethylphenyl, and ferrocenyl.

Examples of the arylalkyl group having 7 to 20 carbon atoms represented by $R^{61}$ and $R^{62}$ include benzyl, 1-methyl-1-phenylethyl, 1-naphthylmethyl, 9-anthracenylmethyl, 9-fluorenyl, 3-phenylpropyl, methyl-2-phenylpropan-2-yl, diphenylmethyl, triphenylmethyl, phenethyl, styryl, and cinnamyl.

Examples of the heterocycle-containing group having 2 to 20 carbon atoms represented by $R^{61}$ and $R^{62}$ include groups formed by combining a methylene chain with a heterocycle such as a pyridine ring, a pyrimidine ring, a pyridazine ring, a piperidine ring, a pyran ring, a pyrazoline ring, a triazine ring, a pyrroline ring, a quinoline ring, an isoquinoline ring, an imidazoline ring, a benzoimidazoline ring, a triazoline ring, a furan ring, a benzofuran ring, a thiadiazoline ring, a thiazoline ring, a benzothiazoline ring, a thiophene ring, an oxazoline ring, a benzooxazoline ring, an isothiazoline ring, an isooxazoline ring, an indole ring, a pyrrolidine ring, a piperidone ring, or a dioxane ring.

Examples of the trialkylsilyl group represented by $R^{62}$ include silyl groups substituted with alkyl groups having 1 to 6 carbon atoms (three alkyl groups may be the same or different from each other), such as trimethylsilane, triethylsilane, and ethyldimethylsilane.

Examples of the alkyl group having 1 to 8 carbon atoms represented by R' include alkyl groups having a predetermined number of carbon atoms out of those listed for the above-mentioned alkyl groups represented by $R^{61}$.

Among compounds having a skeleton represented by General Formula (III), compounds in which $R^{61}$ is a hydrogen atom, an alkyl group having 1 to 8 carbon atoms, or an aryl group having 6 to 12 carbon atoms are preferable because these compounds are easy to synthesize, and

also, compounds in which $R^{62}$ is an alkyl group having 1 to 8 carbon atoms whose terminus on the oxygen atom side is linked with -CO-O- are preferable because these compounds efficiently exhibit their functions as latent additives.

In General Formula (III-A) above, $X^5$ represents a direct bond or an m-valent atom, inorganic group, or organic group. Specifically, $X^5$ represents a direct bond, a hydrogen atom, a nitrogen atom, an oxygen atom, a sulfur atom, a phosphorus atom, a group represented by Formula (III-a) or (III-b) below, >C=O, $>NR^{63}$, $-OR^{63}$, $-SR^{63}$, $-NR^{63}R^{64}$, an optionally substituted aliphatic hydrocarbon group having 1 to 120 carbon atoms, an optionally substituted aromatic ring-containing hydrocarbon group having 6 to 35 carbon atoms, or an optionally substituted heterocycle-containing group having 2 to 35 carbon atoms (the aliphatic hydrocarbon group, the aromatic ring-containing hydrocarbon group, and the heterocycle-containing group having a valence that is equal to m). $R^{63}$ and $R^{64}$ represent a hydrogen atom, an optionally substituted aliphatic hydrocarbon group having 1 to 35 carbon atoms, an optionally substituted aromatic ring-containing hydrocarbon group having 6 to 35 carbon atoms, or an optionally substituted heterocycle-containing group having 2 to 35 carbon atoms. The aliphatic hydrocarbon group, the aromatic ring-containing hydrocarbon group, and the heterocycle-containing group are optionally entirely or partially (e.g., methylene group therein) replaced with a group selected from a carbon-carbon double bond, -O-, -S-, -CO-, -O-CO-, -CO-O-, -O-CO-O-, -O-CO-O-, -S-CO-, -CO-S-, -S-CO-O-, -O-CO-S-, -CO-NH-, -NH-CO-, -NH-CO-O-, -NH-CO-O-, -NR'-, -S-S-, $-SO_2-$, and a nitrogen atom.

When $X^5$ is a nitrogen atom, a phosphorus atom, or a group represented by Formula (III-a) or (III-b) below, m is 3; when $X^5$ is an oxygen atom, a sulfur atom, >C=O, -NH-CO-, -CO-NH-, or $>NR^{63}$, m is 2; and when $X^5$ is $-OR^{63}$, $-SR^{63}$, or $-NR^{63}R^{64}$, m is 1, and $X^5$ optionally forms a ring together with $A^1$.

[Chem. 4]

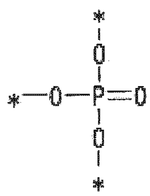

(III-a)

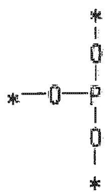

(III-b)

The latent antioxidant represented by General Formula (III-A) above has a structure in which m number of specific groups are linked with a specific m-valent atom or group represented by $X^5$, and m number of the groups may be the same or different from each other. The value of m is 1 to 10, and is preferably 2 to 6 in light of the ease of synthesis.

Examples of the aliphatic hydrocarbon group having 1 to 120 carbon atoms, having a valence that is equal to m, and represented by $X^5$ in General Formula (III-A) above include:

when the valence m is 1, alkyl groups such as methyl, ethyl, propyl, isopropyl, cyclopropyl, butyl, secondary butyl, tertiary butyl, isobutyl, amyl, isoamyl, tertiary amyl, cyclopentyl, hexyl, 2-hexyl, 3-hexyl, cyclohexyl, bicyclohexyl, 1-methylcyclohexyl, heptyl, 2-heptyl, 3-heptyl, isoheptyl, tertiary heptyl, n-octyl, isooctyl, tertiary octyl, 2-ethylhexyl, nonyl, isononyl, and decyl; alkoxy groups such as methyloxy, ethyloxy, propyloxy, isopropyloxy, butyloxy, secondary butyloxy, tertiary butyloxy, isobutyloxy, amyloxy, isoamyloxy, tertiary amyloxy, hexyloxy, cyclohexyloxy, heptyloxy, isoheptyloxy, tertiary heptyloxy, n-octyloxy, isooctyloxy, tertiary octyloxy, 2-ethylhexyloxy, nonyloxy, and decyloxy; alkylthio groups such as methylthio, ethylthio, propylthio, isopropylthio, butylthio, secondary butylthio, tertiary butylthio, isobutylthio, amylthio, isoamylthio, tertiary amylthio, hexylthio, cyclohexylthio, heptylthio, isoheptylthio, tertiary heptylthio, n-octylthio, isooctylthio, tertiary octylthio, and 2-ethylhexylthio; alkenyl groups such as vinyl, 1-methylethenyl, 2-methylethenyl, 2-propenyl, 1-methyl-3-propenyl, 3-butenyl, 1-methyl-3-butenyl, an isobutenyl, 3-pentenyl, 4-hexenyl, cyclohexenyl, bicyclohexenyl, heptenyl, octenyl, decenyl, pentadecenyl, eicosenyl, and tricosenyl; and groups obtained by substituting these groups with substituents that will be described later,

when the valence m is 2, alkylenes such as methylene, ethylene, propylene, butylene, and butyldiyl; groups obtained by replacing the methylene chain in the above-mentioned alkylenes with -O-, -S-, -CO-O-, or -O-CO-; residues of diols such as ethanediol, propanediol, butanediol, pentanediol, and hexanediol; residues of dithiols such as ethanedithiol, propanedithiol, butanedithiol, pentanedithiol, and hexanedithiol; and groups obtained by substituting these groups with substituents that will be described later,

when the valence m is 3, alkylidynes such as propyridyne and 1,1,3-butylidyne, and groups obtained by substituting these groups with substituents that will be described later.

Examples of the optionally substituted monovalent aromatic ring-containing hydrocarbon group having 6 to 35 carbon atoms and having a valence that is equal to m include:

when the valence m is 1, arylalkyl groups such as benzyl, phenethyl, diphenylmethyl, triphenylmethyl, styryl, and cinnamyl; aryl groups such as phenyl and naphthyl; aryloxy groups such as phenoxy and naphthyloxy; arylthio groups such as phenylthio and naphthylthio; and groups obtained by substituting these groups with substituents that will be described later,

when the valence m is 2, arylene groups such as phenylene and naphthylene; residues of bifunctional phenols such as catechol and bisphenol; 2,4,8,10-tetraoxaspiro[5,5]undecane and the like; and groups obtained by substituting these groups with substituents that will be described later, and

when the valence m is 3, phenyl-1,3,5-trimethylene and the like, and groups obtained by substituting these groups with substituents that will be described later.

Examples of the optionally substituted heterocycle-containing group having 2 to 35 carbon atoms and having a valence that is equal to m include:

when the valence m is 1, pyridyl, pyrimidyl, pyridazyl, piperidyl, pyranyl, pyrazolyl, triazile, pyrrolyl, quinolyl, isoquinolyl, imidazolyl, benzimidazolyl, triazolyl, furyl, furanyl, benzofuranyl, thienyl, thiophenyl, benzothiophenyl, thiadiazolyl, thiazolyl, benzothiazolyl, oxazolyl, benzoxazolyl, isothiazolyl, isooxazolyl, indolyl, 2-pyrrolidinon-1-yl, 2-piperidon-1-yl, 2,4-dioxyimidazolidin-3-yl, 2,4-dioxyoxazolidin-3-yl, benzotriazoyl, and the like; and groups obtained by substituting these groups with substituents that will be described later,

when the valence m is 2, groups having a pyridine ring, a pyrimidine ring, a piperidine ring, a piperazine ring, a triazine ring, a furan ring, a thiophene ring, an indole ring, and the like, and groups obtained by substituting these groups with substituents that will be described later, and

when the valence m is 3, groups having an isocyanuric ring, groups having a triazine ring, and groups obtained by substituting these groups with substituents that will be described later.

Examples of the optionally substituted aliphatic hydrocarbon group having 1 to 35 carbon atoms represented by $R^{63}$ and $R^{64}$ include groups having a predetermined number of carbon atoms out of those listed for the above-mentioned aliphatic hydrocarbon group represented by $X^5$ and groups obtained by combining any of these with substituents that will be described later.

Examples of the optionally substituted aromatic ring-containing hydrocarbon group having 6 to 35 carbon atoms represented by $R^{63}$ and $R^{64}$ and the optionally substituted heterocycle-containing group having 2 to 35 carbon atoms represented by $R^{63}$ and $R^{64}$ include those listed for the above-mentioned aromatic ring-containing hydrocarbon group having 6 to 35 carbon atoms and heterocycle-containing group having 2 to 35 carbon atoms represented by $X^5$, respectively, as well as groups obtained by combining these groups with substituents that will be described later.

Examples of the substituent with which the m-valent organic group (e.g., the aliphatic hydrocarbon group, the aromatic ring-containing hydrocarbon group, or the heterocycle-containing group) represented by $X^5$ and the aliphatic hydrocarbon group, the aromatic ring-containing hydrocarbon group, or the heterocycle-containing group represented by $R^{63}$ and $R^{64}$ may be substituted include ethylenically unsaturated groups such as vinyl, allyl, acryl, and methacryl; halogen atoms such as fluorine, chlorine, bromine, and iodine; acyl groups such as acetyl, 2-chloroacetyl, propionyl, octanoyl, acryloyl, methacryloyl, phenylcarbonyl (benzoyl), phthaloyl, 4-trifluoromethylbenzoyl, pivaloyl, salicyloyl, oxaloyl, stearoyl, methoxycarbonyl, ethoxycarbonyl, t-butoxycarbonyl, n-octadecyloxycarbonyl, and carbamoyl; acyloxy groups such as acetyloxy and benzoyloxy; an amino group and substituted amino groups such as, ethylamino, dimethylamino, diethylamino, butylamino, cyclopentylamino, 2-ethylhexylamino, dodecylamino, anilino, chlorophenylamino, toluidino, anisidino, N-methyl-anilino, diphenylamino, naphthylamino, 2-pyridylamino, methoxycarbonylamino, phenoxycarbonylamino, acetylamino, benzoylamino, formylamino, pivaloylamino, lauroylamino, carbamoylamino, N,N-dimethylaminocarbonylamino, N.N-diethylaminocarbonylamino, morpholinocarbonylamino, methoxycarbonylamino, ethoxycarbonylamino, t-butoxycarbonylamino, n-octadecyloxycarbonylamino, N-methyl-methoxycarbonylamino, phenoxycarbonylamino, sulfamoylamino, N,N-dimethylaminosulfonylamino, methylsulfonylamino, butylsulfonylamino, and phenylsulfonylamino; a sulfonamide group, a sulfonyl group, a carboxyl group, a cyano group, a sulfo group, a hydroxyl group, a nitro group, a mercapto group, an imido group, a carbamoyl group, a sulfonamide group, a phosphonate group, a phosphate group, and salts of a carboxyl group, a sulfo group, a phosphonate group, and a phosphate group. These groups are optionally further substituted. The carboxyl group and sulfo group optionally form a salt.

In General Formula (III-A) above, when m is 2, $X^5$ can also be represented by General Formula (1) below.

[Chem. 5]

$$*-Z^1-Y^{10}-Z^2-* \quad (1)$$

wherein, $Y^{10}$ represents a single bond, a sulfur atom, $-CR^{65}R^{66}-$, $-NR^{67}-$, a divalent aliphatic hydrocarbon group having 1 to 35 carbon atoms, a divalent aromatic ring-containing hydrocarbon group having 6 to 35 carbon atoms, or a divalent heterocycle-containing group having 2 to 35 carbon atoms, or a substituent represented by one of formulae (1-1) to (1-3) below,

the aliphatic hydrocarbon group is optionally interrupted by -O-, -S-, -CO-, -COO-, -OCO-, or -NH-, or a linking group in which these groups are combined without oxygen atoms adjacent to each other,

$Z^1$ and $Z^2$ independently represent a direct bond, -O-, -S-, >CO, -CO-O-, -O-CO-, $-SO_2-$, -SS-, -SO-, $>NR^{67}$, $>PR^{67}$, an optionally substituted divalent aliphatic hydrocarbon group having 1 to 20 carbon atoms, or an optionally substituted divalent aromatic hydrocarbon group having 6 to 10 carbon atoms, and

$R^{65}$, $R^{66}$, and $R^{67}$ independently represent a hydrogen atom, an optionally substituted aliphatic hydrocarbon group having 1 to 35 carbon atoms, an optionally substituted aromatic ring-containing hydrocarbon group having 6 to 35 carbon atoms, or an optionally substituted heterocycle-containing group having 2 to 35 carbon atoms.

[Chem. 6]

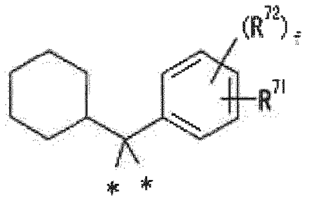

(1-1)

wherein, $R^{71}$ represents a hydrogen atom, an optionally substituted phenyl group, or a cycloalkyl group having 3 to 10 carbon atoms,

$R^{72}$ represents an alkyl group having 1 to 10 carbon atoms, an alkoxy group having 1 to 10 carbon atoms, an alkenyl group having 2 to 10 carbon atoms, or a halogen atom, wherein the alkyl group, the alkoxy group, and the alkenyl group are optionally substituted, and

f is an integer from 0 to 5.

[Chem. 7]

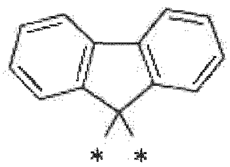

(1-2)

[Chem. 8]

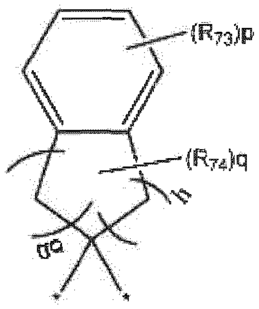

(1-3)

wherein, $R^{73}$ and $R^{74}$ independently represent an optionally substituted alkyl group having 1 to 10 carbon, an optionally substituted aryl group having 6 to 20 carbon atoms, an optionally substituted aryloxy group having 6 to 20 carbon atoms, an optionally substituted arylthio group having 6 to 20 carbon atoms, an optionally substituted arylalkenyl group having 6 to 20 carbon atoms, an optionally substituted arylalkyl group having 7 to 20 carbon atoms, an optionally substituted heterocycle-containing group having 2 to 20 carbon atoms, or a halogen atom,

a methylene group in the alkyl group and the arylalkyl group is optionally interrupted by an unsaturated bond, -O-, or -S-,
$R^{73}$ optionally forms a ring together with adjacent $R^{73}$,
p represents a number from 0 to 4,
q represents a number from 0 to 8, g represents a number from 0 to 4,
h represents a number from 0 to 4, and
a total of g and h is 2 to 4.

In General Formula (III-A) above, when m is 3, $X^5$ can also be represented by General Formula (2) below.

[Chem. 9]

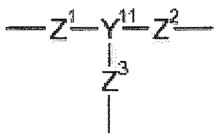

(2)

wherein, $Y^{11}$ represents a single bond, a trivalent aliphatic hydrocarbon group having 1 to 35 carbon atoms, a trivalent alicyclic hydrocarbon group having 3 to 35 carbon atoms, a trivalent aromatic ring-containing hydrocarbon group having 6 to 35 carbon atoms, or a trivalent heterocycle-containing group having 2 to 35 carbon atoms,

$Z^1$, $Z^2$, and $Z^3$ independently represent a direct bond, -O-, -S-, >CO, -CO-O-, -O-CO-, $-SO_2-$, -SS-, -SO-, $>NR^{68}$, $>PR^{68}$, an optionally substituted divalent aliphatic hydrocarbon group having 1 to 20 carbon atoms, or an optionally substituted divalent aromatic hydrocarbon group having 6 to 10 carbon atoms,
$R^{68}$ represents a hydrogen atom, an optionally substituted aliphatic hydrocarbon group having 1 to 35 carbon atoms, an optionally substituted aromatic hydrocarbon group having 6 to 35 carbon atoms, or an optionally substituted heterocycle-containing group having 2 to 35 carbon atoms, and
each of the above-mentioned aliphatic hydrocarbon groups is optionally interrupted by a carbon-carbon double bond, -O-, -CO-, -O-CO-, -CO-O-, or $-SO_2-$.

In General Formula (III-A) above, when m is 4, $X^5$ can also be represented by General Formula (3) below.

[Chem. 10]

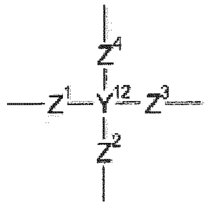

(3)

wherein, $Y^{12}$ represents a a single bond, a carbon atom, or a tetravalent aliphatic hydrocarbon group having 1 to 35 carbon atoms, a tetravalent aromatic ring-containing hydrocarbon group having 6 to 35 carbon atoms, or a tetravalent heterocycle-containing group having 2 to 35 carbon atoms,
the aliphatic hydrocarbon group is optionally interrupted by -COO-, -O-, -OCO-, -NHCO-, -NH-, or -CONH-, and $Z^1$ to $Z^4$ have the same meaning as $Z^1$ to $Z^3$ in General Formula (2) above.

In General Formula (III-A) above, when m is 5, $X^5$ can also be represented by General Formula (4) below.

[Chem. 11]

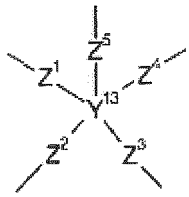

(4)

wherein, $Y^{13}$ represents a single bond, a pentavalent aliphatic hydrocarbon group having 2 to 35 carbon atoms, a pentavalent aromatic ring-containing hydrocarbon group having 6 to 35 carbon atoms, or a pentavalent heterocycle-containing group having 2 to 35 carbon atoms,

the aliphatic hydrocarbon group is optionally interrupted by -COO-, -O-, -OCO-, -NHCO-, -NH-, or -CONH-, and $Z^1$ to $Z^5$ have the same meaning as $Z^1$ to $Z^3$ in General Formula (2) above.

In General Formula (III-A) above, when m is 6, $X^5$ can also be represented by General Formula (5) below.

[Chem. 12]

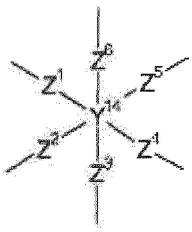

(5)

wherein $Y^{14}$ represents a single bond, a hexavalent aliphatic hydrocarbon group having 2 to 35 carbon atoms, a hexavalent aromatic ring-containing hydrocarbon group having 6 to 35 carbon atoms, or a hexavalent heterocycle-containing group having 2 to 35 carbon atoms,

the aliphatic hydrocarbon group is optionally interrupted by -COO-, -O-, -OCO-, -NHCO-, -NH-, or -CONH-, and $Z^1$ to $Z^6$ have the same meaning as $Z^1$ to $Z^3$ in General Formula (2) above.

Examples of the optionally substituted aliphatic hydrocarbon group having 1 to 35 carbon atoms represented by $R^{65}$, $R^{66}$, and $R^{67}$ in General Formula (1) above include groups having a predetermined number of carbon atoms out of the monovalent aliphatic hydrocarbon groups shown as the examples of the m-valent organic group represented by

$X^5$ in General Formula (III-A) above and the groups obtained by substituting these groups with the groups shown as the examples of the substituent with which the m-valent organic group represented by $X^5$ in General Formula (III-A) above may be substituted. Examples of the divalent aliphatic hydrocarbon group having 1 to 35 carbon atoms represented by $Y^{10}$ in General Formula (1) include divalent groups obtained by substituting these groups or the divalent aliphatic hydrocarbon groups shown as the examples of the m-valent organic group represented by $X^5$ in General Formula (III-A) above with $Z^1$ and $Z^2$.

Examples of the optionally substituted aromatic ring-containing hydrocarbon group having 6 to 35 carbon atoms represented by $R^{65,}$ $R^{66}$, and $R^{67}$ include the monovalent aromatic ring-containing hydrocarbon groups shown as the examples of the m-valent organic group represented by $X^5$ in General Formula (III-A) above and the groups obtained by substituting these groups with the groups shown as the examples of the substituent with which the m-valent organic group represented by $X^5$ in General Formula (III-A) above may be substituted. Examples of the divalent aromatic ring-containing hydrocarbon group having 6 to 35 carbon atoms represented by $Y^{10}$ in General Formula (1) include divalent groups obtained by substituting these groups or the divalent aromatic ring-containing hydrocarbon groups shown as the examples of the m-valent organic group represented by $X^5$ in General Formula (III-A) above with $Z^1$ and $Z^2$.

Examples of the optionally substituted heterocycle-containing group having 2 to 35 carbon atoms represented by $R^{65,}$ $R^{66}$, and $R^{67}$ include the monovalent heterocycle-containing groups shown as the examples of the m-valent organic group represented by $X^5$ in General Formula (III-A) above and the groups obtained by substituting these groups with the groups shown as the examples of the substituent with which the m-valent organic group represented by $X^5$ in General Formula (III-A) above may be substituted. Examples of the divalent heterocycle-containing group having 2 to 35 carbon atoms represented by $Y^{10}$ in General Formula (1) include divalent groups obtained by substituting these groups or the divalent heterocycle-containing groups shown as the examples of the m-valent organic group represented by $X^5$ in General Formula (III-A) above with $Z^1$ and $Z^2$.

Examples of the optionally substituted divalent aliphatic hydrocarbon group having 1 to 20 carbon atoms or the optionally substituted divalent aromatic hydrocarbon group having 6 to 10 carbon atoms represented by $Z^1$ and $Z^2$ include groups having a predetermined number of carbon atoms out of those described above as the optionally substituted divalent aliphatic hydrocarbon group or aromatic ring-containing hydrocarbon group represented by $Y^{10}$.

With regard to the substituent represented by the formula (1-1) above, examples of the cycloalkyl group having 3 to 10 carbon atoms represented by $R^{71}$ include a cyclopropyl, a cyclobutyl, a cyclopentyl, a cycloheptyl, and a cyclooctyl.

Examples of the alkyl group having 1 to 10 carbon atoms represented by $R^{72}$ include groups having a predetermined number of carbon atoms out of the groups shown as the examples of the alkyl group having 1 to 40 carbon atoms represented by $R^{61}$.

Examples of the alkoxy group having 1 to 10 carbon atoms represented by $R^{72}$ include methyloxy, ethyloxy, propyloxy, isopropyloxy, butyloxy, secondary butyloxy, tertiary butyloxy, isobutyloxy, amyloxy, isoamyloxy, tertiary amyloxy, hexyloxy, cyclohexyloxy, heptyloxy, isoheptyloxy, tertiary heptyloxy, n-octyloxy, isooctyloxy, tertiary octyloxy, 2-ethylhexyloxy, nonyloxy, and decyloxy.

Substituents with which the phenyl group, the alkyl group, the alkoxy group, and the alkenyl group may be substituted are the same as those shown as the examples of the substituent with which groups representing the m-valent organic group represented by $X^5$ in General Formula (III-A) above may be substituted.

With regard to the groups represented by the formula (1-3) above, examples of the optionally substituted alkyl group having 1 to 10 carbon atoms represented by $R^{73}$ and $R^{74}$ include groups having a predetermined number of carbon atoms out of the groups shown as the examples of the alkyl group having 1 to 40 carbon atoms represented by $R^{61}$.

Examples of the optionally substituted aryl group having 6 to 20 carbon atoms represented by $R^{73}$ and $R^{74}$ include the groups shown as the examples of the aryl group having 6 to 20 carbon atoms represented by $R^{61}$.

Examples of the optionally substituted aryloxy group having 6 to 20 carbon atoms represented by $R^{73}$ and $R^{74}$ include groups such as phenyloxy, naphthyloxy, 2-methylphenyloxy, 3-methylphenyloxy, 4-methylphenyloxy, 4-vinylphenyldioxy, 3-iso-propylphenyloxy, 4-iso-propylphenyloxy, 4-butylphenyloxy, 4-tert-butylphenyloxy, 4-hexylphenyloxy, 4-cyclohexylphenyloxy. 4-octylphenyloxy, 4-(2-ethylhexyl)phenyloxy, 2,3-dimethylphenyloxy, 2,4-dimethylphenyloxy, 2,5-dimethylphenyloxy, 2,6-dimethylphenyloxy, 3,4-dimethylphenyloxy, 3,5-dimethylphenyloxy, 2,4-di-tert-butylphenyloxy, 2,5-di-tert-butylphenyloxy, 2,6-di-tert-butylphenyloxy, 2,4-di-tert-pentylphenyloxy, 2,5-tert-amylphenyloxy, 4-cyclohexylphenyloxy, 2,4,5-trimethylphenyloxy, and ferrocenyloxy.

Examples of the optionally substituted arylthio group having 6 to 20 carbon atoms represented by $R^{73}$ and $R^{74}$ include groups obtained by replacing the oxygen atom of the above-mentioned optionally substituted aryloxy groups having 6 to 20 carbon atoms with a sulfur atom.

Examples of the optionally substituted arylalkenyl group having 8 to 20 carbon atoms represented by $R^{73}$ and $R^{74}$ include groups obtained by replacing the oxygen atom of the above-mentioned optionally substituted aryloxy group having 6 to 20 carbon atoms with an alkenyl group such as vinyl, allyl, 1-propenyl, isopropenyl, 2-butenyl, 1,3-butadienyl, 2-pentenyl, or 2-octenyl.

Examples of the arylalkyl group having 7 to 20 carbon atoms represented by $R^{73}$ and $R^{74}$ include the groups

shown as the examples of the arylalkyl group having 7 to 20 carbon atoms represented by $R^{61}$.

Examples of the optionally substituted heterocycle-containing group having 2 to 20 carbon atoms represented by $R^{73}$ and $R^{74}$ include the groups shown as the examples of the heterocycle-containing group having 2 to 20 carbon atoms represented by $R^{61}$.

Examples of the trivalent aliphatic hydrocarbon group having 1 to 35 carbon atoms represented by $Y^{11}$ in General Formula (2) above include trivalent groups obtained by substituting, with $Z^1$, $Z^2$, and $Z^3$, groups having a predetermined number of carbon atoms, out of the monovalent to trivalent aliphatic hydrocarbon groups shown as the examples of the m-valent organic group represented by $X^5$ in General Formula (III-A) above and the groups obtained by substituting these groups with those shown as the examples of the substituent with which the groups representing the m-valent organic group represented by $X^5$ in General Formula (III-A) above may be substituted.

Examples of the trivalent alicyclic hydrocarbon group having 3 to 35 carbon atoms represented by $Y^{11}$ in General Formula (2) above include trivalent groups obtained by substituting, with $Z^1$, $Z^2$, and $Z^3$, groups such as cyclopentyl, cyclohexyl, cycloheptyl, cyclooctyl, cyclodecanyl, 1-adamantyl, 2-adamantyl, noradamantyl, 2-methyladamantyl, norbornyl, isonorbornyl, perhydronaphthyl, perhydroanthracenyl, bicyclo[1.1.0]butyl, bicyclo[1.1.1]pentyl, bicyclo[2.1.0]pentyl, bicyclo[3.1.0]hexyl, bicyclo[2.1.1]hexyl, bicyclo[2.2.0]hexyl, bicyclo[4.1.0]heptyl, bicyclo[3.2.0]heptyl, bicyclo[3.1.1]heptyl, bicyclo[2.2.1]heptyl, bicyclo[5.1.0]octyl, bicyclo[4.2.0]octyl, bicyclo[4.1.1]octyl, bicyclo[3.3.0]octyl, bicyclo[3.2.1]octyl, bicyclo[2.2.2]octyl, spiro[4,4]nonanyl, spiro[4,5]decanyl, decalin, tricyclodecanyl, tetracyclododecanyl, cedrol, and cyclododecanyl.

Examples of the trivalent aromatic ring-containing hydrocarbon group having 6 to 35 carbon atoms represented by $Y^{11}$ include trivalent groups obtained by substituting, with $Z^1$, $Z^2$, and $Z^3$, the monovalent to trivalent aromatic ring-containing hydrocarbon groups shown as the examples of the m-valent organic group represented by $X^5$ in General Formula (III-A) above, the groups obtained by substituting these groups with those shown as the examples of the substituent with which the groups representing the m-valent organic group represented by $X^5$ in General Formula (III-A) above may be substituted, and the like.

Examples of the trivalent heterocycle-containing group having 2 to 35 carbon atoms represented by $Y^{11}$ include trivalent groups obtained by substituting, with $Z^1$, $Z^2$, and $Z^3$, the monovalent to trivalent heterocycle-containing groups shown as the examples of the m-valent organic group represented by $X^5$ in General Formula (III-A) above, the groups obtained by substituting these groups with those shown as the examples of the substituent with which the groups representing the m-valent organic group represented by $X^5$ in General Formula (III-A) above may be substituted, and the like.

Moreover, examples of the optionally substituted aliphatic hydrocarbon group having 1 to 35 carbon atoms, the optionally substituted aromatic hydrocarbon group having 6 to 35 carbon atoms, and the optionally substituted heterocycle-containing group having 2 to 35 carbon atoms represented by $R^{68}$ in General Formula (2) include the aliphatic hydrocarbon groups, the aromatic ring-containing hydrocarbon group, and the heterocycle-containing groups, respectively, shown as the examples for $R^{65}$ and $R^{66}$ in General Formula (1) above.

Moreover, examples of the optionally substituted divalent aliphatic hydrocarbon group having 1 to 20 carbon atoms and the optionally substituted divalent aromatic hydrocarbon group having 6 to 10 carbon atoms represented by $Z^1$ to $Z^3$ in General Formula (2) include those shown as the examples of the optionally substituted divalent aliphatic hydrocarbon group and the optionally substituted aromatic ring-containing hydrocarbon group, respectively, represented by $Z^1$ and $Z^2$ in General Formula (1).

Examples of the tetravalent aliphatic hydrocarbon group having 1 to 35 carbon atoms represented by $Y^{12}$ in General Formula (3) above include tetravalent groups obtained by substituting, with $Z^1$, $Z^2$, $Z^3$, and $Z^4$, groups having a predetermined number of carbon atoms, out of the monovalent to trivalent aliphatic hydrocarbon groups shown as the examples of the m-valent organic group represented by $X^5$ in General Formula (III-A) above and the groups obtained by substituting these groups with those shown as the examples of the substituent with which the groups representing the m-valent organic group represented by $X^5$ in General Formula (III-A) above may be substituted.

Examples of the aromatic ring-containing hydrocarbon group having 6 to 35 carbon atoms represented by $Y^{12}$ include tetravalent groups obtained by substituting, with $Z^1$, $Z^2$, $Z^3$, and $Z^4$, the monovalent to trivalent aromatic ring-containing hydrocarbon groups shown as the examples of the m-valent organic group represented by $X^5$ in General Formula (III-A) above, the groups obtained by substituting these groups with those shown as the examples of the substituent with which the groups representing the m-valent organic group represented by $X^5$ in General Formula (III-A) above may be substituted, and the like.

Examples of the tetravalent heterocycle-containing group having 2 to 35 carbon atoms represented by $Y^{12}$ include tetravalent groups obtained by substituting, with $Z^1$, $Z^2$, $Z^3$, and $Z^4$, the monovalent to trivalent heterocycle-containing groups shown as the examples of the m-valent organic group represented by $X^5$ in General Formula (III-A) above, the groups obtained by substituting these groups with those shown as the examples of the substituent with which the groups representing the m-valent organic group represented by $X^5$ in General Formula (III-A) above may be substituted, and the like.

Examples of the pentavalent aliphatic hydrocarbon group having 2 to 35 carbon atoms represented by $Y^{13}$ in General Formula (4) above include pentavalent groups obtained by substituting, with $Z^1$, $Z^2$, $Z^3$, $Z^4$, and $Z^5$, groups having a predetermined number of carbon atoms, out of the monovalent to trivalent aliphatic hydrocarbon groups shown as the examples of the m-valent organic group represented by $X^5$ in General Formula (III-A) above and the groups obtained by substituting these groups with those shown as the examples of the substituent with which the groups representing the m-valent organic group represented by $X^5$ in General Formula (III-A) above may be substituted.

Examples of the pentavalent aromatic ring-containing hydrocarbon group having 6 to 35 carbon atoms represented by $Y^{13}$ include pentavalent groups obtained by substituting, with $Z^1$, $Z^2$, $Z^3$, $Z^4$, and $Z^5$, the monovalent to trivalent aromatic ring-containing hydrocarbon groups shown as the examples of the m-valent organic group represented by $X^5$ in General Formula (III-A) above, the groups obtained by substituting these groups with those shown as the examples of the substituent with which the m-valent organic group represented by $X^5$ in General Formula (III-A) above may be substituted, and the like.

Examples of the pentavalent heterocycle-containing group having 2 to 35 carbon atoms represented by $Y^{13}$ include pentavalent groups obtained by substituting, with $Z^1$, $Z^2$, $Z^3$, $Z^4$, and $Z^5$, the monovalent to trivalent heterocycle-containing groups shown as the examples of the m-valent organic group represented by $X^5$ in General Formula (III-A) above, the groups obtained by substituting these groups with those shown as the examples of the substituent with which groups representing the m-valent organic group represented by $X^5$ in General Formula (III-A) above may be substituted, and the like.

Examples of the hexavalent aliphatic hydrocarbon group having 2 to 35 carbon atoms represented by $Y^{14}$ in General Formula (5) above include hexavalent groups obtained by substituting, with $Z^1$, $Z^2$, $Z^3$, $Z^4$, $Z^5$, and $Z^6$, groups having a predetermined number of carbon atoms out of the monovalent to trivalent aliphatic hydrocarbon groups shown as the examples of the m-valent organic group represented by $X^5$ in General Formula (III-A) above and the groups obtained by substituting these groups with those shown as the examples of the substituent with which the groups representing the m-valent organic group represented by $X^5$ in General Formula (III-A) above may be substituted.

Examples of the hexavalent aromatic ring-containing hydrocarbon group having 6 to 35 carbon atoms represented by $Y^{14}$ include hexavalent groups obtained by substituting, with $Z^1$, $Z^2$, $Z^3$, $Z^4$, $Z^5$, and $Z^6$, the monovalent to trivalent aromatic ring-containing hydrocarbon groups shown as the examples of the m-valent organic group represented by $X^5$ in General Formula (III-A) above, the groups obtained by substituting these groups with those shown as the examples of the substituent with which the groups representing the m-valent organic group represented by $X^5$ in General Formula (III-A) above may be substituted, and the like.

Examples of the hexavalent heterocycle-containing group having 2 to 35 carbon atoms represented by $Y^{14}$ include hexavalent groups obtained by substituting, with $Z^1$, $Z^2$, $Z^3$, $Z^4$, $Z^5$, and $Z^6$, the monovalent to trivalent heterocycle-containing groups shown as the examples of the m-valent organic group represented by $X^5$ in General Formula (III-A) above, the groups obtained by substituting these groups with those shown as the examples of the substituent with which the groups representing the m-valent organic group represented by $X^5$ in General Formula (III-A) above may be substituted, and the like.

In General Formula (III-A) above, the total of d and k is not more than the possible maximum number of substituents with which ring $A^1$ is optionally substituted. It is preferable that the total of d and k be less than the possible maximum number of substituents with which ring $A^1$ is optionally substituted. For example, when ring $A^1$ is a six-membered aromatic ring, the possible maximum number of substituents with which ring $A^1$ is optionally substituted is 6, and therefore d and k satisfy $d+k \leq 6$. When ring $A^1$ is a five-membered heterocycle, the possible maximum number of substituent with which ring $A^1$ is optionally substituted is 4, and therefore d and k satisfy $d+k \leq 4$.

Among the compounds represented by General Formula (III-A) above, compounds represented by any of General Formulae (IV) to (VI) below are preferable because these compounds are easy to synthesize and have high thermal resistance.

[Chem. 13]

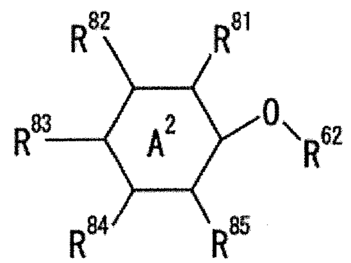

(IV)

wherein, ring $A^2$ is a six-membered alicyclic ring, aromatic ring, or heterocycle; $R^{81}$, $R^{82}$, $R^{83}$, $R^{84}$, and $R^{85}$ represent a hydrogen atom, a halogen atom, a cyano group, a hydroxyl group, a nitro group, a carboxyl group, an optionally substituted alkyl group having 1 to 40 carbon atoms, an aryl group having 6 to 20 carbon atoms, an arylalkyl group having 7 to 20 carbon atoms, an heterocycle-containing group having 2 to 20 carbon atoms, or -O-$R^{62}$; at least one of $R^{81}$, $R^{82}$, $R^{83}$, $R^{84}$, and $R^{85}$ is not a hydrogen atom; and $R^{62}$ is the same as that in General Formula (III) above.

[Chem. 14]

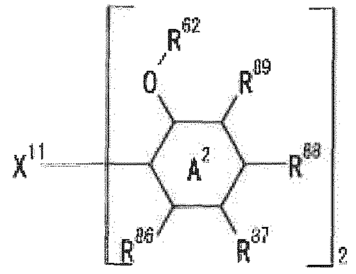

(V)

wherein, $X^{11}$ is a group represented by General Formula (1) above; $R^{86}$, $R^{87}$, $R^{88}$, and $R^{89}$ represent a hydrogen atom, a halogen atom, a cyano group, a hydroxyl group, a nitro group, a carboxyl group, an optionally substituted alkyl group having 1 to 40 carbon atoms, an aryl group having 6 to 20 carbon atoms, an arylalkyl group having 7 to 20 carbon atoms, or a heterocycle-containing group having 2 to 20 carbon atoms; at least one of $R^{86}$, $R^{87}$, $R^{88}$, and $R^{89}$ is not a hydrogen atom; $R^{62}$ is the same as that in General Formula (III) above; and ring $A^2$ is the same as that in General Formula (IV) above.

[Chem. 15[

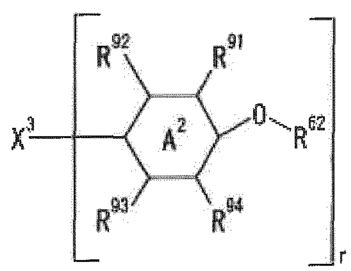

(VI)

wherein, r = 2 to 6; $X^3$ is a group represented by General Formula (1) above when r = 2, a group represented by General Formula (2) above when r = 3, a group represented by General Formula (3) above when r = 4, a group represented by General Formula (4) above when r = 5, and a group represented by General Formula (5) above when r = 6; $R^{91}$, $R^{92}$, $R^{93}$, and $R^{94}$ represent a hydrogen atom, a halogen atom, a cyano group, a hydroxyl group, a nitro group, a carboxyl group, an optionally substituted alkyl group having 1 to 40 carbon atoms, an aryl group having 6 to 20 carbon atoms, an arylalkyl group having 7 to 20 carbon atoms, or a heterocycle-containing group having 2 to 20 carbon atoms; at least one of $R^{91}$, $R^{92}$, $R^{93}$, and $R^{94}$ is not a hydrogen atom; $R^{62}$ is the same as that in General Formula (III) above; and ring $A^2$ is the same as that in General Formula (IV) above.

Examples of the six-membered alicyclic ring, aromatic ring, or heterocycle represented by ring $A^2$ in General Formula (IV) above include those shown as the examples for ring $A^1$ in General Formula (III) above.

Examples of the halogen atom, the optionally substituted alkyl group having 1 to 40 carbon atoms, the aryl group having 6 to 20 carbon atoms, the arylalkyl group having 7 to 20 carbon atoms, and the heterocycle-containing group having 2 to 20 carbon atoms represented by $R^{81}$, $R^{82}$, $R^{83}$, $R^{84}$, and $R^{85}$ include those shown as the examples for $R^{61}$ or $R^{62}$ in General Formula (III) above.

Examples of the halogen atom, the optionally substituted alkyl group having 1 to 40 carbon atoms, the aryl group having 6 to 20 carbon atoms, the arylalkyl group having 7 to 20 carbon atoms, and the heterocycle-containing group having 2 to 20 carbon atoms represented by $R^{86}$, $R^{87}$, $R^{88}$, and $R^{89}$ in General Formula (V) above include those shown as the examples for $R^{61}$ or $R^{62}$ in General Formula (III) above.

Examples of the halogen atom, the optionally substituted alkyl group having 1 to 40 carbon atoms, the aryl group having 6 to 20 carbon atoms, the arylalkyl group having 7 to 20 carbon atoms, and the heterocycle-containing

group having 2 to 20 carbon atoms represented by $R^{91}$, $R^{92}$, $R^{93}$, and $R^{94}$ in General Formula (VI) above include those shown as the examples for $R^{61}$ or $R^{62}$ in General Formula (III) above.

In the compounds represented by General Formula (IV) above, ring $A^2$ is preferably benzene or naphthalene,

the group that is represented by $R^{81}$, $R^{82}$, $R^{83}$, $R^{84}$, and $R^{85}$ and is other than a hydrogen atom is preferably an alkyl group having 1 to 20 carbon atoms, an aryl group having 6 to 10 carbon atoms, an arylalkyl group having 7 to 12 carbon atoms, or a heterocycle-containing group having 2 to 10 carbon atoms, and particularly preferably, any one of $R^{81}$ to $R^{85}$ is an alkyl group having 1 to 4 carbon atoms or a heterocycle-containing group having 2 to 10 carbon atoms, and

$R^{62}$ is preferably substituted with the following substituent linked via -CO-O-. -Alkyl group having 1 to 8 carbon atoms (in particular, methyl, ethyl, propyl, iso-propyl, butyl, sec-butyl, tert-butyl, iso-butyl, amyl, 1-methylbutyl, 2-methylbutyl, 3-methylbutyl, 1-ethylpropyl, 1,1-dimethylpropyl, 1,2-dimethylpropyl, or 2,2-dimethylpropyl)

-Arylalkyl group having 7 to 10 carbon atoms (in particular, benzyl group)

-Alkenyl group having 2 to 6 carbon atoms (in particular, propen-1-yl group)

In the compounds represented by General Formula (V) above,

ring $A^2$ is preferably benzene or naphthalene,

the group that is represented by $R^{86}$, $R^{87}$, $R^{88}$, and $R^{89}$ and is other than a hydrogen atom is preferably an alkyl group having 1 to 20 carbon atoms, an aryl group having 6 to 10 carbon atoms, an arylalkyl group having 7 to 12 carbon atoms, or a heterocycle-containing group having 2 to 10 carbon atoms, and particularly preferably an alkyl group having 1 to 8 carbon atoms or a heterocycle-containing group having 2 to 10 carbon atoms, and

$R^{62}$ is preferably substituted with the following substituent linked via -CO-O-. -Alkyl group having 1 to 8 carbon atoms (in particular, methyl, ethyl, propyl, iso-propyl, butyl, sec-butyl, tert-butyl, iso-butyl, amyl, 1-methylbutyl, 2-methylbutyl, 3-methylbutyl, 1-ethylpropyl, 1,1-dimethylpropyl, 1,2-dimethylpropyl, or 2,2-dimethylpropyl)

-Arylalkyl group having 7 to 10 carbon atoms (in particular, benzyl group)

-Alkenyl group having 2 to 6 carbon atoms (in particular, propen-1-yl group)

In General Formula (1) above, which represents $X^{11}$, $Y^{10}$ is preferably a sulfur atom, an aromatic ring-containing hydrocarbon group having 6 to 25 carbon atoms, or a heterocycle-containing group having 2 to 21 carbon atoms, and $Z^1$ and $Z^2$ are preferably a direct bond, -CO-O-, -O-CO-, or an aliphatic hydrocarbon group having 1 to 20 carbon atoms or aromatic hydrocarbon group having 6 to 10 carbon atoms that is optionally substituted and optionally interrupted by -COO-, -O-, -OCO-, -NHCO-, -NH-, or -CONH- (hereinafter abbreviated to "-COO- or the like"), and particularly preferably an aliphatic hydrocarbon group having 1 to 8 carbon atoms that is optionally substituted and optionally interrupted by -COO- or the like.

In the compounds represented by General Formula (VI) above, the group that is represented by $R^{91}$, $R^{92}$, $R^{93}$, and $R^{94}$ and is other than a hydrogen atom is preferably an alkyl group having 1 to 20 carbon atoms, an aryl group having 6 to 10 carbon atoms, an arylalkyl group having 7 to 12 carbon atoms, or a heterocycle-containing group having 2 to 10 carbon atoms, and particularly preferably, any one of $R^{91}$ to $R^{94}$ is an alkyl group having 1 to 4 carbon atoms or a heterocycle-containing group having 2 to 10 carbon atoms.

$R^{62}$ is preferably substituted with the following substituent linked via -CO-O-.

-Alkyl group having 1 to 8 carbon atoms (in particular, methyl, ethyl, propyl, iso-propyl, butyl, sec-butyl, tert-butyl, iso-butyl, amyl, 1-methylbutyl, 2-methylbutyl, 3-methylbutyl, 1-ethylpropyl, 1,1-dimethylpropyl, 1,2-dimethylpropyl, or 2,2-dimethy lpropyl)

-Arylalkyl group having 1 to 10 carbon atoms (in particular, benzyl group)

-Alkenyl group having 2 to 6 carbon atoms (in particular, propen-1-yl group)

When $X^3$ is a group represented by General Formula (1) above, $Y^{10}$ in General Formula (1) is preferably a sulfur atom, a divalent alkyl group having 1 to 20 carbon atoms, a divalent aromatic ring-containing hydrocarbon group having 6 to 25 carbon atoms, a divalent heterocycle-containing group having 2 to 21 carbon atoms, or 2,4,8,10-tetraoxaspiro[5,5]undecane, and particularly preferably a divalent alkyl group having 1 to 15 carbon atoms, a divalent aromatic ring-containing hydrocarbon group having 6 to 15 carbon atoms, or 2,4,8,10-tetraoxaspiro[5,5]undecane, and

$Z^1$ an $Z^2$ are preferably a direct bond, -CO-O-, -O-CO-, or an aliphatic hydrocarbon group having 1 to 20 carbon atoms or aromatic hydrocarbon group having 6 to 10 carbon atoms that is optionally substituted and optionally interrupted by -COO- or the like, and particularly preferably an aliphatic hydrocarbon group having 1 to 8 carbon atoms that is optionally substituted and optionally interrupted by -COO- or the like.

When $X^3$ is a group represented by General Formula (2) above, $Y^{11}$ is preferably a trivalent alkyl group having

1 to 20 carbon atoms, a trivalent aryl group having 6 to 10 carbon atoms, a trivalent arylalkyl group having 7 to 12 carbon atoms, or a trivalent heterocycle-containing group having 1 to 10 carbon atoms, and particularly preferably a trivalent alkyl group having 1 to 8 carbon atoms, a trivalent aryl group having 6 to 9 carbon atoms, or a trivalent heterocycle-containing group having 2 to 6 carbon atoms, and

$Z^1$, $Z^2$, and $Z^3$ are preferably the same as those preferable for $Z^1$ and $Z^2$ in General Formula (1).

When $X^3$ is represented by General Formula (3) above, $Y^{12}$ is preferably the same as those preferable for $Y^{11}$, provided that $Y^{12}$ is tetravalent, and
$Z^1$ to $Z^4$ are preferably the same as those preferable for $Z^1$ and $Z^2$ in General Formula (1).
When $X^3$ is represented by General Formula (4) above, $Y^{13}$ is preferably the same as those preferable for $Y^{11}$, provided that $Y^{13}$ is is pentavalent, and
$Z^1$ to $Z^5$ are preferably the same as those preferable for $Z^1$ and $Z^2$ in General Formula (1).
When $X^3$ is represented by General Formula (5) above, $Y^{14}$ is preferably the same as those preferable for $Y^{11}$, provided that $Y^{14}$ is hexavalent, and
$Z^1$ to $Z^6$ are preferably the same as those preferable for $Z^1$ and $Z^2$ in General Formula (1).

In the composition of the present invention, the content of the above-mentioned latent additive (A) is preferably 0.001 to 20 mass% and more preferably 0.005 to 5 mass%.

Polymerization Initiator (B)

The polymerization initiator (B) used in the composition of the present invention includes one or more oxime ester compounds represented by General Formula (I) above.

Although the oxime ester compounds represented by General Formula (I) above embrace geometric isomers at the double bond of oxime, the geometric isomers are herein not distinguished from each other.

That is to say, General Formula (I) herein is intended to represent a mixture of the isomers or either one of the isomers, and is not to be construed as being limited to the structure of the isomer shown, and the same holds true for specific compounds shown as examples thereof.

Examples of the alkyl group having 1 to 20 carbon atoms represented by $R^3$, $R^{11}$, $R^{12}$, $R^{13}$, $R^{14}$, $R^{15}$, $R^{16}$, $R^{21}$, $R^{22}$, $R^{23}$, and $R^{24}$ in General Formula (I) above include methyl, ethyl, propyl, isopropyl, butyl, isobutyl, s-butyl, t-butyl, amyl, isoamyl, t-amyl, hexyl, heptyl, octyl, isooctyl, 2-ethylhexyl, t-octyl, nonyl, isononyl, decyl, isodecyl, undecyl, dodecyl, tetradecyl, hexadecyl, octadecyl, icosyl, cyclopentyl, cyclopentylmethyl, cyclopentylethyl, cyclohexyl, cyclohexylmethyl, and cyclohexylethyl.

Examples of the aryl group having 6 to 30 carbon atoms represented by $R^3$, $R^{11}$, $R^{12}$, $R^{13}$, $R^{21}$, $R^{22}$, $R^{23}$, and $R^{24}$ in General Formula (I) above include phenyl, tolyl, xylyl, ethylphenyl, naphthyl, anthryl, and phenanthrenyl; and phenyl, biphenylyl, naphthyl, anthryl, and the like that are substituted with one or more of the above-mentioned alkyl groups.

Examples of the arylalkyl group having 7 to 30 carbon atoms represented by $R^3$, $R^{11}$, $R^{12}$, $R^{13}$, $R^{21}$, $R^{22}$, $R^{23}$, and $R^{24}$ in General Formula (I) above include benzyl, $\alpha$-methylbenzyl, $\alpha,\alpha$-dimethylbenzyl, and phenylethyl.

Examples of the heterocycle-containing group having 2 to 20 carbon atoms represented by $R^3$, $R^{11}$, $R^{12}$, $R^{13}$, $R^{21}$, $R^{22}$, $R^{23}$, and $R^{24}$ in General Formula (I) above include five- to seven-membered heterocycle groups such as pyridyl, pyrimidyl, furyl, thienyl, tetrahydrofuryl, dioxolanyl, benzoxazol-2-yl, tetrahydropyranyl, pyrrolidyl, imidazolidyl, pyrazolidyl, thiazolidyl, isothiazolidyl, oxazolidyl, isooxazolidyl, piperidyl, piperazyl, and morpholinyl; and groups formed by linking a divalent linking group with these five- to seven-membered heterocycle groups.

Preferable examples of the ring that may be formed by any pair of $R^4$ and $R^5$, $R^5$ and $R^6$, and $R^6$ and $R^7$, as well as $R^3$ and $R^7$, and $R^3$ and $R^8$ together in General Formula (I) above include five- to seven-membered rings such as a cyclopentane ring, a cyclohexane ring, a cyclopentene ring, a benzene ring, a piperidine ring, a morpholine ring, a lactone ring, and a lactam ring.

Also, examples of the halogen atom represented by $R^4$, $R^5$, $R^6$, $R^7$, and $R^8$ in General Formula (I) above and the halogen atom with which $R^3$, $R^{11}$, $R^{12}$, $R^{13}$, $R^{21}$, $R^{22}$, and $R^{23}$ in General Formula (I) above are optionally replaced include fluorine, chlorine, bromine, and iodine.

Among the oxime ester compounds represented by General Formula (I), compounds in which $R^3$ is an alkyl group having 1 to 12 carbon atoms or a heterocycle-containing group having 2 to 12 carbon atoms are preferable because these compounds are easy to manufacture. Also, compounds in which $R^3$ is an aromatic ring that is optionally condensed or compounds represented by General Formula (VII) below are preferable because these compounds have high sensitivity and are easy to manufacture.

[Chem. 16]

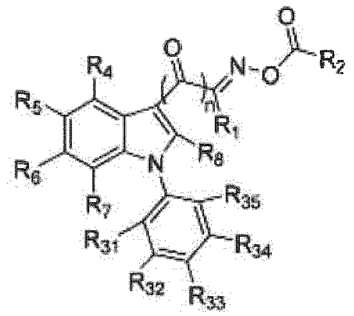

(VII)

wherein, $R^1$, $R^2$, $R^4$, $R^5$, $R^6$, $R^7$, $R^8$, and n are the same as defined for General Formula (I) above,
$R^{31}$, $R^{32}$, $R^{33}$, $R^{34}$, and $R^{35}$ independently represent $R^{11}$, $OR^{11}$, $SR^{11}$, $COR^{11}$, $CONR^{15}R^{16}$, $NR^{12}COR^{11}$, $OCOR^{11}$, $COOR^{14}$, $SCOR^{11}$, $OCSR^{11}$, $COSR^{14}$, $CSOR^{11}$, a hydroxyl group, a nitro group, CN, or a halogen atom, and pairs of $R^{31}$ and $R^{32}$, $R^{32}$ and $R^{33}$, $R^{33}$ and $R^{34}$, and $R^{34}$ and $R^{35}$ each optionally form a ring together.

Examples of the ring that may be formed by any pair of $R^{31}$ and $R^{32}$, $R^{32}$ and $R^{33}$, $R^{33}$ and $R^{34}$, and $R^{34}$ and $R^{35}$ together include the same rings as those mentioned above as the examples of the ring that may be formed by any pair of $R^4$ and $R^5$, $R^5$ and $R^6$, and $R^6$ and $R^7$, as well as $R^3$ and $R^7$, and $R^3$ and $R^8$ together.

With regard to General Formulae (I) and (VII) above, compounds in which $R^1$ is an alkyl group having 1 to 12 carbon atoms or an arylalkyl group having 7 to 15 carbon atoms; or compounds in which $R^1$ is $R^{11}$ or $OR^{11}$ wherein $R^{11}$ is an aryl group having 6 to 12 carbon atoms or an alkyl group having 1 to 8 carbon atoms are preferable, because these compounds have high solubility in solvent. Compounds in which $R^2$ is a methyl group, an ethyl group, or a phenyl group are preferable because these compounds have high reactivity. Compounds in which $R^4$ to $R^7$ are independently a hydrogen atom, a cyano group, or $OR^{11}$ wherein $R^{11}$ is an alkyl group having 1 to 8 carbon atoms and having a hydroxyl group (in particular, a hydrogen atom or a cyano group, and in more particular, a hydrogen atom) are preferable because these compounds are easy to synthesize. Compounds in which $R^8$ is a hydrogen atom are preferable because these compounds are easy to synthesize. Compounds in which n is 1 are preferable because these compounds have high sensitivity.

With regard to General Formula (VII) above, compounds in which at least one of $R^{31}$ to $R^{35}$ is a nitro group, CN, a halogen atom, or $COR^{11}$ wherein $R^{11}$ is an aryl group having 6 to 12 carbon atoms or an alkyl group having 1 to 8 carbon atoms are preferable because these compounds have high sensitivity. Compounds in which at least one of $R^{31}$ to $R^{35}$ is a nitro group, CN, or a halogen atom are more preferable, and compounds in which $R^{33}$ is a nitro group, CN, or a halogen atom are particularly preferable.

Accordingly, preferred specific examples of the oxime ester compound in the present invention represented by General Formula (I) above include compounds No. 1 to No. 214 below. However, the present invention is not limited by the compounds below.

[Chem. 17]

Compound No. 1

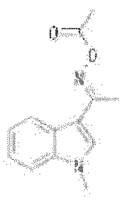

Compound No. 2

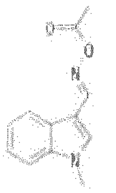

Compound No. 3

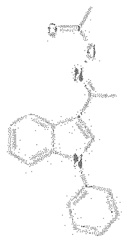

Compound No. 4

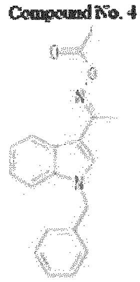

Compound No. 5

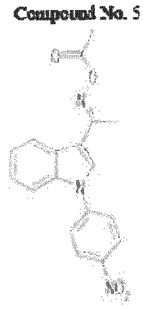

Compound No. 6

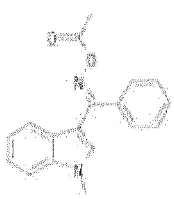

Compound No. 7

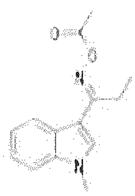

Compound No. 8

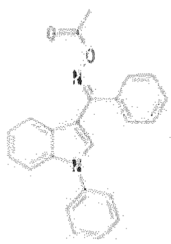

Compound No. 9

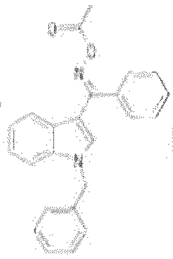

Compound No. 10

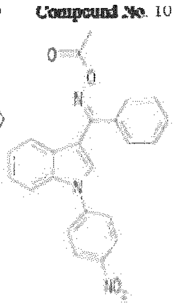

Compound No. 11

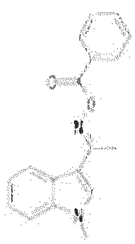

Compound No. 12

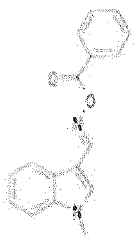

Compound No. 13

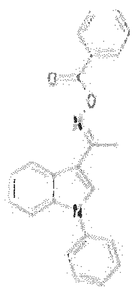

Compound No. 14

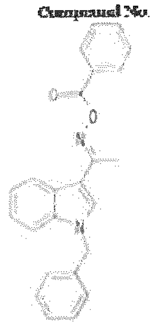

Compound No. 15

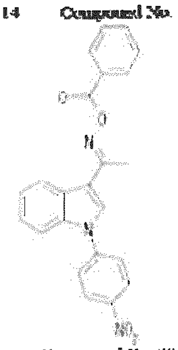

Compound No. 16

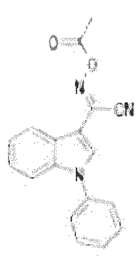

Compound No. 17

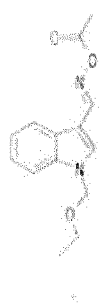

Compound No. 18

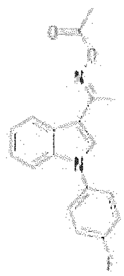

Compound No. 19

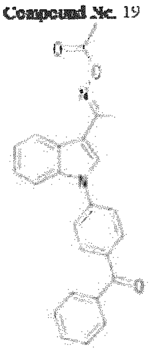

Compound No. 20

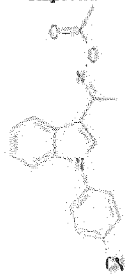

[Chem. 18]

Compound No. 21

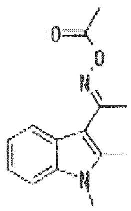

Compound No. 22

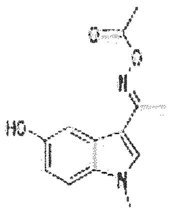

Compound No. 23

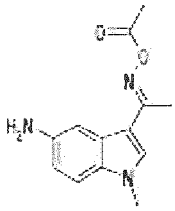

Compound No. 24

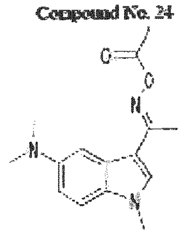

Compound No. 25

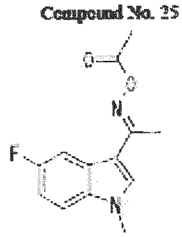

Compound No. 26

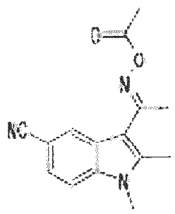

Compound No. 27

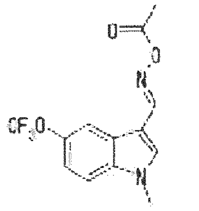

Compound No. 28

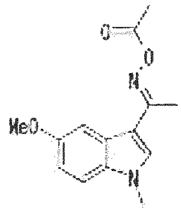

Compound No. 29

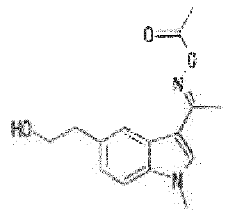

Compound No. 30

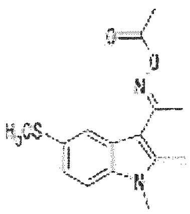

Compound No. 31

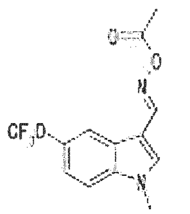

Compound No. 32

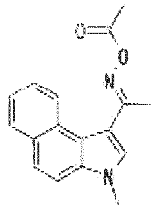

Compound No. 33

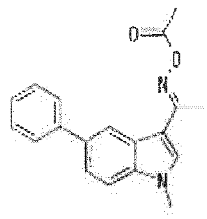

Compound No. 34

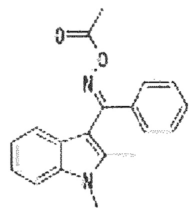

Compound No. 35

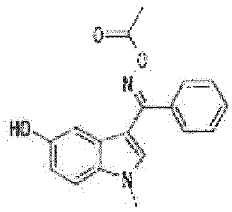

Compound No. 36

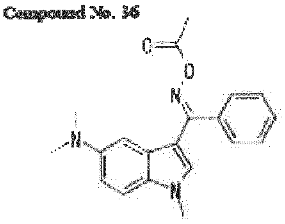

Compound No. 37

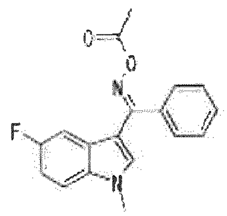

Compound No. 38

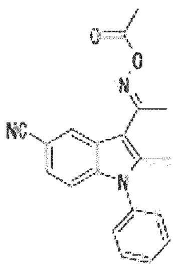

Compound No. 39

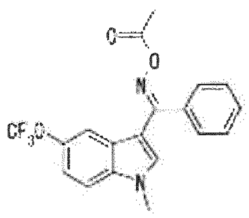

Compound No. 40

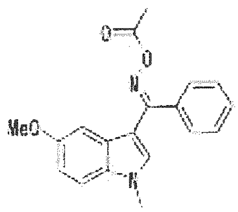

Compound No. 41

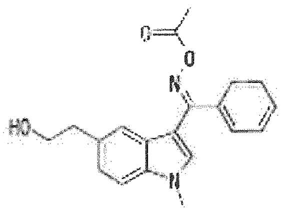

[Chem. 19]

Compound No. 42

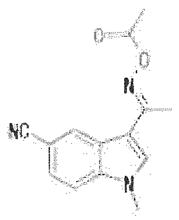

Compound No. 43

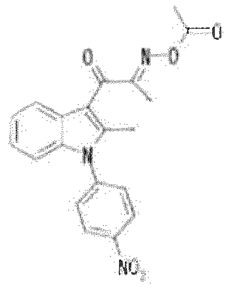

Compound No. 44

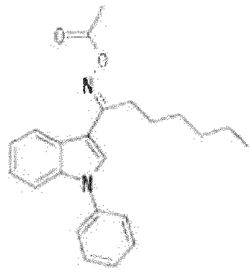

Compound No. 45

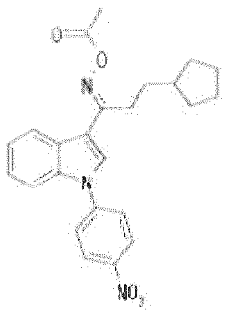

Compound No. 46

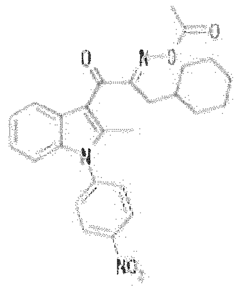

Compound No. 47

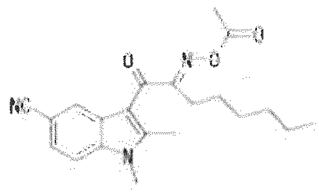

Compound No. 48

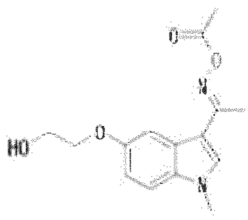

Compound No. 49

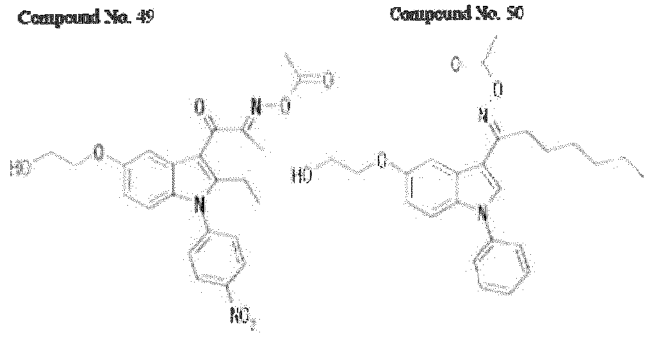

Compound No. 50

Compound No. 51

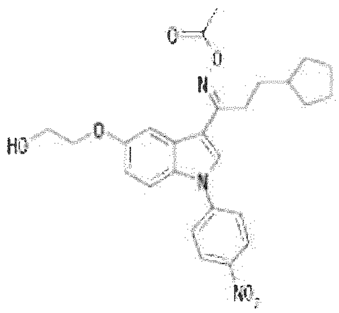

Compound No. 52

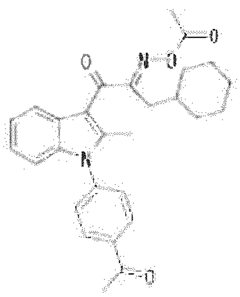

Compound No. 53

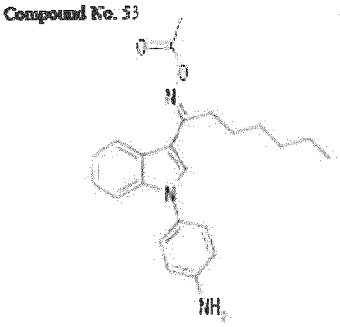

[Chem. 20]

Compound No. 54

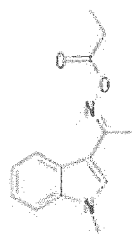

Compound No. 55

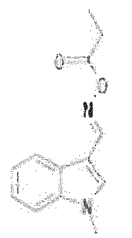

Compound No. 56

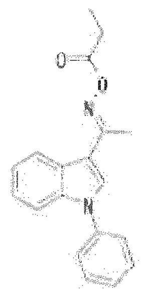

Compound No. 57

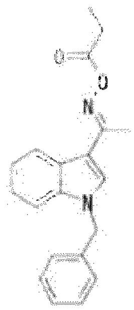

Compound No. 58

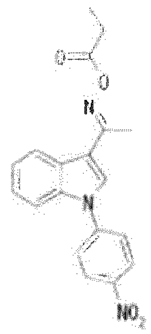

Compound No. 59

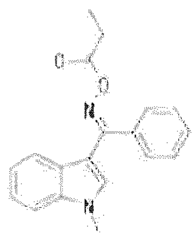

Compound No. 60

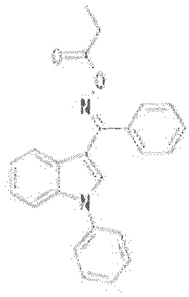

Compound No. 61

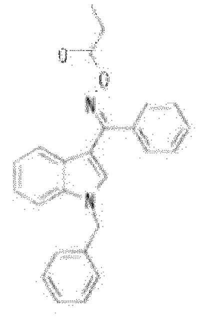

Compound No. 62

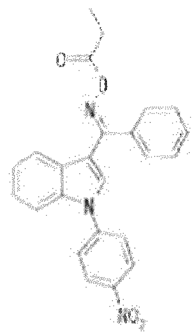

Compound No. 63

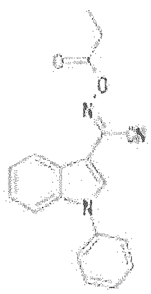

Compound No. 64

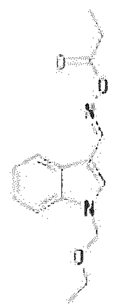

Compound No. 65

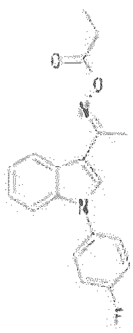

Compound No. 66

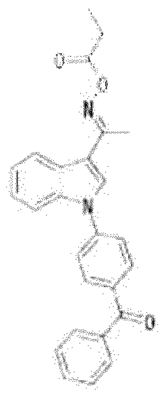

Compound No. 67

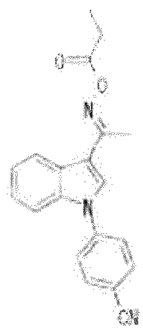

[Chem. 21]

Compound No. 68

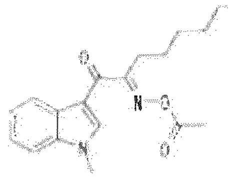

Compound No. 69

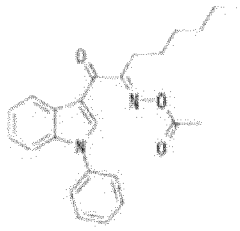

Compound No. 70

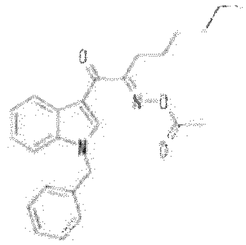

Compound No. 71

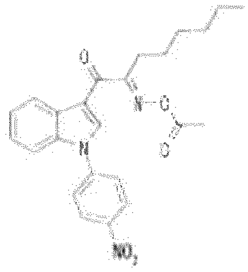

Compound No. 72

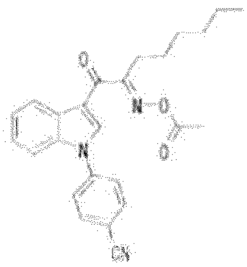

Compound No. 73

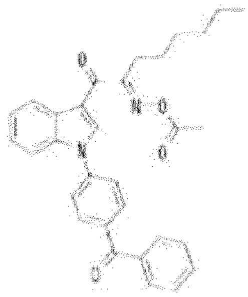

Compound No. 74

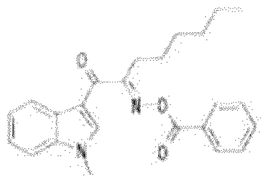

Compound No. 75

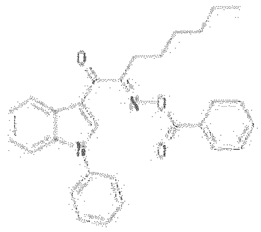

Compound No. 76

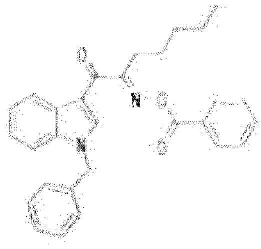

Compound No. 77

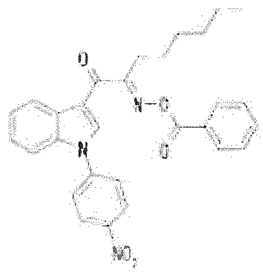

Compound No. 78

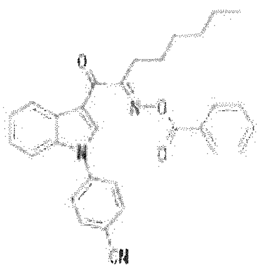

Compound No. 79

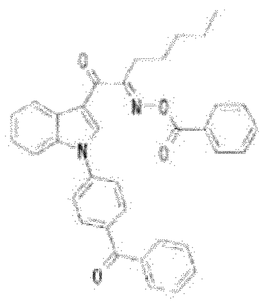

[Chem. 22]

Compound No. 80

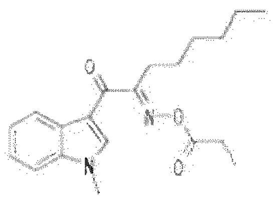

Compound No. 81

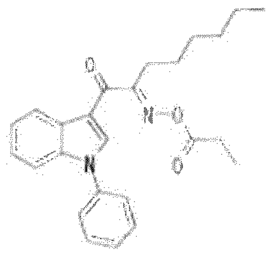

Compound No 82

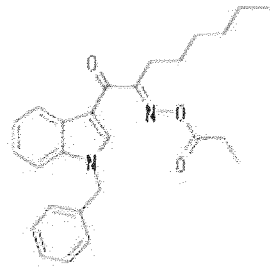

Compound No. 83

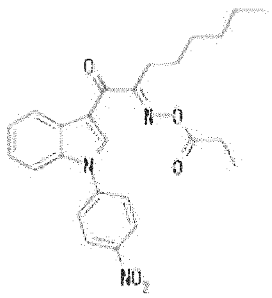

Compound No. 84

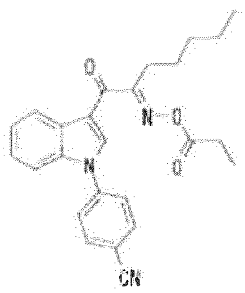

Compound No. 85

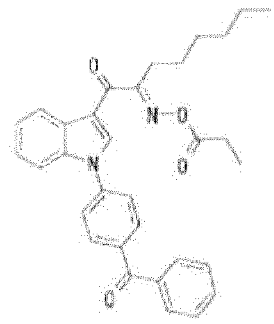

[Chem. 23]

Compound No. 86

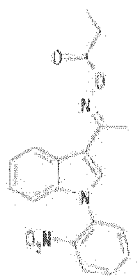

Compound No. 87

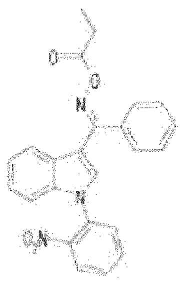

Compound No. 88

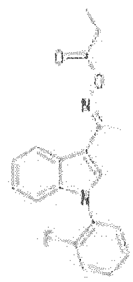

Compound No. 89

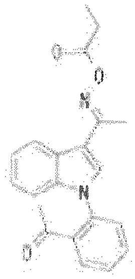

Compound No. 90

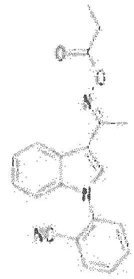

Compound No. 91

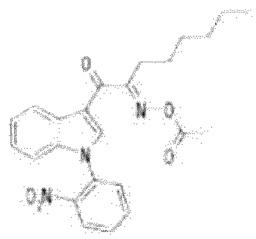

Compound No. 92

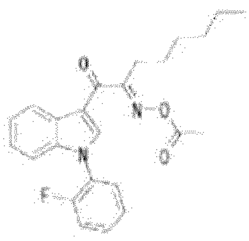

Compound No. 93

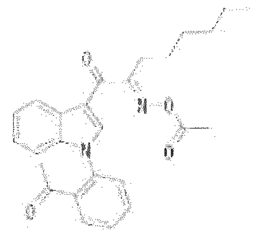

Compound No. 94

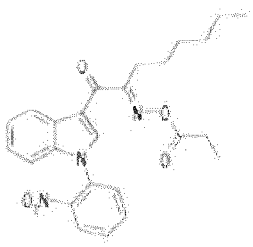

Compound No. 95

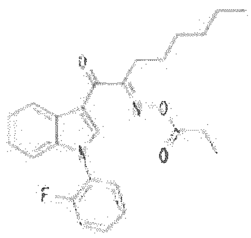

Compound No. 96

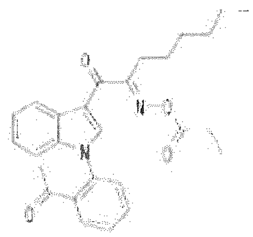

Compound No. 97

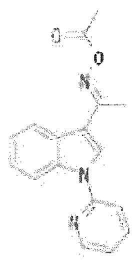

Compound No. 98

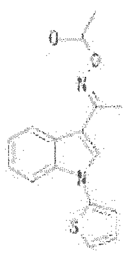

Compound No. 99

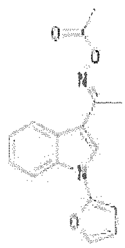

Compound No. 100

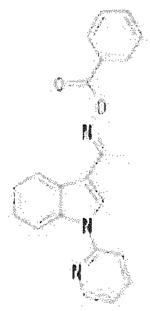

Compound No. 101

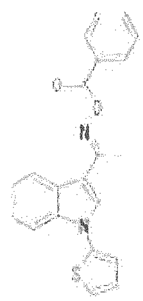

[Chem. 24]

Compound No. 102

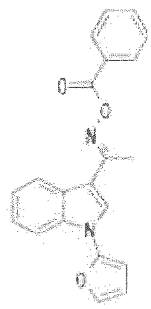

Compound No. 103

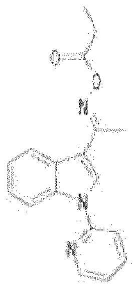

Compound No. 104

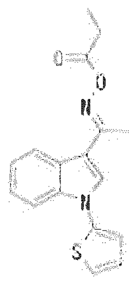

Compound No. 105

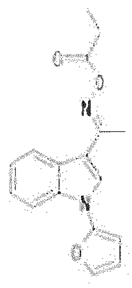

Compound No. 106

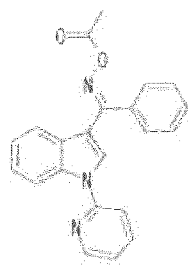

Compound No. 107

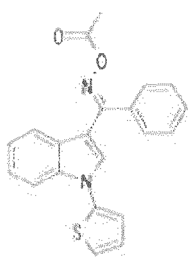

Compound No. 108

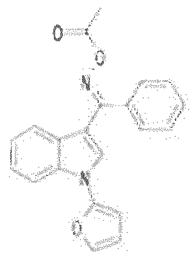

Compound No. 109

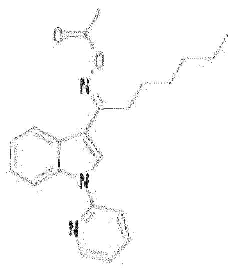

Compound No. 110

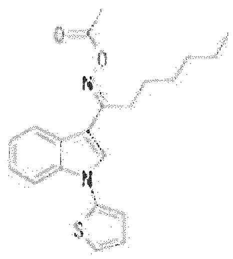

Compound No. 111

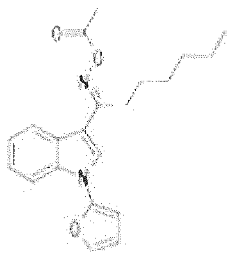

Compound No. 112

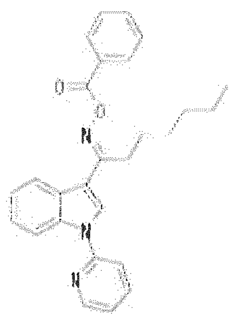

Compound No. 113

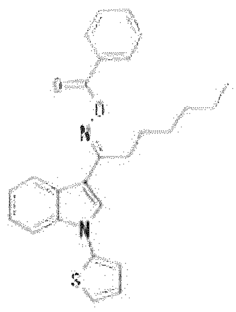

Compound No. 114

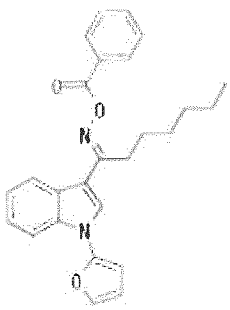

Compound No. 115

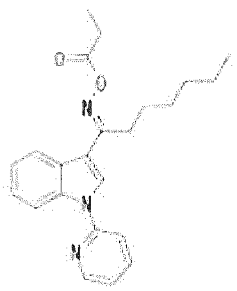

Compound No. 116

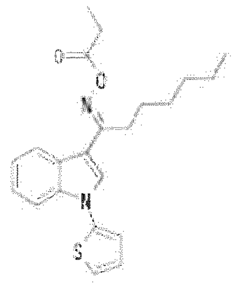

Compound No. 117

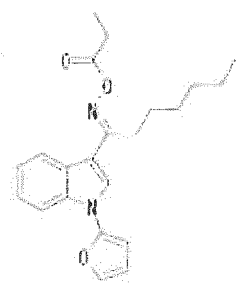

[Chem. 25]

Compound No. 118

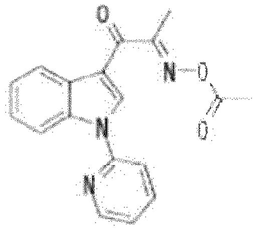

Compound No. 119

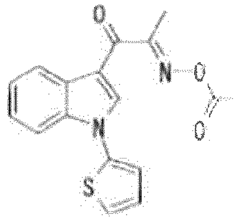

Compound No. 120

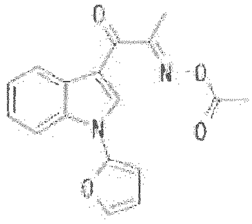

Compound No. 121

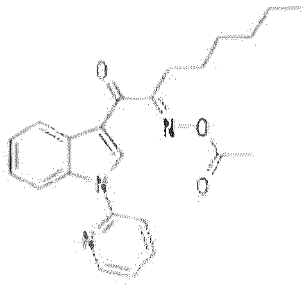

Compound No. 122

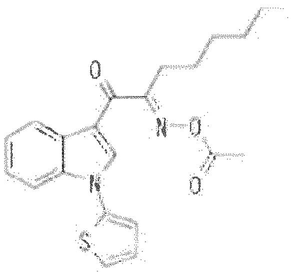

Compound No. 123

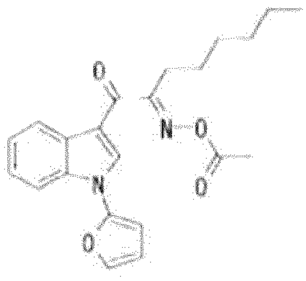

Compound No. 124

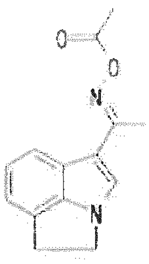

Compound No. 125

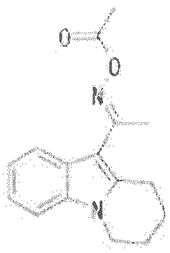

Compound No. 126

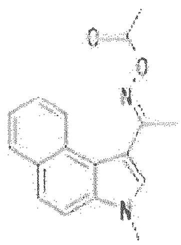

Compound No. 127

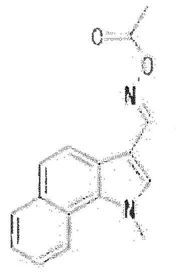

Compound No. 128

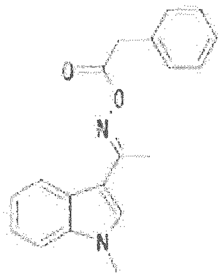

Compound No. 129

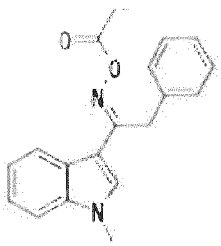

Compound No. 130

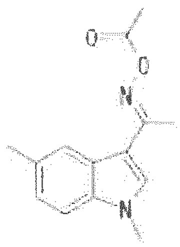

[Chem. 26]

Compound No. 131

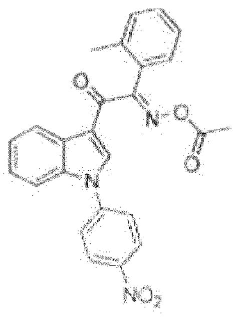

Compound No. 132

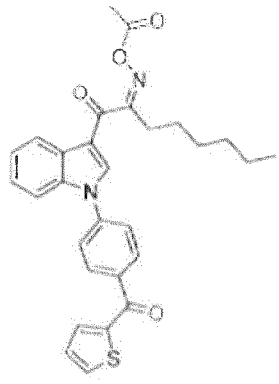

Compound No. 133

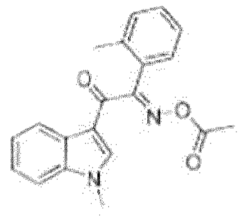

Compound No. 134

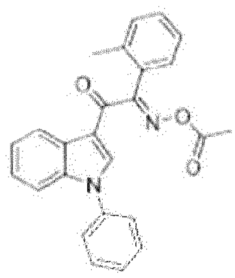

Compound No. 135

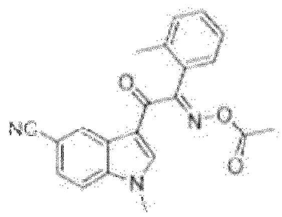

Compound No. 136

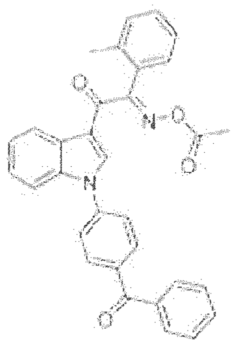

[Chem. 27]

Compound No. 137

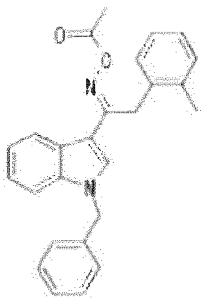

Compound No. 138

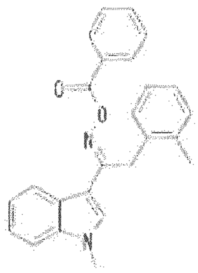

Compound No. 139

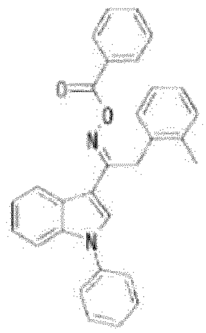

Compound No. 140

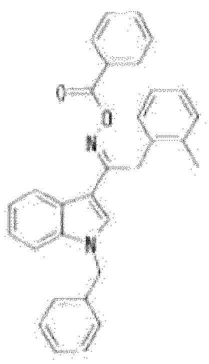

Compound No. 141

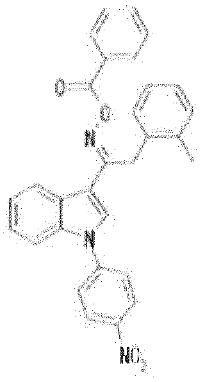

Compound No. 142

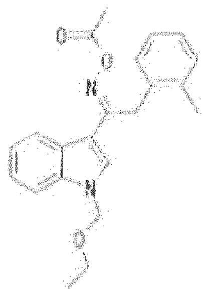

Compound No. 143

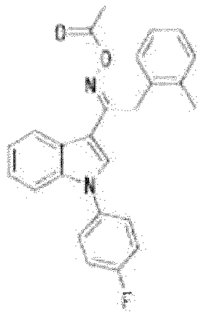

Compound No. 144

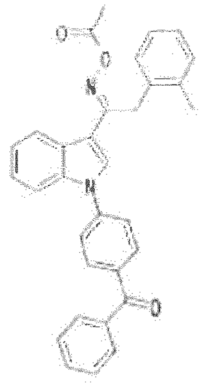

Compound No. 145

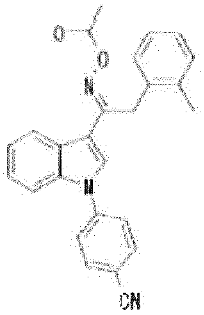

[Chem. 28]

Compound No. 146

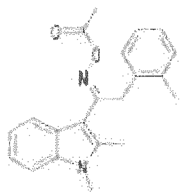

Compound No. 147

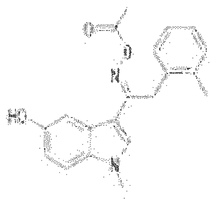

Compound No. 148

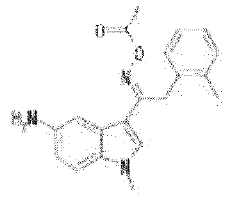

Compound No. 149

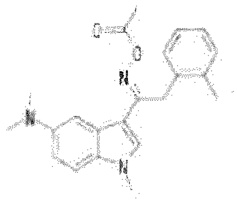

Compound No. 150

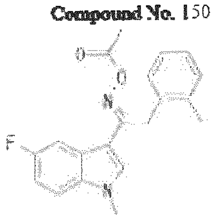

Compound No. 151

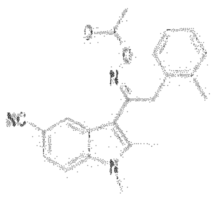

Compound No. 152

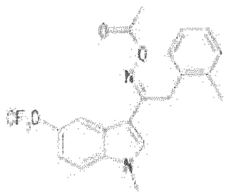

Compound No. 153

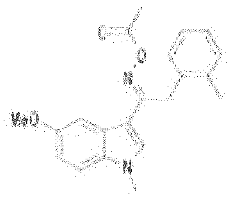

Compound No. 154

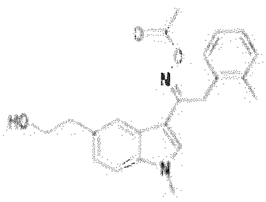

Compound No. 155

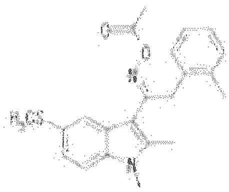

Compound No. 156

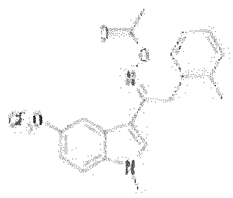

Compound No. 157

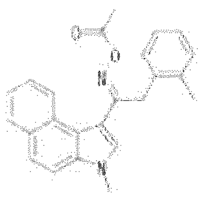

Compound No. 158

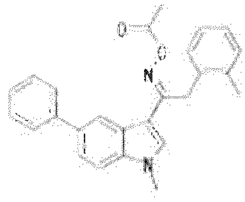

Compound No. 159

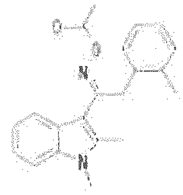

Compound No. 160

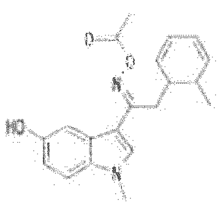

Compound No. 161

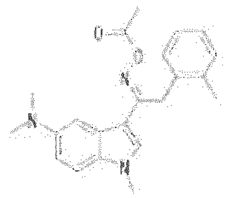

Compound No. 162

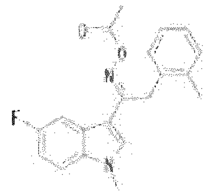

Compound No. 163

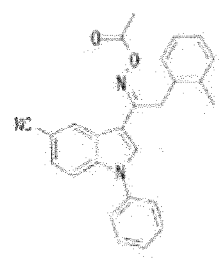

[Chem. 29]

Compound No. 164

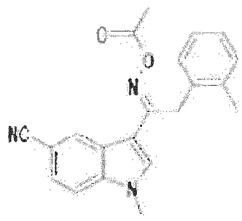

Compound No. 165

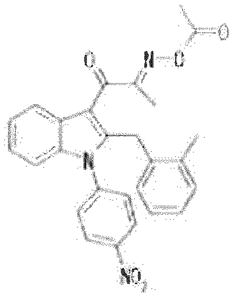

Compound No. 166

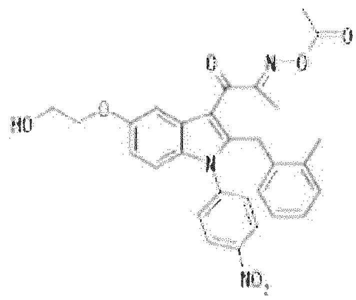

Compound No. 167

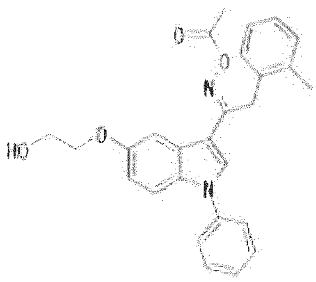

Compound No. 168

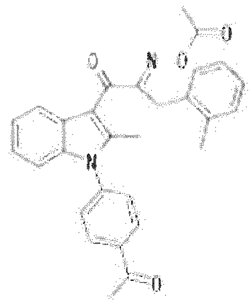

Compound No. 169

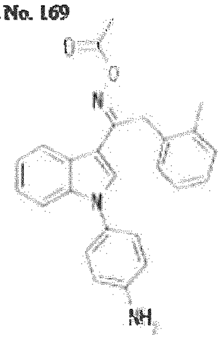

[Chem. 30]

Compound No. 170 Compound No. 171 Compound No. 172 Compound No. 173 Compound No. 174

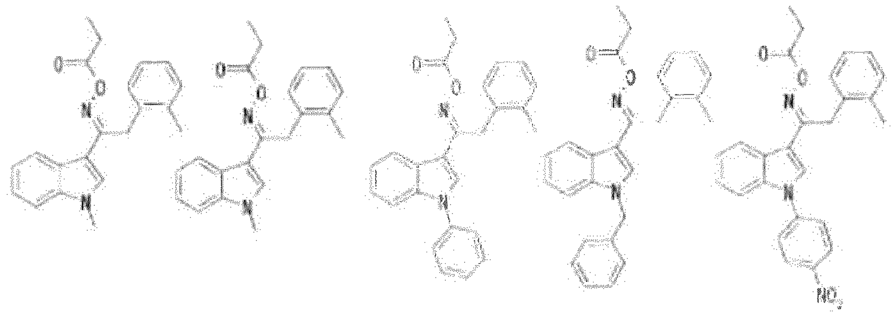

Compound No. 175 Compound No. 176 Compound No. 177 Compound No. 178

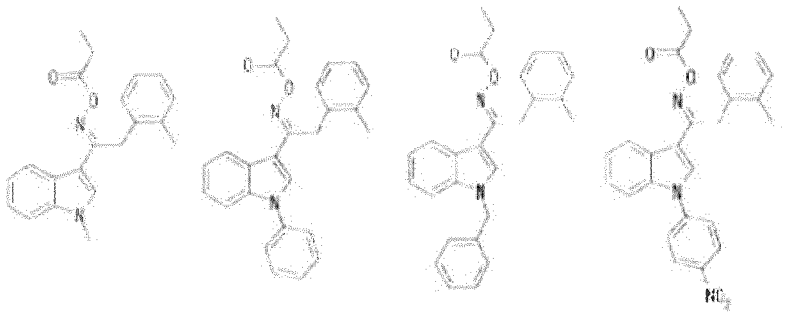

Compound No. 179 Compound No. 180 Compound No. 181 Compound No. 182 Compound No. 183

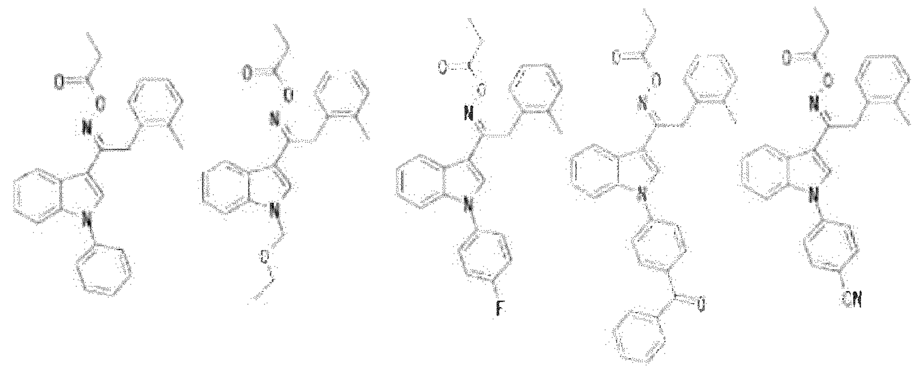

[Chem. 31]

Compound No. 184

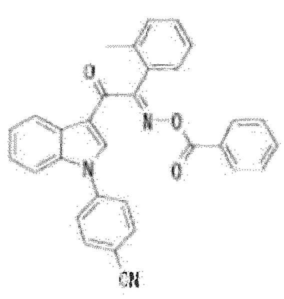

Compound No. 185

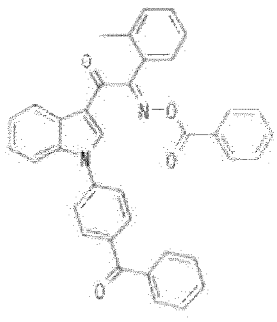

Compound No. 186

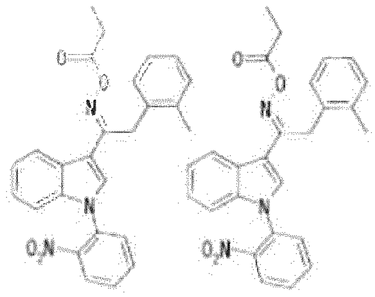

Compound No. 187

Compound No. 188

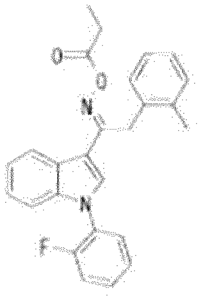

Compound No. 189

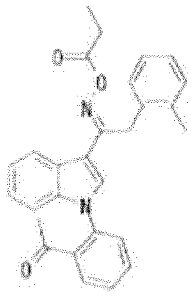

Compound No. 190

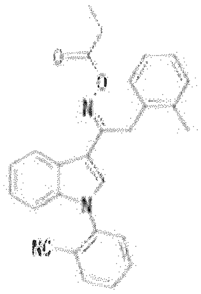

Compound No. 191

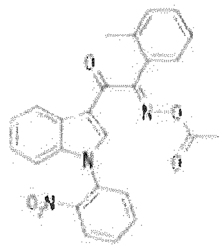

Compound No. 192

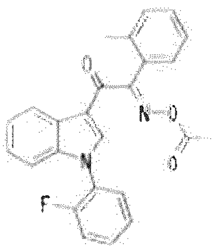

Compound No. 193

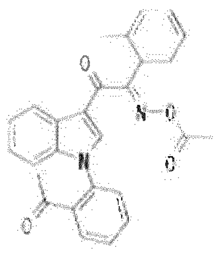

Compound No. 194

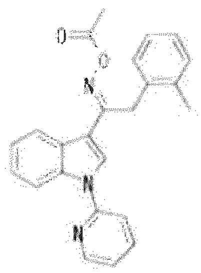

Compound No. 195

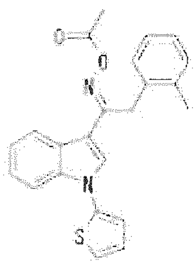

Compound No. 196

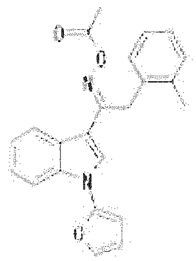

Compound No. 197

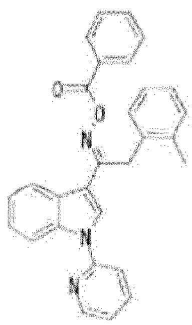

Compound No. 198

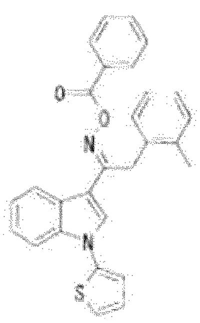

[Chem. 32]

Compound No. 203

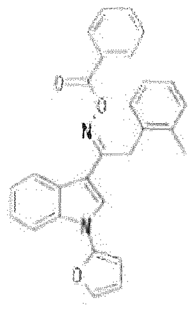

Compound No. 204

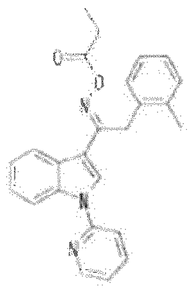

Compound No. 205

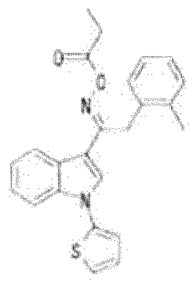

Compound No. 206

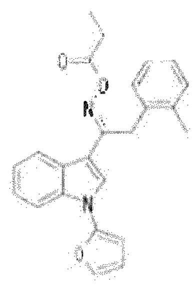

Compound No. 207

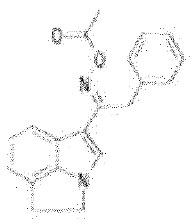

Compound No. 208

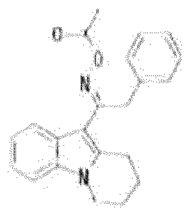

Compound No. 209

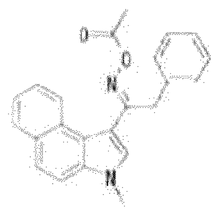

Compound No. 210

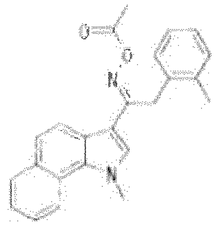

Compound No. 211

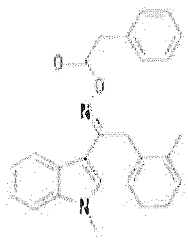

Compound No. 212

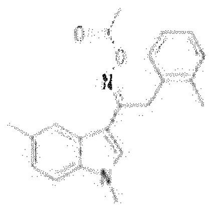

Compound No. 213

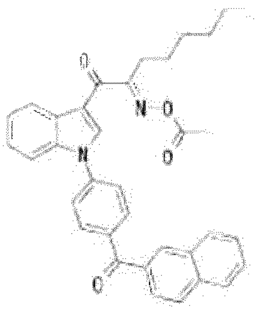

Compound No. 214

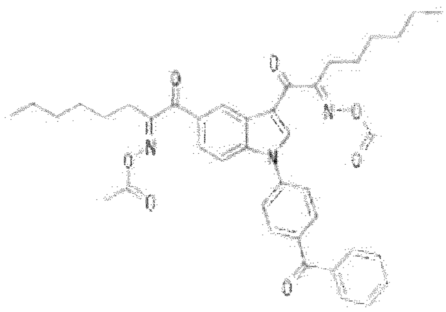

With regard to the above-mentioned polymerization initiator (B), a mixture of a plurality of oxime ester compounds represented by General Formula (I) above may be used, or the oxime ester compound represented by General Formula (I) above may be used in combination with an oxime ester compound represented by General Formula (II) below.

[Chem. 33]

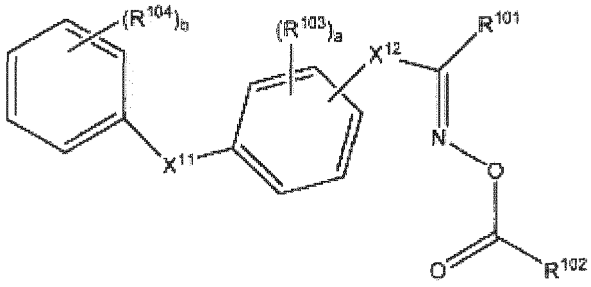

(II)

wherein, $R^{101}$ and $R^{102}$ independently represent a hydrogen atom, a cyano group, an alkyl group having 1 to 20 carbon atoms, an aryl group having 6 to 20 carbon atoms, an arylalkyl group having 7 to 20 carbon atoms, or a heterocycle-containing group having 2 to 20 carbon atoms,

$R^{103}$ and $R^{104}$ independently represent a halogen atom, a nitro group, a cyano group, a hydroxyl group, a carboxyl group, $R^{105}$, $OR^{106}$, $SR^{107}$, $NR^{108}R^{109}$, $COR^{110}$, $SOR^{111}$, $SO_2R^{112}$, or $CONR^{113}R^{114}$, $R^{103}$ and $R^{104}$ being optionally linked with each other to form a ring, and two $R^{103}$ or two $R^{104}$ being optionally linked together to form a ring,
$X^{11}$ represents an oxygen atom, a sulfur atom, a selenium atom, $CR^{115}R^{116}$, CO, $NR^{117}$, or $PR^{118}$,
$X^{12}$ represents a single bond or CO,
$R^{105}$, $R^{106}$, $R^{107}$, $R^{108}$, $R^{109}$, $R^{110}$, $R^{111}$, $R^{112}$, $R^{113}$, $R^{114}$, $R^{115}$, $R^{116}$, $R^{117}$, and $R^{118}$ independently represent an alkyl group having 1 to 20 carbon atoms, an aryl group having 6 to 20 carbon atoms, an arylalkyl group having 7 to 20 carbon atoms, or a heterocycle-containing group having 2 to 20 carbon atoms,
the alkyl group having 1 to 20 carbon atoms in $R^{101}$, $R^{102}$, $R^{105}$, $R^{106}$, $R^{107}$, $R^{108}$, $R^{109}$, $R^{110}$ , $R^{111}$ , $R^{112}$ , $R^{113}$, $R^{114}$, $R^{115}$, $R^{116}$, $R^{117}$, and $R^{118}$ may be linear, branched, or cyclic, or a combination of linear and cyclic forms or a combination of branched and cyclic forms,
a methylene group in the alkyl group having 1 to 20 carbon atoms or the arylalkyl group having 7 to 20 carbon atoms in $R^{101}$, $R^{102}$, $R^{105}$, $R^{106}$, $R^{107}$, $R^{108}$, $R^{109}$, $R^{110}$, $R^{111}$, $R^{112}$, $R^{113}$, $R^{114}$, $R^{115}$, $R^{116}$, $R^{117}$, and $R^{118}$ is optionally substituted with a halogen atom, a nitro group, a cyano group, a hydroxyl group, a carboxyl group, or a ring-containing group or is optionally interrupted by -O-,
a represents an integer from 0 to 4, and
b represents an integer from 0 to 5.

In the present invention, a polymerization initiator other than the polymerization initiators represented by General Formula (II) above can also be used as the polymerization initiator for use in combination with the oxime ester compounds represented by General Formula (I). Preferred examples of the other polymerization initiator include an acetophenone compound, a benzyl compound, a benzophenone compound, a thioxanthone compound, a bisimidazole compound, an acridine compound, and an acylphosphine compound.

Examples of the above-mentioned acetophenone compound include diethoxyacetophenone, 2-hydroxy-2-methyl-1-phenylpropan-1-one, 4'-isopropyl-2-hydroxy-2-methy lpropiophenone, 2-hydroxymethyl-2-methylpropiophenone, 2,2-dimethoxy-1,2-diphenylethan-1-one, p-dimethylaminoacetophenone, p-tert-butyldichloroacetophenone, p-tert-butyltrichloroacetophenone, p-azidobenzalacetophenone, 1-hydroxycyclohexyl phenyl ketone, 2-methyl-1-[4-(methylthio)phenyl]-2-morpholinopropanone-1, 2-benzyl-2-dimethylamino-1-(4-morpholinophenyl)-butanone-1, benzoin, benzoin methyl ether, benzoin ethyl ether, benzoin isopropyl ether, benzoin-n-butyl ether, benzoin isobutyl ether, and 1-[4-(2-hydroxyethoxy)-phenyl]-2-hydroxy-2-methyl-1-propan-1-one.

Examples of the above-mentioned benzyl compound include benzyl.

Examples of the above-mentioned benzophenone compound include benzophenone, methyl o-benzoylbenzoate, Michler's ketone, 4,4'-bisdiethylaminobenzophenone, 4,4'-dichlorobenzophenone, and 4-benzoyl-4'-methyldiphenyl sulfide.

Examples of the above-mentioned thioxanthone compound include thioxanthone, 2-methylthioxanthone, 2-ethylthioxanthone, 2-chlorothioxanthone, 2-isopropylthioxanthone, and 2,4-diethylthioxanthone.

A hexaarylbisimidazole (HABI, dimer of triaryl-imidazole) can be used as the above-mentioned bisimidazole compound, and specific examples thereof include 2,2'-bis(2-chlorophenyl)-4,4',5,5'-tetrakis(4-ethoxycarbonylphenyl)-1,2'-biimidazo le, 2,2'-bis(2-bromophenyl)-4,4',5,5'-tetrakis(4-ethoxycarbonylphenyl)-1,2'-biimidazole, 2,2'-bis(2-chlorophenyl)-4,4',5,5'-tetraphenyl-1,2'-biimidazole, 2,2'-bis(2,4-dichlorophenyl)-4,4',5,5'-tetraphenyl-1,2'-biimidazole, 2,2'-bis(2,4,6-trichlorophenyl)-4,4',5,5'-tetraphenyl-1,2'-biimidazole, 2,2'-bis(2-bromophenyl)-4,4',5,5'-tetraphenyl-1,2'-biimidazole, 2,2'-bis(2,4-dibromophenyl)-4,4',5,5'- tetraphenyl-1,2'-biimidazole, 2,2'-bis(2,4,6-tribromophenyl)-4,4',5,5'-tetraphenyl-1,2'-biimidazole, 2,4,5,2',4',5' -hexaphenylbisimidazole, 2,2'-bis(2-chlorophenyl)-4,5,4',5'-tetraphenylbisimidazole, 2,2'-bis(2-bromophenyl)-4,5,4',5'-tetraphenylbisimidazole, 2,2'-bis(2,4-dichlorophenyl)-4,5,4',5'-tetraphenylbisimidazole, 2,2'-bis(2-chlorophenyl)-4,5,4',5'-tetrakis(3-methoxyphenyl)bisimidazole, 2,2'-bis(2-chlorophenyl)-4,5,4',5'-tetrakis(3,4,5-trimethoxyphenyl)-bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazole, 2,2'-di-o-tolyl-4,5,4',5'-tetraphenylbisimidazole, 2,2'-bis(2-ethoxyphenyl)-4,5,4',5'-tetraphenylbisimidazole, 2,2'-bis(2,6-difluorophenyl)-4,5,4',5'-tetraphenylbisimidazole, 5'-tetra(p-iodophenyl)biimidazole, 2,2'-bis(o-chlorophenyl-4,4',5,5'-tetra(m-methoxyphenyl)biimidazole), 2,2'-bis(p-methylthiophenyl)-4,5,4',5'-diphenyL-1,1'-biimidazole, bis(2,4,5-triphenyl)-1,1'-biimidazole, 5,5'-tetra(p-chloronaphthyl)biimidazole, and the like; tautomers having a 1,2'-, 1,4'-, or 2,4'- covalent bond disclosed in JP S45-37377B; and compounds disclosed in WO 00/52529.

Examples of the above-mentioned acridine compound include acridine, 9-phenylacridine, 9-(p-methylphenyl)acridine, 9-(p-ethylphenyl)acridine, 9-(p-iso-propylphenyl)acridine, 9-(p-n-butylphenyl)acridine, 9-(p-tert-butylphenyl)acridine, 9-(p-methoxyphenyl)acridine, 9-(p-ethoxyphenyl)acridine, 9-(p-acetylphenyl)acridine, 9-(p-dimethylaminophenyl)acridine, 9-(p-cyanophenylphenyl)acridine, 9-(p-chlorodiphenyl)acridine, 9-(p-bromophenyl)acridine, 9-(m-methylphenyl)acridine, 9-(m-n-propylphenyl)acridine, 9-(m-iso-propylphenyl)acridine, 9-(m-n-butylphenyl)acridine, 9-(m-tert-butylphenyl)acridine, 9-(m-methoxyphenyl)acridine, 9-(m-ethoxyphenyl)acridine, 9-(m-acetylphenyl)acridine, 9-(m-dimethylaminophenyl)acridine, 9-(m-diethylaminophenyl)acridine, 9-(cyanophenyl)acridine, 9-(m-chlorophenyl)acridine, 9-(m-bromophenyl)acridine, 9-methylacridine, 9-ethylacridine, 9-n-propylacridine, 9-iso-propylacridine, 9-cyanoethylacridine, 9-hydroxyethylacridine, 9-chloroethylacridine, 9-bromoacridine, 9-hydroxyacridine, 9-nitroacridine, 9-aminoacridine, 9-methoxyacridine, 9-ethoxyacridine, 9-n-propoxyacridine, 9-iso-propoxyacridine, 9-chloroethoxyacridine, 4,6-bis(dimethylamino)acridine, 10-acridineacetic acid, 10-methylacetate acridine, 3,6-dimethylacridine, 7,13-dimethylacridine, 7,13-bis(dimethylamino)acridine, 3,6-dimethyl-10-acridineacetic acid, 3,5-dimethyl-10-methylacetate acridine, 7,13-dimethyl-10-acridineacetic acid, 7,13-dimethyl-10-methylacetate acridine, 1,7-bis(9-acridinyl)heptane, 1,5-bis(9-acridinyl)pentane, 1,3-bis(9-acridinyl)propane, 2,7-dibenzoyl-9-phenylacridine, 2,7-bis(a-hydroxybenzyl)-9-phenylacridine, 2,7-bis(a-acetoxybenzyl)-9-phenylacridine, 2,7-dimethyl-9-(4-methylphenyl)acridine, 2,7-dimethyl-9-phenylacridine, 2,7-bis(3,4-dimethyl-benzoyl)-9-(3,4-dimethylphenyl)acridine, 2,7-bis($\alpha$-acetoxy-4-tert-butylbenzyl)-9-(4-tert-butylphenyl)acridine, 2,7-dimethyl-9-(3,4-dichlorophenyl)acridine, 2,7-dimethyl-9-(4-benzoylphenyl)acridine, 2,7-bis(2-chlorobenzoyl)-9-(2-chlorophenyl)acridine, 2-(a-hydroxy-3-bromobenzyl)-6-methyl-9-(3-bromophenyl)acridine, 2,5-bis(4-tert-butylbenzoyl)-9-(4-tert-butylphenyl)acridine, 1,4-bis(2,7-dimethyl-9-acridinyl)benzene, 2,7-bis(a-phenylaminocarbonyloxy-3,4-dimethylbenzyl)-9-(3,4-dimethylphenyl)acridine, 2,7-bis(3,5-dimethyl-4-hydroxy-4'-fluorodiphenylmethyl)-9-(4-fluorophenyl)acridine, 9,10-dihydroacridine, 1-methylacridine, 4-methylacridine, 2,3-dimethylacridine, 1-phenylacridine, 4-phenylacridine, 1-benzylacridine, 4-benzylacridine, 1-chloroacridine, 2,3-dichloroacridine, 10-butyl-2-chloroacridin-9(10H)-one, 1 0-propyl-2-chloroacridin-9(10H)-one, 10-butyl-2-chloroacridin-9(10H)-one, 1,2-bis(9-acridinyl)ethane, 1,3-bis(9-acridinyl)propane, 1,4-bis(9-acridinyl)butane, 1,6-bis(9-acridinyl)hexane, 1,7-bis(9-acridinyl)heptane, 1,8-bis(9-acridinyl)octane, 1,9-bis(9-acridinyl)nonane, 1,10-bis(9-acridinyl)decane, 1,11-bis(9-acridinyl)undecane, 1,12-bis(9-acridinyl)dodecane, 1,14-bis(9-acridinyl)tetradecane, 1,16-bis(9-acridinyl)hexadecane, 1,18-bis(9-acridinyl)octadecane, 1,20-bis(9-acridinyl)eicosane, 1,3-bis(9-acridinyl)-2-thiapropane, 1,5-bis(9-acridinyl)-3-thiapentane, 7-methyl-benzo[c]acridine, 7-ethyl-benzo[c]acridine, 7-propyl-benzo[c]acridine, 7-butyl-benzo[c]acridine, 7-pentyl-benzo[c]acridine, 7-hexyl-benzo[c]acridine, 7-heptyl-benzo[c]acridine, 7-octyl-benzo[c]acridine, 7-nonyl-benzo[c]acridine, 7-decyl-benzo[c]acridine, 7-undecyl-benzo[c]acridine, 7-dodecyl-benzo[c]acridine, 7-tridecyl-benzo[c]acridine, 7-tetradecyl-benzo[c]acridine, 7-pentadecyl-benzo[c]acridine, 7-hexadecyl-benzo[c]acridine, 7-heptadecyl-benzo [c]acridine, 7-octadecyl-benzo [c]acridine, 7-nonadecyl-benzo[c]acridine, 1,1-bis(7-benzo[c]acridinyl)methane, 1,2-bis(7-benzo[c]acridinyl)ethane, 1,3 -bis(7-benzo [c]acridinyl)propane, 1,4-bis(7-benzo[c]acridinyl)butane, 1,5-bis(7-benzo[c]acridinyl)pentane, 1,6-bis(7-benzo[c]acridinyl)hexane, 1,7-bis(7-benzo[c]acridinyl)heptane, 1,8-bis(7-benzo[c]acridinyl)octane, 1,9-bis(7-benzo[c]acridinyl)nonane, 1,10-bis(7-benzo[c]acridinyl)decane, 1,11-bis(7-benzo[c]acridinyl)undecane, 1,12-bis(7-benzo[c]acridinyl)dodecane, 1,13-bis(7-benzo[c]acridinyl)tridecane, 1,14-bis(7-benzo[c]acridinyl)tetradecane, 1,15-bis(7-benzo[c]acridinyl)pentadecane, 1,16-bis(7-benzo[c]acridinyl)hexadecane, 1,17-bis(7-benzo[c]acridinyl)heptadecane, 1,18-bis(7-benzo[c]acridinyl)octadecane, 1,19-bis(7-benzo[c]acridinyl)nonadecane, 1,20-bis(7-benzo[c] acridinyl)eico sane, 7-phenyl-benzo [c]acridine, 7-(2-chlorophenyl)-benzo[c]acridine, 7-(4-methylphenyl)-benzo[c]acridine, 7-(4-nitrophenyl)-benzo[c]acridine, 1,3-bis(7-benzo[c]acridinyl)benzene, 1,4-bis(7-benzo[c]acridinyl)benzene, 7-[1-propen-3-yl(benzo[c]acridine)], 7-[1-ethylpentyl-(benzo[c]acridine)], 7-[8-heptadecenyl-(benzo[c]acridine)], 7,8-diphenyl-1,14-bis(7-benzo[c]acridinyl)tetradecane, 1,2-bis(7-benzo[c]acridinyl)ethylene, 1-methyl-1,2-bis(7-benzo[c]acridinyl)ethylene, 7-styryl-benzo [c] acridine, 7-(1-propenyl)-benzo[c] acridine, 7-(1-pentenyl)-benzo [c]acridine, 9-(2-pyridyl)acridine, 9-(3-pyridyl)acridine, 9-(4-pyridyl)acridine, 9-(4-pyrimidinyl)acridine, 9-(2-pyrazinyl)acridine, 9(5-methyl-2-pyrazinyl)acridine, 9-(2-quinolinyl)acridine, 9-(2-pyridyl)-2-methyl-acridine, 9-(2-pyridy1)-2-ethylacridine, 9-(3-pyridyl)-2-methyl-acridine, 9-(3-pyridyl)-2,4-diethyl-acridine, 3,6-diamino-acridine sulfonate, 3,6-bis-(dimethylamino)-acridine sulfonate, 3,6-diamino-10-methyl-acridinium chloride, and 9-acridinecarboxylic acid.

Examples of the above-mentioned acylphosphine compound include 2,4,6-trimethylbenzoyldiphenylphosphine oxide (Lucirin TPO; manufactured by BASF), isobutyryl-methyl phosphinic acid methyl ester, isobutyryl-phenyl phosphinic acid methyl ester, pivaloyl-phenyl phosphinic acid methyl ester, 2-ethylhexanoyl-phenyl phosphinic acid methyl ester, pivaloyl-phenyl phosphinic acid isopropyl ester, p-toluyl-phenyl phosphinic acid methyl ester, o-toluyl-phenyl phosphinic acid methyl ester, 2,4-dimethylbenzoyl-phenyl phosphinic acid methyl ester, p-tert-butylbenzoyl-phenyl phosphinic acid isopropyl ester, acryloyl-phenyl phosphinic acid methyl ester, isobutyryl-diphenylphosphine oxide, 2-ethylhexanoyl-diphenylphosphine oxide, o-toluyl-diphenylphosphine oxide, p-tert-butylbenzoyl-diphenylphosphine oxide, 3-pyridylcarbonyl-diphenylphosphine oxide, acryloyl-diphenylphosphine oxide, benzoyl-diphenylphosphine oxide, pivaloyl-phenyl phosphinic acid vinyl ester, adipoyl-bis-diphenylphosphine oxide, pivaloyl-diphenylphosphine oxide, p-toluyl-diphenylphosphine oxide, 4-(tert-butyl)-benzoyl-diphenylphosphine oxide, 2-methylbenzoyl-diphenylphosphine oxide, 2-methyl-2-ethylhexanoyl-diphenylphosphine oxide, 1-methyl-cyclohexanoyl-diphenylphosphine oxide, pivaloyl-phenylphosphinic acid methyl ester, pivaloyl-phenyl phosphinic acid isopropyl ester, 4-octylphenylphosphine oxide, terephthaloyl-bis-diphenylphosphine oxide, 1-methyl-cyclohexylcarbonyldiphenylphosphine oxide, versatoyl-diphenylphosphine oxide, bis(2,4,6-trimethylbenzoyl)-2,4-diisobutoxyphenylphosphine oxide, bis(2,4,6-trimethylbenzoyl)phenylphosphine oxide (Irgacure819; manufactured by BASF), bis(2,4,6-trimethylbenzoyl)-2, 5-dimethylphenylphosphine oxide, bis(2,6-dichloro-3,4,5-trimethoxybenzoyl)-2,5-dimethylphenylphosphine oxide, bis(2,6-dichloro-3,4,5-trimethoxybenzoyl)-4-ethoxyphenylphosphine oxide, bis(2-methyl-1-naphthoyl)-2,5-dimethylphenylphosphine oxide, bis(2-methyl-1 -naphthoyl)-4-ethoxyphenylphosphine oxide, bis(2-methyl-1-naphthoyl)-2-naphthylphosphine oxide, bis(2-methyl-1-naphthoyl)-4-propylphenylphosphine oxide, bis(2-methyl-1-naphthoyl)-2,5-dimethylphenylphosphine oxide, bis(2-methoxy-1-naphthoyl)-4-ethoxyphenylphosphine oxide, bis(2-chloro-1-naphthoyl)-2,5-dimethylphenylphosphine oxide, bis(2,6-dimethoxybenzoyl)-2,4,4-trimethylpentylphosphine oxide, bis(2,4,6-trimethylbenzoyl)-2,4-dioctyloxyphenylphosphine oxide, bis(2,4,6-trimethylbenzoyl)-2,4-diisopropoxyphenylphosphine oxide, bis(2,4,6-trimethylbenzoyl)-2,4-dihexyloxyphenylphosphine oxide, bis(2,4,6-trimethylbenzoyl)-2-propoxy-4-methylphenylphosphine oxide, bis(2,4,6-trimethylbenzoyl)-2,4-diisopentyloxyphenylphosphine oxide, bis(2,6-dichlorobenzoyl)phenylphosphine oxide, bis(2,6-dichlorobenzoyl)-2,5-dimethylphenylphosphine oxide, bis(2,6-dichlorobenzoyl)-phenylphosphine oxide, bis(2,6-dichlorobenzoyl)-4-biphenylylphosphine oxide, bis(2,6-dichlorobenzoyl)-4-propylphenylphosphine oxide, bis(2,6-dichlorobenzoyl)-2-naphthylphosphine oxide, bis(2,6-dichlorobenzoyl)-1-naphthylphosphine oxide, bis(2,6-dimethoxybenzoyl)-2,4,4-trimethyl-pentylphosphine oxide (CGI403), and 6-trimethylbenzoyl-ethyl-phenyl-phosphinate (SPEEDCURE TPO-L; manufactured by Lambson).

In the composition of the present invention, the total content of the above-mentioned polymerization initiator is preferably 0.1 to 30 mass% and particularly preferably 0.5 to 10 mass% based on the solid content of the composition of the present invention. A content of the above-mentioned polymerization initiator of less than 0.1 mass% may result in insufficient curing through exposure to light, and a content of more than 30 mass% may cause precipitation of the initiator in a resin composition. The proportion of the oxime ester compound represented by General Formula (I) above with respect to 100 parts by mass of the polymerization initiator as a whole is preferably not less than 25 parts by mass, more preferably not less than 50 parts by mass, and particularly preferably not less than 75 parts by mass.

The composition of the present invention can also be used as a photosensitive composition by mixing, with the latent antioxidant (A) and the polymerization initiator (B), a resin and a photopolymerizable unsaturated monomer, and also a solvent, an inorganic compound, a coloring material, and the like, if necessary.

As the resin, any resin that is compatible with the above-mentioned polymerization initiator and the photopolymerizable unsaturated monomer can be used without limitation, and examples thereof include homopolymers and copolymers containing a repeating unit derived from the photopolymerizable unsaturated monomer. Among these, a methacryliate ester copolymer, a polyvinyl alcohol/polyvinyl ether/polyvinyl ester copolymer, an unsaturated polyester, and the like have excellent compatibility with the photopolymerizable unsaturated monomer and are therefore preferable, and a resin having an acid value is preferable in light of photolithographic properties.

As the resin (or its monomer) having an acid value, the following can be used: (meth)acrylic acid, $\alpha$-chloroacrylic acid, itaconic acid, maleic acid, citraconic acid, fumaric acid, himic acid, crotonic acid, isocrotonic acid, vinylacetic acid, allylacetic acid, cinnamic acid, sorbic acid, mesaconic acid, mono[2-(meth)acryloyloxyethyl] succinate, mono[2-(meth)acryloyloxyethyl] phthalate, mono(meth)acrylates of polymers having a carboxy group and a hydroxyl group at both termini such as $\omega$-carboxypolycaprolactone mono(meth)acrylate, and unsaturated polybasic acids such as hydroxyethyl(meth)acrylate·maleate, hydroxypropyl(meth)acrylate·maleate, dicyclopentadiene·maleate, and polyfunctional (meth)acrylates having one carboxyl group and two or more (meth)acryloyl groups; esters between an unsaturated monobasic acid and a polyhydric alcohol or a polyhydric phenol such as dipentaerythritol penta(meth)acrylate and pentaerythritol tri(meth)acrylate; unsaturated aromatic compounds such as 4-hydroxystyrene, vinylbenzoic acid, vinylphenol, vinylsulfonic acid, 4-vinylbenzenesulfonic acid, and vinylbenzyl glycidyl ether; vinyl alcohols such as allyl alcohol and crotyl alcohol; reaction products of a polyfunctional acrylate containing a hydroxyl group (such as pentaerythritol triacrylate or dipentaerythritol pentaacrylate) with a dibasic acid anhydride (such as succinic anhydride, phthalic anhydride, or tetrahydrophthalic anhydride); reaction products of a bisphenol epoxy compound or a novolac epoxy compound with an unsaturated monobasic acid; and products obtained by reacting, with an acid anhydride such as a polybasic

acid anhydride, a reaction product of a bisphenol epoxy compound or a novolac epoxy compound with an unsaturated monobasic acid. These monomers can be used singly or in combinations of two or more thereof. Moreover, it is preferable that the above-mentioned resin having an acid value contain an unsaturated group in an amount of 0.2 to 1.0 equivalents.

Examples of the above-mentioned unsaturated monobasic acid to be reacted with the epoxy group of the bisphenol epoxy compound or novolac epoxy compound include acrylic acid, methacrylic acid, crotonic acid, cinnamic acid, sorbic acid, hydroxyethyl methacrylate·malate, hydroxyethyl acrylate·malate, hydroxypropyl methacrylate·malate, hydroxypropyl acrylate malate, and dicyclopentadiene malate.

Moreover, examples of the above-mentioned polybasic acid anhydride to be reacted after the reaction between the bisphenol epoxy compound or novolac epoxy compound and the unsaturated monobasic acid include biphenyltetracarboxylic dianhydride, tetrahydrophthalic anhydride, succinic anhydride, maleic anhydride, trimellitic anhydride, pyromellitic anhydride, 2,2'-3,3'-benzophenonetetracarboxylic anhydride, ethylene glycol bisanhydrotrimellitate, glycerol trisanhydrotrimellitate, hexahydrophthalic anhydride, methyltetrahydrophthalic anhydride, nadic anhydride, methylnadic anhydride, trialkyltetrahydrophthalic anhydride, hexahydrophthalic anhydride, 5-(2,5-dioxotetrahydrofuryl)-3-methyl-3-cyclohexene-1,2-dicarboxylic anhydride, trialkyltetrahydrophthalic anhydride-maleic anhydride adduct, dodecenylsuccinic anhydride, and methylhimic anhydride.

It is preferable that the reaction molar ratio of the epoxy compound, the unsaturated monobasic acid, and the polybasic acid anhydride be set as follows: the epoxy compound and the unsaturated monobasic acid are reacted to produce an epoxy adduct that has a structure in which 0.1 to 1.0 carboxyl group of the unsaturated monobasic acid has been added with respect to one epoxy group of the epoxy compound, and the epoxy adduct and the polybasic acid anhydride are reacted in a ratio such that 0.1 to 1.0 acid anhydride structure of the polybasic acid anhydride is present with respect to one hydroxyl group of the epoxy adduct.

The epoxy compound, the unsaturated monobasic acid, and the polybasic acid anhydride can be reacted in accordance with a commonly used procedure.

In order to adjust the acid value of the above-mentioned resin having an acid value to thereby improve the developability of the composition of the present invention, a monofunctional or polyfunctional epoxy compound can be further used. For the resin having an acid value, it is preferable that the acid value of the solid content thereof be within a range of 5 to 120 mg KOH/g, and it is preferable that the amount of the monofunctional or polyfunctional epoxy compound used be selected so as to satisfy the above preferable range of the acid value.

Examples of the above-mentioned monofunctional epoxy compound include glycidyl methacrylate, methyl glycidyl ether, ethyl glycidyl ether, propyl glycidyl ether, isopropyl glycidyl ether, butyl glycidyl ether, isobutyl glycidyl ether, t-butyl glycidyl ether, pentyl glycidyl ether, hexyl glycidyl ether, heptyl glycidyl ether, octyl glycidyl ether, nonyl glycidyl ether, decyl glycidyl ether, undecyl glycidyl ether, dodecyl glycidyl ether, tridecyl glycidyl ether, tetradecyl glycidyl ether, pentadecyl glycidyl ether, hexadecyl glycidyl ether, 2-ethylhexyl glycidyl ether, allyl glycidyl ether, propargyl glycidyl ether, p-methoxyethyl glycidyl ether, phenyl glycidyl ether, p-methoxy glycidyl ether, p-butylphenol glycidyl ether, cresyl glycidyl ether, 2-methylcresyl glycidyl ether, 4-nonylphenyl glycidyl ether, benzyl glycidyl ether, p-cumylphenyl glycidyl ether, trityl glycidyl ether, 2,3-epoxypropyl methacrylate, epoxidized soybean oil, epoxidized linseed oil, glycidyl butyrate, vinylcyclohexane monooxide, 1,2-epoxy-4-vinylcyclohexane, styrene oxide, pinene oxide, methylstyrene oxide, cyclohexene oxide, propylene oxide, and compounds No. A2, No. A3, etc. below.

It is preferable to use one or more of compounds selected from the group consisting of bisphenol epoxy compounds and glycidyl ethers as the above-mentioned polyfunctional epoxy compound because an alkali-developable photosensitive composition having even more favorable characteristics can be obtained. As the bisphenol epoxy compound, an epoxy compound represented by General Formula (1) above or a bisphenol epoxy compound such as a hydrogenated bisphenol epoxy compound can be used. Examples of the glycidyl ethers include ethylene glycol diglycidyl ether, propylene glycol diglycidyl ether, 1,4-butanediol diglycidyl ether, 1,6-hexanediol diglycidyl ether, 1,8-octanediol diglycidyl ether, 1,10-decanediol diglycidyl ether, 2,2-dimethyl-1,3-propanediol diglycidyl ether, diethylene glycol diglycidyl ether, triethylene glycol diglycidyl ether, tetraethylene glycol diglycidyl ether, hexaethylene glycol diglycidyl ether, 1,4-cyclohexanedimethanol diglycidyl ether, 1,1,1-tri(glycidyloxymethyl)propane, 1,1,1-tri(glycidyloxymethyl)ethane, 1,1,1 -tri(glycidyloxymethyl)methane, and 1,1,1,1-tetra(glycidyloxymethyl)methane.

The following can also be used: novolac epoxy compounds such as a phenol novolac epoxy compound, a biphenyl novolac epoxy compound, a cresol novolac epoxy compound, a bisphenol-A novolac epoxy compound, and a dicyclopentadiene novolac epoxy compound; alicyclic epoxy compounds such as 3,4-epoxy-6-methylcyclohexylmethyl-3,4-epoxy -6-methylcyclohexane carboxylate, 3,4-epoxycyclohexylmethyl-3,4-epoxycyclohexane carboxylate, and 1-epoxyethyl-3,4-epoxycyclohexane; glycidyl esters such as diglycidyl phthalate ester, diglycidyl tetrahydrophthalate ester, and glycidyl dimerate ester; glycidyl amines such as tetraglycidyldiaminodiphenylmethane, triglycidyl-p-aminophenol, and N,N-diglycidylaniline; heterocyclic epoxy compounds such as 1,3-diglycidyl-5,5-dimethylhydantoin and triglycidyl isocyanurate; dioxide compounds such as dicyclopentadiene dioxide; and naphthalene epoxy compounds, triphenylmethane epoxy compounds, dicyclopentadiene epoxy compounds, and the like.

Among the above-mentioned resins having an acid value, unsaturated polybasic acids and polyfunctional

acrylates having an acid value are preferable in terms of compatibility, alkali-developability, and thermal resistance, and polyfunctional acrylates having an acid value is particularly preferable.

Commercially available resins can also be used as the above-mentioned resin having an acid value, and examples thereof include SPC-1000 and SPC-3000 (manufactured by Showa Denko K.K.), AX3-BX, AX3-RD1, and AX3-RD2 (manufactured by Nippon Shokubai Co., Ltd.), and JET2000 (manufactured by Osaka Organic Chemical Industry Ltd.).

There is no particular limitation on the above-mentioned photopolymerizable unsaturated monomer, and photopolymerizable unsaturated monomers that are conventionally used in a photosensitive composition can be used. Examples thereof include unsaturated aliphatic hydrocarbons such as ethylene, propylene, butylene, isobutylene, vinyl chloride, vinylidene chloride, vinylidene fluoride, and tetrafluoroethylene; (meth)acrylic acid, α-chloroacrylic acid, itaconic acid, maleic acid, citraconic acid, fumaric acid, himic acid, crotonic acid, isocrotonic acid, vinylacetic acid, allylacetic acid, cinnamic acid, sorbic acid, mesaconic acid, mono[2-(meth)acryloyloxyethyl] succinate, mono [2-(meth)acryloyloxyethyl] phthalate, and mono(meth)acrylates of polymers having a carboxy group and a hydroxyl group at both termini such as ω-carboxypolycaprolactone mono(meth)acrylate; unsaturated monobasic acids such as hydroxyethyl (meth)acrylatemalate, hydroxypropyl (meth)acrylate·malate, dicyclopentadiene·malate, and polyfunctional (meth)acrylates having one carboxyl group and two or more (meth)acryloyl groups; esters between an unsaturated monobasic acid and a polyhydric alcohol or a polyhydric phenol such as 2-hydroxyethyl (meth)acrylate, 2-hydroxypropyl (meth)acrylate, glycidyl (meth)acrylate, compounds No. A1 to No. A4 below, methyl (meth)acrylate, butyl (meth)acrylate, isobutyl (meth)acrylate, t-butyl (meth)acrylate, cyclohexyl (meth)acrylate, n-octyl (meth)acrylate, isooctyl (meth)acrylate, isononyl (meth)acrylate, stearyl (meth)acrylate, lauryl (meth)acrylate, methoxyethyl (meth)acrylate, dimethylaminomethyl (meth)acrylate, dimethylaminoethyl (meth)acrylate, aminopropyl (meth)acrylate, dimethylaminopropyl (meth)acrylate, ethoxyethyl (meth)acrylate, poly(ethoxy)ethyl (meth)acrylate, butoxyethoxyethyl (meth)acrylate, ethylhexyl (meth)acrylate, phenoxyethyl (meth)acrylate, tetrahydrofuryl (meth)acrylate, vinyl (meth)acrylate, allyl (meth)acrylate, benzyl (meth)acrylate, ethylene glycol di(meth)acrylate, diethylene glycol di(meth)acrylate, triethylene glycol di(meth)acrylate, polyethylene glycol di(meth)acrylate, propylene glycol di(meth)acrylate, 1,4-butanediol di(meth)acrylate, 1,6-hexanediol di(meth)acrylate, trimethylolethane tri(meth)acrylate, trimethylolpropane tri(meth)acrylate, dipentaerythritol hexa(meth)acrylate, dipentaerythritol penta(meth)acrylate, pentaerythritol tetra(meth)acrylate, pentaerythritol tri(meth)acrylate, tricyclodecanedimethylol di(meth)acrylate, tri[(meth)acryloylethyl] isocyanurate, and a polyester (meth)acrylate oligomer; metal salts of unsaturated polybasic acids such as zinc (meth)acrylate and magnesium (meth)acrylate; acid anhydrides of unsaturated polybasic acids such as maleic anhydride, itaconic anhydride, citraconic anhydride, methyltetrahydrophthalic anhydride, tetrahydrophthalic anhydride, trialkyltetrahydrophthalic anhydride, 5-(2,5-dioxotetrahydrofuryl)-3-methyl-3-cyclohexene-1 ,2-dicarboxylic anhydride, trialkyltetrahydrophthalic anhydride-maleic anhydride adduct, dodecenylsuccinic anhydride, and methylhimic anhydride; amides between an unsaturated monobasic acid and a polyamine such as (meth)acrylamide, methylene bis-(meth)acrylamide, diethylenetriamine tris(meth)acrylamide, xylylene bis(meth)acrylamide, α-chloroacrylamide, and N-2-hydroxyethyl(meth)acrylamide; unsaturated aldehydes such as acrolein; unsaturated nitriles such as (meth)acrylonitrile, α-chloroacrylonitrile, vinylidene cyanide, and allyl cyanide; unsaturated aromatic compounds such as styrene, 4-methylstyrene, 4-ethylstyrene, 4-methoxystyrene, 4-hydroxystyrene, 4-chlorostyrene, divinylbenzene, vinyltoluene, vinylbenzoic acid, vinylphenol, vinylsulfonic acid, 4-vinylbenzenesulfonic acid, vinylbenzyl methyl ether, and vinylbenzyl glycidyl ether; unsaturated ketones such as methyl vinyl ketone; unsaturated amine compounds such as vinylamine, allylamine, N-vinylpyrrolidone, and vinyl piperidine; vinyl alcohols such as allyl alcohol and crotyl alcohol; vinyl ethers such as vinyl methyl ether, vinyl ethyl ether, n-butyl vinyl ether, isobutyl vinyl ether, and allyl glycidyl ether; unsaturated imides such as maleimide, N-phenylmaleimide, and N-cyclohexylmaleimide; indenes such as indene and 1-methylindene; aliphatic conjugated dienes such as 1,3-butadiene, isoprene, and chloroprene; macromonomers having a mono(meth)acryloyl group at the terminus of the molecular chain of the polymer such as polystyrene, polymethyl(meth)acrylate, poly-n-butyl(meth)acrylate, and polysiloxane; vinyl chloride, vinylidene chloride, divinyl succinate, diallyl phthalate, triallyl phosphate, triallyl isocyanurate, vinyl thioether, vinylimidazole, vinyloxazoline, vinylcarbazole, vinylpyrrolidone, vinylpyridine, vinylurethane compounds between a vinyl monomer containing a hydroxyl group and a polyisocyanate compound, and vinyl epoxy compounds between a vinyl monomer containing a hydroxyl group and a polyepoxy compound.

[Chem. 34]

Compound No. A1

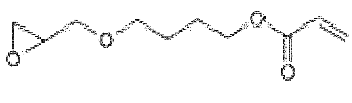

[Chem. 35]

Compound No. A2

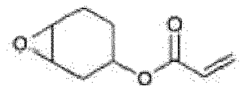

[Chem. 36]

Compound No. A3

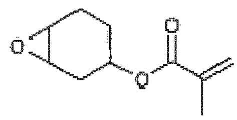

[Chem. 37]

Compound No. A4

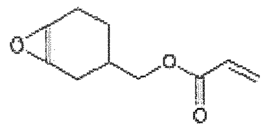

Among the various compounds mentioned above as the examples of the photopolymerizable unsaturated monomer, esters between an unsaturated monobasic acid and a polyhydric alcohol or a polyhydric phenol are particularly preferably used in light of curability and chromaticity characteristics.

When the composition of the present invention is a photosensitive composition, the content of the above-mentioned polymerizable unsaturated monomer preferably satisfies the mass ratio of the resin : the photopolymerizable unsaturated monomer = 35 to 95 : 5 to 65, and preferably 40 to 90 : 10 to 60.

Moreover, when the composition of the present invention is a photosensitive composition, the total amount of the above-mentioned resin and the above-mentioned polymerizable unsaturated monomer is preferably 20 to 80 mass% and more preferably 30 to 70 mass% based on the solid content of the composition of the present invention. If the total content of the resin and the polymerizable unsaturated monomer is less than 20 mass%, a cured film may not be sufficiently hardened. If the total content is more than 80 mass%, the chromaticity characteristics may be insufficient due to an insufficient amount of coloring agent.

With regard to the solvent, a solvent in which the above-mentioned components (the polymerization initiator, the resin, the photopolymerizable unsaturated monomer, etc.) can be dissolved or dispersed is usually used as needed, and examples thereof include ketones such as methyl ethyl ketone, methyl amyl ketone, diethyl ketone, acetone, methyl isopropyl ketone, methyl isobutyl ketone, cyclohexanone, and 2-heptanone; ether-based solvents such as ethyl ether, dioxane, tetrahydrofuran, 1,2-dimethoxyethane, 1,2-diethoxyethane, and dipropylene glycol dimethyl ether; ester-based solvents such as methyl acetate, ethyl acetate, n-propyl acetate, isopropyl acetate, n-butyl acetate, cyclohexyl acetate, ethyl lactate, dimethyl succinate, and texanol; Cellosolve-based solvents such as ethylene glycol monomethyl ether and ethylene glycol monoethyl ether; alcohol-based solvents such as methanol, ethanol, isopropanol, n-propanol, isobutanol, n-butanol, and amyl alcohol; ether ester-based solvents such as ethylene glycol monomethyl ether acetate, ethylene glycol monoethyl ether acetate, propylene glycol-1-monomethyl ether-2-acetate (PGMEA), 4-hydroxy-4-methyl-2-pentanone, dipropylene glycol monomethyl ether acetate, 3-methoxybutyl ether acetate, and ethoxyethyl ether propionate; BTX-based solvents such as benzene, toluene, and xylene; aliphatic hydrocarbon-based solvents such as hexane, heptane, octane, and cyclohexane; terpene-based hydrocarbon oils such as turpentine oil, D-limonene, and pinene; paraffin-based solvents such as mineral spirit, Swasol #310 (Cosmo Matsuyama Oil Co., Ltd.), and Solvesso #100 (ExxonMobil Chemical); halogenated aliphatic hydrocarbon-based solvents such as carbon tetrachloride, chloroform, trichloroethylene, methylene chloride, and 1,2-dichloroethane; halogenated aromatic hydrocarbon-based solvents such as chlorobenzene; Carbitol-based solvents, aniline, triethylamine, pyridine, acetic acid, acetonitrile, carbon disulfide, N,N-dimethylformamide, N,N-dimethylacetamide, N-methylpyrrolidone, dimethylsulfoxide, and water. These solvents can be used singly or in combinations of two or more. Among these, the ketones, the etherester-based solvents, and the like, in particular, propylene glycol-1-monomethyl ether-2-acetate (PGMEA), cyclohexanone, and the like are preferable because these solvents have good compatibility with a resist and the polymerization initiator in a colored composition.

When the composition of the present invention is a photosensitive composition, the amount of the solvent used is preferably set such that the concentration of the composition excluding the solvent is 5 to 30 mass%. A concentration of less than 5 mass% is not preferable because the film thickness is difficult to increase to thereby result in that light of a desired wavelength cannot be sufficiently absorbed. A concentration of more than 30 mass% is not preferable because a decrease in storage stability and an increase in viscosity of the composition due to precipitation of the composition will occur to thereby lead to deterioration of handling.

Examples of the aforementioned inorganic compound include metal oxides such as nickel oxide, iron oxide, iridium oxide, titanium oxide, zinc oxide, magnesium oxide, calcium oxide, potassium oxide, silica, and alumina; layered clay minerals, Milori blue, calcium carbide, magnesium carbide, cobalt-based compounds, manganese-based compounds, glass powder (in particular, glass frit), mica, talc, kaolin, ferrocyanides, various metal sulfates, sulfides, selenides, aluminum silicate, calcium silicate, aluminum hydroxide, platinum, gold, silver, and copper.

Among these, glass frit, titanium oxide, silica, layered clay minerals, silver, and the like are preferable. The content of the inorganic compound in the photosensitive composition of the present invention is preferably 0.1 to 1000 parts by mass and more preferably 10 to 800 parts by mass with respect to 100 parts by mass of the above-mentioned resin. These inorganic compounds can be used singly or in combinations of two or more.

These inorganic compounds are used as a filler, an antireflection agent, a conducting agent, a stabilizer, a flame retardant, a mechanical strength improving agent, a special-wavelength absorber, an ink repellent, or the like.

A dispersant for dispersing the coloring material and/or the inorganic compound can be incorporated into the photosensitive composition of the present invention. There is no limitation on the dispersant as long as the dispersant can disperse and stabilize the coloring material or the inorganic compound, and commercially available dispersants such as BYK series manufactured by BYK can be used as the dispersant. In particular, preferably used are polymeric dispersants including polyester, polyether, or polyurethane having a basic functional group having a nitrogen atom, the functional group having a nitrogen atom being amine and/or quaternary salts thereof with an amine value of 1 to 100 mg KOH/g.

Examples of the coloring material include pigments, dyes, and natural coloring matters. These coloring materials can be used singly or by in combinations of two or more.

An organic pigment or an inorganic pigment can be used as the above-mentioned pigment, and examples thereof include nitroso compounds; nitro compounds; azo compounds; diazo compounds; xanthene compounds; quinoline compounds; anthraquinone compounds; coumarin compounds; phthalocyanine compounds; isoindolinone compounds; isoindolin compounds; quinacridone compounds; anthanthrone compounds; perinone compounds; perylene compounds; diketopyrrolopyrrole compounds; thioindigo compounds; dioxazine compounds; triphenylmethane compounds; quinophthalone compounds; naphthalenetetracarboxylic acids; metal complex compounds such as azo dyes and cyanine dyes; lake pigments; carbon blacks such as those obtained by using a furnace method, a channel method, or a thermal method, or acetylene black, Ketjen black, or lamp black; modified carbon blacks obtained by conditioning or coating the above-mentioned carbon blacks with an epoxy resin, or obtained by subjecting the above-mentioned carbon blacks to a dispersion treatment with a resin in a solvent to adsorb the resin thereon in an amount of 20 to 200 mg/g; suface-treated carbon blacks obtained by subjecting the above-mentioned carbon blacks to an acidic or alkaline suface treatment; carbon blacks having an average particle diameter of 8 nm or more and a DBP oil absorption number of 90 ml/100 g or less; carbon blacks having a total oxygen amount of 9 mg or more per 100 $m^2$ of the surface area thereof, the total oxygen amount being calculated from CO and $CO_2$ in volatile components at 950°C; graphite, graphitized carbon black, active carbon, carbon fibers, carbon nanotubes, carbon microcoils, carbon nanohorns, carbon aerogels, and fullerene; aniline black, Pigment Black 7, and titanium black; chromic oxide green, Milori blue, cobalt green, cobalt blue, manganese-based pigments, ferrocyanides, phosphate ultramarine blue, Prussian blue, ultramarine, ceculean blue, viridian, emerald green, lead sulfate, yellow lead, zinc yellow, Bengal red (red iron oxide (III)), cadmium red, synthetic iron black, and amber. These pigments can be used singly or in combinations of two or more thereof.

Commercially available pigments can also be used as the above-mentioned pigment, and examples thereof include Pigment Red 1, 2, 3, 9, 10, 14, 17, 22, 23, 31, 38, 41, 48, 49, 88, 90, 97, 112, 119, 122, 123, 144, 149, 166, 168, 169, 170, 171, 177, 179, 180, 184, 185, 192, 200, 202, 209, 215, 216, 217, 220, 223, 224, 226, 227, 228, 240, and 254; Pigment Orange 13, 31, 34, 36, 38, 43, 46, 48, 49, 51, 52, 55, 59, 60, 61, 62, 64, 65, and 71; Pigment Yellow 1, 3, 12, 13, 14, 16, 17, 20, 24, 55, 60, 73, 81, 83, 86, 93, 95, 97, 98, 100, 109, 110, 113, 114, 117, 120, 125, 126, 127, 129, 137, 138, 139, 147, 148, 150, 151, 152, 153, 154, 166, 168, 175, 180, and 185; Pigment Green 7, 10, and 36; Pigment Blue 15, 15:1, 15:2, 15:3, 15:4, 15:5, 15:6, 22, 24, 56, 60, 61, 62, and 64; and Pigment Violet 1, 19, 23, 27, 29, 30, 32, 37, 40, and 50.

Examples of the above-mentioned dyes include azo dyes, anthraquinone dyes, indigoid dyes, triarylmethane dyes, xanthene dyes, alizarin dyes, acridine dyes, stilbene dyes, thiazole dyes, naphthol dyes, quinoline dyes, nitro dyes, indamine dyes, oxazine dyes, phthalocyanine dyes, and cyanine dyes. These dyes may be used in combinations of two or more thereof.

When the composition of the present invention is used as a photosensitive composition, the content of the above-mentioned coloring material is preferably 50 to 350 parts by mass and more preferably 100 to 250 parts by mass with respect to 100 parts by mass of the above-mentioned resin.

Commonly used additives can be further incorporated into the composition of the present invention as needed, and examples thereof include a thermal polymerization suppressing agent such as p-anisole, hydroquinone, pyrocatechol, t-butylcatechol, or phenothiazine; a plasticizer; an adhesion promoter; a filler; an antifoaming agent; a leveling agent; a surface conditioner; an antioxidant; an ultraviolet absorber; a dispersion assistant; an aggregation preventing agent; a catalyst; an curing accelerator; a cross-linking agent; a thickening agent; a chain transfer agent; a sensitizer; a surfactant; a silane coupling agent; and melamine.

The amounts of the optional components used (excluding the other photopolymerization initiator, the resin, the photopolymerizable unsaturated monomer, the inorganic compound (filler), the coloring material, and the solvent mentioned above) other than the above-mentioned latent additive (A) and polymerization initiator (B) in the composition of the present invention are selected as appropriate based on the purposes for which the optional components are used, and are not particularly limited; however, the total amount thereof used is preferably not more than 50 parts by mass with respect to 100 parts by mass of the above-mentioned resin.

Moreover, another organic polymer can also be used together with the polymerizable compound having an ethylenically unsaturated bond in the photosensitive composition of the present invention to improve the characteristics of the resulting cured product. Examples of these organic polymers include polystyrene, polymethyl methacrylate, a methyl methacrylate-ethyl acrylate copolymer, poly(meth)acrylic acid, a styrene-(meth)acrylic acid copolymer, a (meth)acrylic acid-methyl methacrylate copolymer, an ethylene-vinyl chloride copolymer, an ethylene-vinyl copolymer, a polyvinyl chloride resin, an ABS resin, nylon 6, nylon 66, nylon 12, a urethane resin, polycarbonate polyvinyl butyral, cellulose ester, polyacrylamide, saturated polyester, a phenol resin, a phenoxy resin, a polyamideimide resin, a polyamic acid resin, and an epoxy resin. Among these, polystyrene, a (meth)acrylic acid-methyl methacrylate copolymer, and an epoxy resin are preferable.

When the another organic polymer is used, the amount thereof used is preferably 10 to 500 parts by mass with respect to 100 parts by mass of the above-mentioned resin.

In order to activate the polymerization initiator (B) used in the composition of the present invention to cure the composition, a light source that emit light having a wavelength of 300 to 450 nm can be used. For example, ultra-high-pressure mercury, mercury-vapor arc, carbon arc, xenon arc, and the like can be employed.

The exposure time to an energy beam depends on the intensity of the energy beam, the coating thickness, and the polymerizable organic compound, but an exposure time of about 0.1 second to 10 seconds is usually sufficient. However, a longer irradiation time is preferred for a relatively thick coating. In 0.1 second to several minutes after irradiation with an energy beam, most of the compositions become dry-to-touch through polymerization. But in some cases, it is also preferable to use thermal energy provided by heating, a thermal head, or the like in combination with irradiation so as to accelerate the polymerization.

When the composition of the present invention is used as a photosensitive composition, a pattern can be formed by performing the following steps.

That is to say, a pattern is preferably formed by performing (1) a step of forming a coating of the composition of the present invention on a substrate, (2) a step of irradiating the coating with radiation via a mask having a predetermined pattern shape, (3) a step of baking after the exposure, (4) a step of developing the resulting exposed film, and (5) a step of heating the developed film.

Multi-tone masks such as a half-tone mask and a gray scale mask can also be used as the above-mentioned mask.

The composition of the present invention has excellent sensitivity and transparency as described above. Moreover, due to the high transparency, the composition of the present invention can form molded articles or cured films having excellent luminance. These molded articles and cured films can be used for color filters, overcoatings, spacers, micro lens arrays, and transparent insulating films, for example.

Specific examples of applications in which the composition of the present invention can be used include, but not limited to, optical filters; paints; coating materials; lining agents; adhesives; printing plates; insulating varnishes; insulation sheets; laminated plates; printed circuit boards; sealants for semiconductor devices, LED packages, liquid crystal inlets, organic EL devices, optical elements, electrical insulating materials, electronic components, separation membranes, and the like; molded materials; putties; glass fiber impregnants; fillers; passivation films for semiconductors, solar cells, and the like; interlayer insulation films that are used in thin-film transistors (TFT), liquid crystal displays, organic EL displays, printed circuit boards, and the like; surface protection films; printed circuit boards; color filters of color televisions, PC monitors, personal data assistants, and CCD image sensors; electrode materials for plasma display panels; printing inks; dental compositions; resins for stereolithography; liquid-form films and dry films; micromachine components; glass fiber cable coatings; materials for holographic recording; magnetic recording materials; optical switches; plating masks; etching masks; screen printing stencils; touch panels such as transparent conductive films; MEMS

elements; nanoimprint materials; photofabrication applications such as two-dimensional and three-dimensional high-density mounting of semiconductor packages; decoration sheets; artificial nails; glass-alternative optical films; electronic papers; optical disks; microlens arrays used in projectors, optical communication lasers, and the like; prism lens sheets used in backlights of liquid crystal displays; Fresnel lens sheets used in the screens of projection televisions and the like; lens parts of lens sheets such as lenticular lens sheets; backlights and the like using these sheets; optical lenses such as microlenses and image pickup lenses; optical elements; optical connectors; optical waveguides; insulation packings; heat-shrinkable rubber tubes; O-rings; sealing agents for display devices; protective materials; optical fiber protection materials; pressure-sensitive adhesives; die bonding agents; high-heat radiation materials; high-heat resistant sealing materials; members for solar cells, fuel cells, and secondary batteries; solid electrolytes for batteries; insulation coating materials; photoconductor drums for copying machines; gas separation membranes; civil engineering and construction materials, such as concrete protecting materials, linings, soil injection materials, sealing materials, cold/heat storage materials, glass coatings, and foams; medical materials, such as tubes, seal materials, coating materials, sealing materials for sterilizers, contact lenses, oxygen enrichment membranes, and biochips; automobile components; and various mechanical components.

Examples

Hereinafter, the present invention will be described in more detail by way of examples and the like. However, the present invention is not limited to the following examples. It should be noted that numerical values in Tables 1 to 3 and 3A to 3C are shown in parts by mass.

Examples 1-1 to 1-9 and Comparative Examples 1-1 to 1-10

Production and evaluation of compositions

Compositions were prepared in accordance with formulations shown in Tables 1 to 3. Each composition was applied to a glass substrate through spin coating (900 rpm, for 10 seconds), prebaked at 90°C for 90 seconds with a hot plate, and exposed to light from a high-pressure mercury lamp as a light source (a number of films were prepared while the exposure was changing from 20 mJ/cm$^2$ to 200 mJ/cm$^2$ in increments of 20 mJ/cm$^2$). The resulting coating film was developed with a 2.5 mass% aqueous solution of sodium carbonate as a developing solution for 40 seconds using a spin development apparatus, and then well washed with water. The resulting film was postbaked at 230°C for 30 minutes using an oven to fix a pattern.

Table 1

| | | Ex. 1-1 | Ex. 1-2 | Ex. 1-3 | Ex. 1-4 | Ex. 1-5 | Ex. 1-6 | Ex. 1-7 |
|---|---|---|---|---|---|---|---|---|
| A | A-1 | 0.4 | | | | 0.4 | | |
| | A-2 | | 0.4 | | | | 0.4 | |
| | A-3 | | | 0.4 | | | | 0.4 |
| | A-4 | | | | 0.4 | | | |
| | A'-1 | | | | | | | |

(continued)

| | | Ex. 1-1 | Ex. 1-2 | Ex. 1-3 | Ex. 1-4 | Ex. 1-5 | Ex. 1-6 | Ex. 1-7 |
|---|---|---|---|---|---|---|---|---|
| B | Compound No. 5 | 0.34 | | | | | | |
| | Compound No. 20 | | 0.34 | | | | | |
| | Compound No. 51 | | | 0.34 | | | | |
| | Compound No. 71 | | | | 0.34 | | | |
| | Compound No. 73 | | | | | 0.34 | | |
| | Compound No. 74 | | | | | | 0.34 | |
| | Compound No. 101 | | | | | | | 0.34 |
| | Compound No. 131 | | | | | | | |
| | B'-1 | | | | | | | |
| | B'-2 | | | | | | | |
| | B'-3 | | | | | | | |
| | B'-4 | | | | | | | |
| C | C-1 | 50.9 | 50.9 | 50.9 | 50.9 | 50.9 | 50.9 | 50.9 |
| | C-2 | 11.9 | 11.9 | 11.9 | 11.9 | 11.9 | 11.9 | 11.9 |
| | C-3 | 34 | 34 | 34 | 34 | 34 | 34 | 34 |
| | C-4 | | | | | | | |

Table 2

| | | Ex. 1-8 | Ex. 1-9 | Com. Ex. 1-1 | Com. Ex. 1-2 | Com. Ex. 1-3 | Com. Ex. 1-4 | Com. Ex. 1-5 |
|---|---|---|---|---|---|---|---|---|
| A | A-1 | | | | | | | |
| | A-2 | | 0.4 | | | | | |
| | A-3 | | | | | | | |
| | A-4 | 0.4 | | | | | | |
| | A'-1 | | | | | | | |

(continued)

| | | Ex. 1-8 | Ex. 1-9 | Com. Ex. 1-1 | Com. Ex. 1-2 | Com. Ex. 1-3 | Com. Ex. 1-4 | Com. Ex. 1-5 |
|---|---|---|---|---|---|---|---|---|
| B | Compound No. 5 | | | 0.34 | | | | |
| | Compound No. 20 | | | | | | | |
| | Compound No. 51 | | | | 0.34 | | | |
| | Compound No. 71 | | | | | | | |
| | Compound No. 73 | | 0.34 | | | 0.34 | | |
| | Compound No. 74 | | | | | | | |
| | Compound No. 101 | | | | | | 0.34 | |
| | Compound No. 131 | 0.34 | | | | | | |
| | B'-1 | | | | | | | 0.34 |
| | B'-2 | | | | | | | |
| | B'-3 | | | | | | | |
| | B'-4 | | | | | | | |
| C | C-1 | 50.9 | 50.9 | 50.9 | 50.9 | 50.9 | 50.9 11.9 | 50.9 11.9 |
| | C-2 | 11.9 | 11.9 | 11.9 | 11.9 | 11.9 | 11.9 | 11.9 |
| | C-3 | 34 | 34 | 34 | 34 | 34 | 34 | 34 |
| | C-4 | | 50.0 | | | | | |

Table 3

| | | Com. Ex. 1-6 | Com. Ex. 1-7 | Com. Ex. 1-8 | Com. Ex. 1-9 | Com. Ex. 1-10 |
|---|---|---|---|---|---|---|
| A | A-1 | | | | | |
| | A-2 | | | | | |
| | A-3 | | | | | |
| | A-4 | | | | | |
| | A'-1 | | | | 0.4 | |

(continued)

| | | Com. Ex. 1-6 | Com. Ex. 1-7 | Com. Ex. 1-8 | Com. Ex. 1-9 | Com. Ex. 1-10 |
|---|---|---|---|---|---|---|
| B | Compound No. 5 | | | | 0.34 | |
| | Compound No. 20 | | | | | |
| | Compound No. 51 | | | | | |
| | Compound No. 71 | | | | | |
| | Compound No. 73 | | | | | 0.34 |
| | Compound No. 74 | | | | | |
| | Compound No. 1 0 1 | | | | | |
| | Compound No. 131 | | | | | |
| | B'-1 | | | | | |
| | B'-2 | 0.34 | | | | |
| | B'-3 | | 0.34 | | | |
| | B'-4 | | | 0.34 | | |
| C | C-1 | 50.9 | 50.9 | 50.9 | 50.9 | 50.9 |
| | C-2 | 11.9 | 11.9 | 11.9 | 11.9 | 11.9 |
| | C-3 | 34 | 34 | 34 | 34 | 34 |
| | C-4 | | | | | 50.0 |

Examples 2-1 to 2-3 and Comparative Examples 2-1 to 2-15

Preparation of colored compositions

Colored compositions were prepared in accordance formulations shown in Tables 3A to 3C to obtain polymerizable colored compositions (Examples 2-1 to 2-3 and Comparative Examples 2-1 to 2-15).

Table 3A

| | Ex. 2-1 | Com. Ex. 2-1 | Com. Ex. 2-2 | Com. Ex. 2-3 | Com. Ex. 2-4 | Com. Ex. 2-5 |
|---|---|---|---|---|---|---|
| A-2 | 0.3 | | 0.3 | | 0.3 | |
| A'-2 | | | | 0.3 | | 0.3 |
| Compound No. 73 | 1.0 | 1.0 | 1.0 | | | |
| B'-5 | | | | 1.0 | 1.0 | 1.0 |
| C-2 | 4.0 | 4.0 | 4.0 | 4.0 | 4.0 | 4.0 |
| C-3 | 34.5 | 34.1 | 34.5 | 34.5 | 34.1 | 34.5 |
| C-5 | 5.4 | 6.1 | 5.4 | 5.4 | 6.1 | 5.4 |
| C-6 | 54.4 | 54.4 | 54.4 | 54.4 | 54.4 | 54.4 |

Table 3B

| | Ex. 2-2 | Com. Ex. 2-6 | Com. Ex. 2-7 | Com. Ex. 2-8 | Com. Ex. 2-9 | Com. Ex. 2-10 |
|---|---|---|---|---|---|---|
| A-2 | 0.3 | | | | | |
| A'-2 | | | 0.3 | | | 0.3 |
| Compound No. 73 | 0.3 | 0.3 | 0.3 | | | |

(continued)

| | Ex. 2-2 | Com. Ex. 2-6 | Com. Ex. 2-7 | Com. Ex. 2-8 | Com. Ex. 2-9 | Com. Ex. 2-10 |
|---|---|---|---|---|---|---|
| B'-5 | | | | 0.3 | 0.3 | 0.3 |
| C-2 | 4.0 | 4.0 | 4.0 | 4.0 | 4.0 | 4.0 |
| C-3 | 33.6 | 33.2 | 33.6 | 33.6 | 33.2 | 33.6 |
| C-5 | 8.4 | 9.1 | 8.4 | 8.4 | 9.1 | 8.4 |
| C-7 | 53.1 | 53.1 | 53.1 | 53.1 | 53.1 | 53.1 |

Table 3C

| | Ex. 2-3 | Com. Ex. 2-11 | Com. Ex. 2-12 | Com. Ex. 2-13 | Com. Ex. 2-14 | Com. Ex. 2-15 |
|---|---|---|---|---|---|---|
| A-2 | 0.3 | | | 0.3 | | |
| A'-2 | | | 0.3 | | | 0.3 |
| Compound No. 73 | 0.9 | 0.9 | 0.9 | | | |
| B'-5 | | | | 0.9 | 0.9 | 0.9 |
| C-2 | 3.0 | 3.0 | 3.0 | 3.0 | 3.0 | 3.0 |
| C-3 | 45.1 | 44.7 | 45.1 | 45.1 | 44.7 | 45.1 |
| C-4 | 28.4 | 28.4 | 28.4 | 28.4 | 28.4 | 28.4 |
| C-5 | 21.9 | 22.6 | 21.9 | 21.9 | 22.6 | 21.9 |

[Chem. 38]

A-1

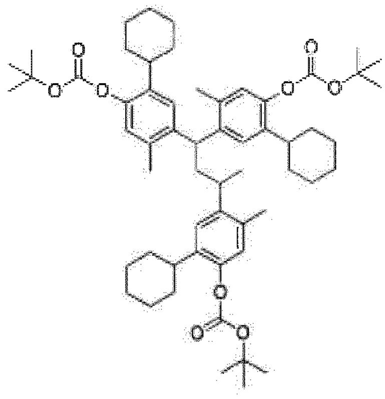

[Chem. 39]

A－2

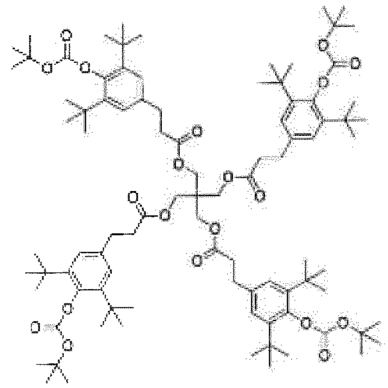

[Chem. 40]

A－3

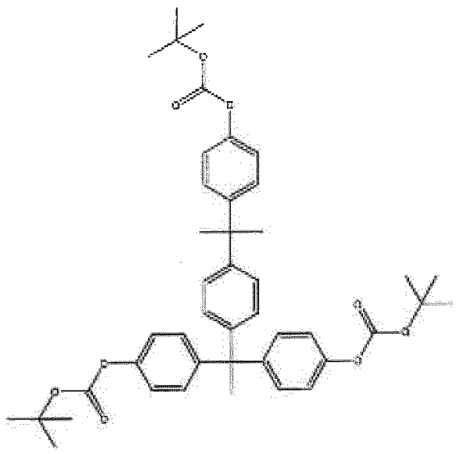

[Chem. 41]

A－4

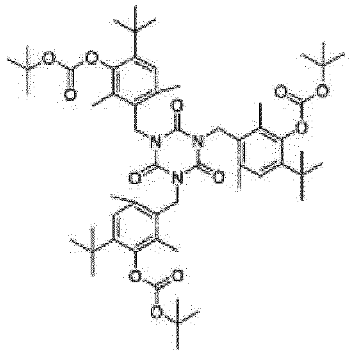

[Chem. 42]

A' - 1

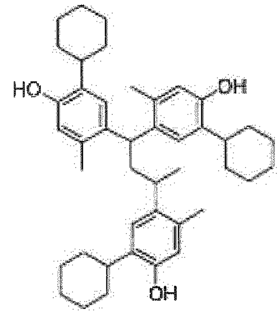

[Chem. 42A]

A' - 2

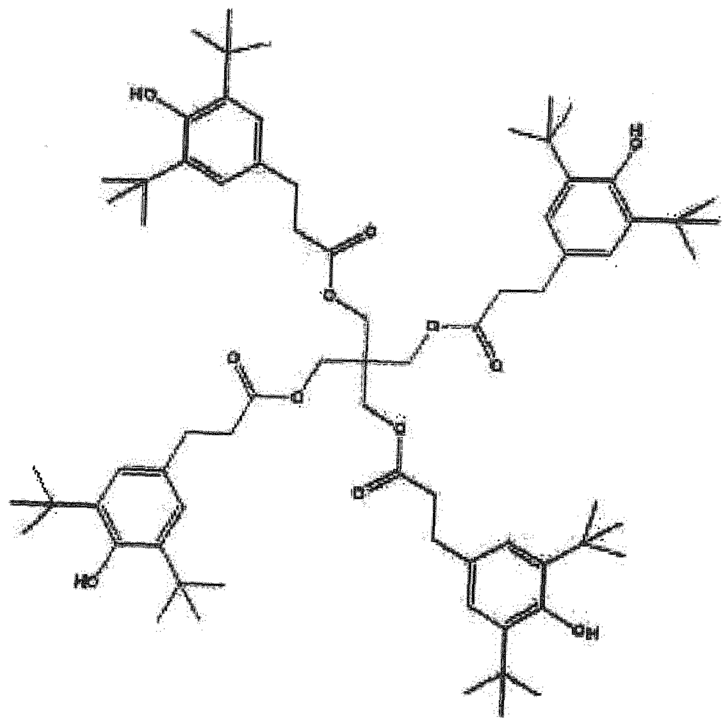

B'-1: 2,2'-Bis(2-chlorophenyl)-4,4',5,5'-tetraphenyl-1,2'-biimidazole (HABI)
B'-2: N-1717 (an acridine compound: manufactured by ADEKA Corporation)
B'-3: Lucirin TPO (manufactured by BASF)
B'-4: Benzophenone
B'-5: OXE-01 (manufactured by BASF)

C-1: SPC-1000 (manufactured by Showa Denko K.K., a PGMEA solution having a solid content of 29%)
C-2: KAYARAD DPHA (a polyfunctional acrylate; manufactured by Nippon Kayaku Co., Ltd.)
C-3: Propylene glycol-1-monomethyl ether-2-acetate
C-4: A blue pigment dispersion (This dispersion was prepared through a bead mill from 15 parts by mass of C.I. Pigment Blue 15:6 as a coloring agent, 12.5 parts by mass (solid content: 40 mass%) of BYK161 (manufactured by BYK) as a dispersant, and 72.5 parts by mass of propylene glycol monomethyl ether acetate as a solvent.)

C-5: SPC-3000 (manufactured by Showa Denko K.K., a PGMEA solution having a solid content of 42.7 mass%)
C-6: A red pigment dispersion (This dispersion was prepared through a bead mill from 15 parts by mass of C.I. Pigment Red 254 as a coloring agent, 8.0 parts by mass of AJISPER PB821 (manufactured by Ajinomoto Fine-Techno Co., Inc.) as a dispersant, and 77.0 parts by mass of PGMEA as a solvent.)
C-7: A green pigment dispersion (This dispersion was prepared through a bead mill from 15 parts by mass of C.I. Pigment Green 58 as a coloring agent, 7.0 parts by mass (solid content: 40 mass%) of BYK-LPN6919 (manufactured by BYK Japan KK) as a dispersant, and 78.0 parts by mass of PGMEA as a solvent.)

Evaluation Examples 1-1 to 1-9 and Comparative Evaluation Examples 1-1 to 1-10

Evaluation of sensitivity

The height of each of the patterns obtained in Examples 1-1 to 1-9 and Comparative Examples 1-1 to 1-10 above was measured using a stylus-type surface profile measuring instrument (manufactured by Keyence Corporation), and the persistence of the film (%) was calculated from the equation below and taken as a measure the radiation sensitivity. When the exposure needed to reach a persistence of the film of 70% or more was 20 mJ/cm$^2$, the composition was rated as A; when the exposure needed to reach a persistence of the film of 70% or more was more than 20 mJ/cm$^2$ and not more than 100 mJ/cm$^2$, the composition was rated as B; when the exposure needed to reach a persistence of the film of 70% or more was more than 100 mJ/cm$^2$ and not more than 200 mJ/cm$^2$, the composition was rated as C; and the persistence of the film did not reach 70% even at an exposure of 200 mJ/cm$^2$, the composition was rated as D. Table 4 shows the test results. It should be noted that in the equation below, the term "initial film thickness" refers to the film thickness after prebaking and prior to postbaking.

$$\text{Persistence of the film (\%)} = (\text{height of pattern after postbaking/initial film thickness}) \times 100$$

Table 4

| | Sensitivity | Transparency |
|---|---|---|
| Example 1 | A | a |
| Example 2 | B | a |
| Example 3 | A | a |
| Example 4 | A | a |
| Example 5 | A | a |
| Example 6 | A | a |
| Example 7 | A | a |
| Example 8 | A | a |
| Example 9 | B | a |
| Comparative Example 1 | A | c |
| Comparative Example 2 | C | c |
| Comparative Example 3 | C | c |
| Comparative Example 4 | D | c |
| Comparative Example 5 | D | b |
| Comparative Example 6 | D | b |
| Comparative Example 7 | D | a |
| Comparative Example 8 | D | a |
| Comparative Example 9 | D | a |
| Comparative Example 10 | D | c |

Evaluation Examples 2-1 to 2-9 and Comparative Evaluation Examples 2-1 to 2-10

Evaluation of transparency after baking

Coatings were obtained from the compositions prepared in accordance with the fomulations of Examples 1-1 to 1-9 and Comparative Examples 1-1 to 1-10 shown in Tables 1 to 3. Each coating was entirely cured without using a mask. The cured coating film was baked at 230°C for 120 minutes, and the transmittance of the resulting baked coating film at 400 nm was measured. The coating film having a transmittance of not less than 95% was rated as "a", the coating film having a transmittance of 90 to 94% was rated as "b", and the coating film having a transmittance of not more than 89% was rated as "c". Table 4 above shows the results.

Evaluation Examples 3-1 to 3-3 and Comparative Evaluation Examples 3-1 to 3-15

The sensitivity of the colored compositions obtained in Examples 2-1 to 2-3 and Comparative Examples 2-1 to 2-15 above was evaluated in accordance with the following method. Table 4A below shows the results. Each of the red colored compositions obtained in Example 2-1 and Comparative Examples 2-1 to 2-5 was applied to a glass substrate using a spin coater to a coating thickness such that the resulting coating satisfies x = 0.670, y = 0.330 under illuminant C, to thereby form a colored coating. The coating was exposed to light via a photomask having an opening of 30 μm at exposures of 20, 40, 60, or 80 mJ/cm$^2$ with an exposure gap of 100 μm. The resulting coating film was developed by discharging a developing solution, specifically a 0.04 mass% aqueous solution of potassium hydroxide at 23°C, at a developing pressure of 1 kgf/cm$^2$ (nozzle diameter: 1mm). Based on break time (BT), which is time necessary for complete dissolving of any unexposed portion, the developing time was 1.5 times as long as BT. After that, the resulting substrate was washed with ultrapure water, air-dried, and then, heated at 230°C for 20 minutes. Thus, a red colored pattern was formed on the substrate. Moreover, a green colored pattern was obtained in the same manner as described above except that each of the green colored compositions obtained in Example 2-2 and Comparative Examples 2-6 to 2-10 was used and applied to a coating thickness such that the resulting coating satisfies x = 0.240, y = 0.580 under illuminant C. Also, a blue colored pattern was obtained in the same manner as described above except that each of the blue colored compositions obtained in Example 2-3 and Comparative Examples 2-11 to 2-15 was used and applied to a coating thickness such that the resulting coating satisfies x = 0.135, y = 0.098 under illuminant C. The pattern width of the formed patterns at the photomask opening of 30 μm was measured.

A (Excellent): The line width was 30 μm or more at the exposure of 20 mJ/cm$^2$.
B (Good): Although the line width was less than 30 μm at the exposure of 20 mJ/cm$^2$, the line width was 30 μm or more at the exposure of 40 mJ/cm$^2$.
C (Fair): Although the line width was less than 30 μm at the exposures of 20 mJ/cm$^2$ and 40 mJ/cm$^2$, the line width was 30 μm or more at the exposure of 60 mJ/cm$^2$.
D (Poor): Although the line width was less than 30 μm at the exposures of 20 mJ/cm$^2$, 40 mJ/cm$^2$, and 60 mJ/cm$^2$, the line width was 30 μm or more at the exposure of 80 mJ/cm$^2$; or the line width was less than 30 μm even at the exposure of 80 mJ/cm$^2$.

Table 4A

| | Sensitivity |
|---|---|
| Example 2-1 | Excellent |
| Example 2-2 | Excellent |
| Example 2-3 | Excellent |
| Comparative Example 2-1 | Excellent |
| Comparative Example 2-2 | Excellent |
| Comparative Example 2-3 | Good |
| Comparative Example 2-4 | Good |
| Comparative Example 2-5 | Poor |
| Comparative Example 2-6 | Excellent |
| Comparative Example 2-7 | Poor |

(continued)

| | |
|---|---|
| Comparative Example 2-8 | Poor |
| Comparative Example 2-9 | Poor |
| Comparative Example 2-10 | Poor |
| Comparative Example 2-11 | Excellent |
| Comparative Example 2-12 | Excellent |
| Comparative Example 2-13 | Poor |
| Comparative Example 2-14 | Poor |
| Comparative Example 2-15 | Poor |

It is clear from the above results that the composition of the present invention can have both of high transmittance and high sensitivity as a result of using a latent antioxidant serving as the component (A) in combination with a specific oxime ester compound serving as the component (B).

## Claims

**1.** A composition comprising:

(i) a latent antioxidant (A), wherein the latent antioxidant (A) has a skeleton represented by General Formula (III) below:

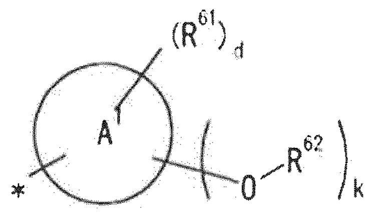

(III)

wherein

ring $A^1$ represents a five-membered or six-membered hydrocarbon ring or heterocycle,
$R^{61}$, independently for each occurence, represents a hydrogen atom, a halogen atom, a cyano group, a hydroxyl group, a nitro group, a carboxyl group, an optionally substituted alkyl group having 1 to 40 carbon atoms, an aryl group having 6 to 20 carbon atoms, an arylalkyl group having 7 to 20 carbon atoms, or a heterocycle-containing group having 2 to 20 carbon atoms,
$R^{62}$, independently for each occurence, represents an alkyl group having 1 to 20 carbon atoms, an alkenyl group having 2 to 20 carbon atoms, an aryl group having 6 to 20 carbon atoms, an arylalkyl group having 7 to 20 carbon atoms, a heterocycle-containing group having 2 to 20 carbon atoms, or a trialkylsilyl group,
a methylene group in the alkyl group or the arylalkyl group represented by $R^{61}$ and $R^{62}$ is optionally replaced with a group obtained by combining groups selected from the group consisting of a carbon-carbon double bond, -O-, -S-, -CO-, -O-CO-, -CO-O-, -O-CO-O-, -O-CO-O-, -S-CO-, -CO-S-, -S-CO-O-, -O-CO-S-, -CO-NH-, -NH-CO-, -NH-CO-O-, -NR'-, -S-S-, and $-SO_2-$ on the condition that oxygen atoms are not adjacent to each other when combined, R' representing a hydrogen atom or an alkyl group having 1 to 8 carbon atoms,
a plurality of the $R^{61}$ are optionally linked together to form a benzene ring or a naphthalene ring,
d represents an integer from 1 to 4, and
k represents an integer from 1 to 4, a total of d and k being not more than the possible maximum number of substituents with which ring $A^1$ is optionally substituted; and

(ii) a polymerization initiator (B) including one or more oxime ester compounds represented by General Formula (I) below:

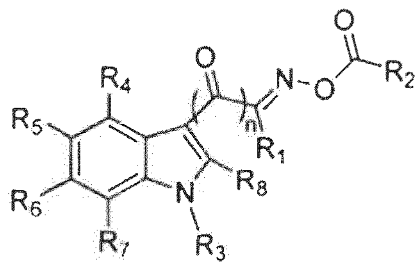

(I)

wherein

$R^1$ and $R^2$ independently represent $R^{11}$, $OR^{11}$, $COR^{11}$, $SR^{11}$, $CONR^{12}R^{13}$, or CN,
$R^{11}$, $R^{12}$, and $R^{13}$ independently represent a hydrogen atom, an alkyl group having 1 to 20 carbon atoms, an aryl group having 6 to 30 carbon atoms, an arylalkyl group having 7 to 30 carbon atoms, or a heterocycle-containing group having 2 to 20 carbon atoms,
a hydrogen atom in the group represented by $R^{11}$, $R^{12}$, and $R^{13}$ is optionally further replaced with $R^{21}$, $OR^{21}$, $COR^{21}$, $SR^{21}$, $NR^{22}R^{23}$, $CONR^{22}R^{23}$, $NR^{22}OR^{23}$, $NCOR^{22}OCOR^{23}$, $NR^{22}COR^{21}$, $OCOR^{21}$, $COOR^{21}$, $SCOR^{21}$, $OCSR^{21}$, $COSR^{21}$, $CSOR^{21}$, a hydroxyl group, a nitro group, CN, a halogen atom, or $COOR^{21}$,
$R^{21}$, $R^{22}$, and $R^{23}$ independently represent a hydrogen atom, an alkyl group having 1 to 20 carbon atoms, an aryl group having 6 to 30 carbon atoms, an arylalkyl group having 7 to 30 carbon atoms, or a heterocycle-containing group having 2 to 20 carbon atoms,
a hydrogen atom in the group represented by $R^{21}$, $R^{22}$, and $R^{23}$ is optionally further replaced with a hydroxyl group, a nitro group, CN, a halogen atom, a hydroxyl group, or a carboxyl group,
a methylene group of an alkylene moiety in the group represented by $R^{11}$, $R^{12}$, $R^{13}$, $R^{21}$, $R^{22}$, and $R^{23}$ is optionally replaced with -O-, -S-, -COO-, -OCO-, -OCOO-, $-CONR^{24}-$, $-NR^{24}-$, $-NR^{24}CO-$, $-NR^{24}COO-$, $-OCONR^{24}-$, -SCO-, -COS-, -OCS-, or -SCOO-,
$R^{24}$ represents a hydrogen atom, an alkyl group having 1 to 20 carbon atoms, an aryl group having 6 to 30 carbon atoms, an arylalkyl group having 7 to 30 carbon atoms, or a heterocycle-containing group having 2 to 20 carbon atoms,
an alkyl moiety in the group represented by $R^{11}$, $R^{12}$ , $R^{13}$, $R^{21}$, $R^{22}$, $R^{23}$, and $R^{24}$ optionally has a branched side chain or is optionally a cyclic alkyl,
$R^3$ represents a hydrogen atom, an alkyl group having 1 to 20 carbon atoms, an aryl group having 6 to 30 carbon atoms, an arylalkyl group having 7 to 30 carbon atoms, or a heterocycle-containing group having 2 to 20 carbon atoms, an alkyl moiety in the group represented by $R^3$ optionally having a branched side chain or optionally being a cyclic alkyl, and pairs of $R^3$ and $R^7$, $R^3$ and $R^8$, $R^4$ and $R^5$, $R^5$ and $R^6$, and $R^6$ and $R^7$ each optionally forming a ring together,
a hydrogen atom in the group represented by $R^3$ is optionally further replaced with $R^{21}$, $OR^{21}$, $COR^{21}$, $SR^{21}$, $NR^{22}R^{23}$, $CONR^{22}R^{23}$, $NR^{22}OR^{23}$, $NCOR^{22}OCOR^{23}$, $NR^{22}COR^{21}$, $OCOR^{21}$, $COOR^{21}$, $SCOR^{21}$, $OCSR^{21}$, $COSR^{21}$, $CSOR^{21}$, a hydroxyl group, a nitro group, CN, a halogen atom, or $COOR^{21}$,
$R^4$, $R^5$, $R^6$, and $R^7$ independently represent $R^{11}$, $OR^{11}$, $SR^{11}$, $COR^{14}$, $CONR^{15}R^{16}$, $NR^{12}COR^{11}$, $OCOR^{11}$, $COOR^{14}$, $SCOR^{11}$, $OCSR^{11}$, $COSR^{14}$, $CSOR^{11}$, a hydroxyl group, CN, or a halogen atom, pairs of $R^4$ and $R^5$, $R^5$ and $R^6$, and $R^6$ and $R^7$ each optionally forming a ring together,
a hydrogen atom in the group represented by $R^4$, $R^5$, $R^6$, and $R^7$ is optionally further replaced with $R^{21}$, $OR^{21}$, $COR^{21}$, $SR^{21}$, $NR^{22}R^{23}$, $CONR^{22}R^{23}$, $NR^{12}OR^{23}$, $NCOR^{22}OCOR^{23}$, $NR^{22}COR^{21}$, $OCOR^{21}$, $COOR^{21}$, $SCOR^{21}$, $OCSR^{21}$, $COSR^{21}$, $CSOR^{21}$, a hydroxyl group, a nitro group, CN, a halogen atom, or $COOR^{21}$,
$R^{14}$, $R^{15}$, and $R^{16}$ represent a hydrogen atom or an alkyl group having 1 to 20 carbon atoms,
an alkyl moiety in the group represented by $R^{14}$, $R^{15}$, and $R^{16}$ optionally has a branched side chain or is optionally a cyclic alkyl,
$R^8$ represents $R^{11}$, $OR^{11}$, $SR^{11}$, $COR^{11}$, $CONR^{12}R^{13}$, $NR^{12}COR^{11}$, $OCOR^{11}$, $COOR^{11}$, $SCOR^{11}$, $OCSR^{11}$, $COSR^{11}$, $CSOR^{11}$, a hydroxyl group, CN, or a halogen atom, and
n represents 0 or 1.

2. The composition according to claim 1, wherein the latent antioxidant (A) is a compound represented by General Formula (III-A) below:

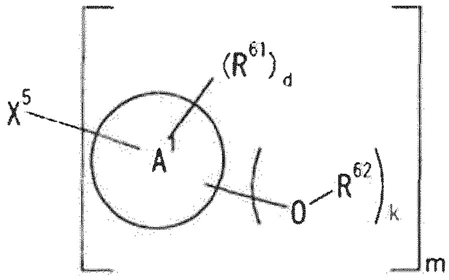

(III-A)

wherein

ring $A^1$ represents a five-membered or six-membered hydrocarbon ring or heterocycle,
$R^{61}$, independently for each occurence, represents a hydrogen atom, a halogen atom, a cyano group, a hydroxyl group, a nitro group, a carboxyl group, an optionally substituted alkyl group having 1 to 40 carbon atoms, an aryl group having 6 to 20 carbon atoms, an arylalkyl group having 7 to 20 carbon atoms, or a heterocycle-containing group having 2 to 20 carbon atoms,
$R^{62}$, independently for each occurence, represents an alkyl group having 1 to 20 carbon atoms, an alkenyl group having 2 to 20 carbon atoms, an aryl group having 6 to 20 carbon atoms, an arylalkyl group having 7 to 20 carbon atoms, a heterocycle-containing group having 2 to 20 carbon atoms, or a trialkylsilyl group,
a methylene group in the alkyl group or the arylalkyl group represented by $R^{61}$ and $R^{62}$ is optionally replaced with a group obtained by combining groups selected from the group consisting of a carbon-carbon double bond, -O-, -S-, -CO-, -O-CO-, -CO-O-, -O-CO-O-, -O-CO-O-, -S-CO-, -CO-S-, -S-CO-O-, -O-CO-S-, -CO-NH-, -NH-CO-, -NH-CO-O-, -NR'-, -S-S-, and $-SO_2-$ on the condition that oxygen atoms are not adjacent to each other when combined, R' representing a hydrogen atom or an alkyl group having 1 to 8 carbon atoms,
a plurality of the $R^{61}$ are optionally linked together to form a benzene ring or a naphthalene ring,
m represents an integer from 1 to 10,
d represents an integer from 1 to 4,
k represents an integer from 1 to 4, a total of d and k being not more than the possible maximum number of substituents with which ring $A^1$ is optionally substituted, and
$X^5$ represents a direct bond or an m-valent atom, inorganic group, or organic group.

**Patentansprüche**

1. Zusammensetzung, umfassend:

(i) ein latentes Antioxidans (A), wobei das latente Antioxidans (A) ein Skelett hat, das durch die nachstehende allgemeine Formel (III) dargestellt wird:

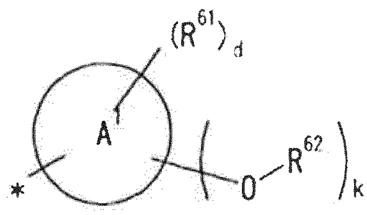

(III)

worin

der Ring $A^1$ einen fünfgliedrigen oder sechsgliedrigen Kohlenwasserstoffring oder Heterocyclus darstellt,
$R^{61}$ stellt unabhängig für jedes Vorkommen ein Wasserstoffatom, ein Halogenatom, eine Cyanogruppe, eine Hydroxylgruppe, eine Nitrogruppe, eine Carboxylgruppe, eine gegebenenfalls substituierte Alkylgruppe mit 1 bis 40 Kohlenstoffatomen, eine Arylgruppe mit 6 bis 20 Kohlenstoffatomen, eine Arylalkylgruppe mit 7 bis 20 Kohlenstoffatomen oder eine einen Heterocyclus enthaltende Gruppe mit 2 bis 20 Kohlenstoffatomen darstellt,
$R^{62}$ unabhängig für jedes Vorkommen eine Alkylgruppe mit 1 bis 20 Kohlenstoffatomen, eine Alkenylgruppe mit 2 bis 20 Kohlenstoffatomen, eine Arylgruppe mit 6 bis 20 Kohlenstoffatomen, eine Arylalkylgruppe mit

7 bis 20 Kohlenstoffatomen, einen Heterocyclus enthaltende Gruppe mit 2 bis 20 Kohlenstoffatomen oder eine Trialkylsilylgruppe darstellt,
eine Methylengruppe in der Alkylgruppe oder der Arylalkylgruppe, dargestellt durch $R^{61}$ und $R^{62}$, gegebenenfalls durch eine Gruppe ersetzt ist, die durch Kombinieren von Gruppen erhalten wird, ausgewählt aus der Gruppe, bestehend aus einer Kohlenstoff-Kohlenstoff-Doppelbindung, -O-, -S-, - CO-, -O-CO-, -CO-O-, -O-CO-O-, -O-CO-O-, -S-CO-, -CO-S-, -S-CO-O-, -O-CO-S-, -CO-NH-, -NH-CO-, -NH-CO-O-, -NR'-, -S-S-, und $-SO_2-$ unter der Bedingung, dass Sauerstoffatome nicht benachbart zueinander sind, wenn sie kombiniert sind, wobei R' ein Wasserstoffatom oder eine Alkylgruppe mit 1 bis 8 Kohlenstoffatomen darstellt, eine Vielzahl von $R^{61}$ gegebenenfalls miteinander verbunden sind, um einen Benzolring oder einen Naphthalinring zu bilden, d eine ganze Zahl von 1 bis 4 darstellt, und
k eine ganze Zahl von 1 bis 4 darstellt, wobei d und k insgesamt nicht mehr als die mögliche maximale Anzahl von Substituenten sind, mit denen Ring $A^1$ gegebenenfalls substituiert ist; und

(ii) einen Polymerisationsinitiator (B), der eine oder mehrere Oximesterverbindungen enthält, die durch die nachstehende allgemeine Formel (I) dargestellt werden:

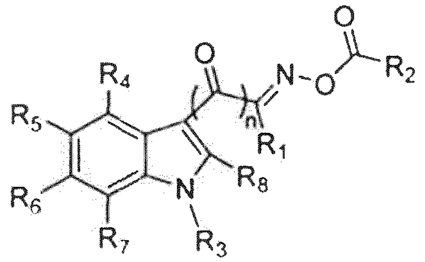
(I)

worin

$R^1$ und $R^2$ unabhängig voneinander $R^{11}$, $OR^{11}$, $COR^{11}$, $SR^{11}$, $CONR^{12}R^{13}$ oder CN darstellen,
$R^{11}$, $R^{12}$ und $R^{13}$ unabhängig voneinander ein Wasserstoffatom, eine Alkylgruppe mit 1 bis 20 Kohlenstoffatomen, eine Arylgruppe mit 6 bis 30 Kohlenstoffatomen, eine Arylalkylgruppe mit 7 bis 30 Kohlenstoffatomen oder eine einen Heterocyclus enthaltende Gruppe mit 2 dar bis 20 Kohlenstoffatomen darstellen,
ein Wasserstoffatom in der durch $R^{11}$, $R^{12}$ und $R^{13}$ dargestellten Gruppe gegebenenfalls weiter durch $R^{21}$, $OR^{21}$, $COR^{21}$, $SR^{21}$, $NR^{22}R^{23}$, $CONR^{22}R^{23}$, $NR^{12}OR^{23}$, $NCOR^{22}OCOR^{23}$, $NR^{22}COR^{21}$, $OCOR^{21}$, $COOR^{21}$, $SCOR^{21}$, $OCSR^{21}$, $COSR^{21}$, $CSOR^{21}$, a Hydroxylgruppe, eine Nitrogruppe, CN, ein Halogenatom oder $COOR^{21}$ ersetzt ist, $R^{21}$, $R^{22}$ und $R^{23}$ unabhängig voneinander ein Wasserstoffatom, eine Alkylgruppe mit 1 bis 20 Kohlenstoffatomen, eine Arylgruppe mit 6 bis 30 Kohlenstoffatomen, eine Arylalkylgruppe mit 7 bis 30 Kohlenstoffatomen oder eine einen Heterocyclus enthaltende Gruppe mit 2 bis 20 Kohlenstoffatomen darstellen,
ein Wasserstoffatom in der durch $R^{21}$, $R^{22}$ und $R^{23}$ dargestellten Gruppe gegebenenfalls weiter durch eine Hydroxylgruppe, eine Nitrogruppe, CN, ein Halogenatom, eine Hydroxylgruppe oder eine Carboxylgruppe ersetzt ist,
eine Methylengruppe einer Alkyleneinheit in der durch $R^{11}$, $R^{12}$, $R^{13}$, $R^{21}$, $R^{22}$ und $R^{23}$ dargestellten Gruppe gegebenenfalls durch - O-, -S-, -COO-, -OCO-, -OCOO-, $-CONR^{24}-$, $-NR^{24}-$, $-NR^{24}CO-$, $-NR^{24}COO-$, $-OCONR^{24}-$, -SCO-, -COS-, -OCS- oder -SCOO- ersetzt ist,
$R^{24}$ ein Wasserstoffatom, eine Alkylgruppe mit 1 bis 20 Kohlenstoffatomen, eine Arylgruppe mit 6 bis 30 Kohlenstoffatomen, eine Arylalkylgruppe mit 7 bis 30 Kohlenstoffatomen oder eine einen Heterocyclus enthaltende Gruppe mit 2 bis 20 Kohlenstoffatomen darstellt,
eine Alkyleinheit in der durch $R^{11}$, $R^{12}$, $R^{13}$, $R^{21}$, $R^{22}$, $R^{23}$ und $R^{24}$ dargestellten Gruppe gegebenenfalls eine verzweigte Seitenkette aufweist oder optional ein cyclisches Alkyl ist,
$R^3$ ein Wasserstoffatom, eine Alkylgruppe mit 1 bis 20 Kohlenstoffatomen, eine Arylgruppe mit 6 bis 30 Kohlenstoffatomen, eine Arylalkylgruppe mit 7 bis 30 Kohlenstoffatomen oder eine einen Heterocyclus enthaltende Gruppe mit 2 bis 20 Kohlenstoffatomen darstellt, wobei eine Alkyleinheit in der durch $R^3$ dargestellten Gruppe gegebenenfalls eine verzweigte Seitenkette aufweist oder gegebenenfalls ein cyclisches Alkyl ist, und Paare von $R^3$ und $R^7$, $R^3$ und $R^8$, $R^4$ und $R^5$, $R^5$ und $R^6$ und $R^6$ und $R^7$ jeweils gegebenenfalls zusammen einen Ring bilden,
ein Wasserstoffatom in der durch $R^3$ dargestellten Gruppe gegebenenfalls weiter ersetzt ist durch $R^{21}$, $OR^{21}$, $COR^{21}$, $SR^{21}$, $NR^{22}R^{23}$, $CONR^{22}R^{23}$, $NR^{12}OR^{23}$, $NCOR^{22}OCOR^{23}$, $NR^{22}COR^{21}$, $OCOR^{21}$,

$COOR^{21}$, $SCOR^{21}$, $OCSR^{21}$, $COSR^{21}$, $CSOR^{21}$, eine Hydroxylgruppe, ein Nitrogruppe, CN, ein Halogenatom oder $COOR^{21}$,

$R^4$, $R^5$, $R^6$ und $R^7$ unabhängig voneinander $R^{11}$, $OR^{11}$, $SR^{11}$, $COR^{14}$, $CONR^{15}R^{16}$, $NR^{12}COR^{11}$, $OCOR^{11}$, $COOR^{14}$, $SCOR^{11}$, $OCSR^{11}$, $COSR^{14}$, $CSOR^{11}$, eine Hydroxylgruppe, CN oder ein Halogenatom darstellen, wobei Paare von $R^4$ und $R^5$, $R^5$ und $R^6$ und $R^6$ und $R^7$ jeweils gegebenenfalls zusammen einen Ring bilden, ein Wasserstoffatom in der durch $R^4$, $R^5$, $R^6$ und $R^7$ dargestellten Gruppe gegebenenfalls weiter ersetzt ist durch $R^{21}$, $OR^{21}$, $COR^{21}$, $SR^{21}$, $NR^{22}R^{23}$, $CONR^{22}R^{23}$, $NR^{12}OR^{23}$, $NCOR^{22}OCOR^{23}$, $NR^{22}COR^{21}$, $OCOR^{21}$, $COOR^{21}$, $SCOR^{21}$, $OCSR^{21}$, $COSR^{21}$, $CSOR^{21}$, eine Hydroxylgruppe, eine Nitrogruppe, CN, ein Halogenatom oder $COOR^{21}$,

$R^{14}$, $R^{15}$ und $R^{16}$ ein Wasserstoffatom oder eine Alkylgruppe mit 1 bis 20 Kohlenstoffatomen darstellen, eine Alkyleinheit in der durch $R^{14}$, $R^{15}$ und $R^{16}$ dargestellten Gruppe gegebenenfalls eine verzweigte Seitenkette aufweist oder gegebenenfalls ein cyclisches Alkyl ist,

$R^8$ für $R^{11}$, $OR^{11}$, $SR^{11}$, $COR^{11}$, $CONR^{12}R^{13}$, $NR^{12}COR^{11}$, $OCOR^{11}$, $COOR^{11}$, $SCOR^{11}$, $OCSR^{11}$, $COSR^{11}$, $CSOR^{11}$, eine Hydroxylgruppe, CN oder ein Halogenatom steht, und

n für 0 oder 1 steht.

2. Zusammensetzung nach Anspruch 1, wobei das latente Antioxidans (A) eine Verbindung ist, die durch die nachstehende allgemeine Formel (III-A) dargestellt wird:

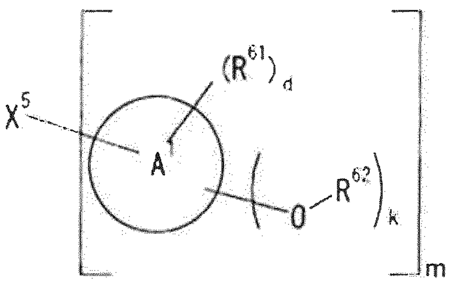
(III-A)

worin

der Ring $A^1$ einen fünfgliedrigen oder sechsgliedrigen Kohlenwasserstoffring oder Heterocyclus darstellt,

$R^{61}$ unabhängig für jedes Vorkommen ein Wasserstoffatom, ein Halogenatom, eine Cyanogruppe, eine Hydroxylgruppe, eine Nitrogruppe, eine Carboxylgruppe, eine gegebenenfalls substituierte Alkylgruppe mit 1 bis 40 Kohlenstoffatomen, eine Arylgruppe mit 6 bis 20 Kohlenstoffatomen, eine Arylalkylgruppe mit 7 bis 20 Kohlenstoffatomen oder eine einen Heterocyclus enthaltende Gruppe mit 2 bis 20 Kohlenstoffatomen darstellt,

$R^{62}$ unabhängig für jedes Vorkommen für eine Alkylgruppe mit 1 bis 20 Kohlenstoffatomen, eine Alkenylgruppe mit 2 bis 20 Kohlenstoffatomen, eine Arylgruppe mit 6 bis 20 Kohlenstoffatomen, eine Arylalkylgruppe mit 7 bis 20 Kohlenstoffatomen, eine einen Heterocyclus enthaltende Gruppe mit 2 bis 20 Kohlenstoffatomen oder eine Trialkylsilylgruppe darstellt,

eine Methylengruppe in der Alkylgruppe oder der Arylalkylgruppe, dargestellt durch $R^{61}$ und $R^{62}$, gegebenenfalls durch eine Gruppe ersetzt ist, die durch Kombinieren von Gruppen erhalten wird, ausgewählt aus der Gruppe, bestehend aus einer Kohlenstoff-Kohlenstoff-Doppelbindung, -O-, -S-, -CO-, -O-CO-, -CO-O-, -O-CO-O-, -O-CO-O-, -S-CO-, -CO-S-, -S-CO-O-, - O-CO-S-, -CO-NH-, -NH-CO-, -NH-CO-O-, -NR'-, -SS- und $-SO_2-$, unter der Bedingung, dass Sauerstoffatome nicht benachbart zueinander sind, wenn sie kombiniert sind, wobei R' ein Wasserstoffatom oder eine Alkylgruppe mit 1 bis 8 Kohlenstoffatomen darstellt,

eine Vielzahl von $R^{61}$ gegebenenfalls miteinander verbunden sind, um einen Benzolring oder einen Naphthalinring zu bilden,

m eine ganze Zahl von 1 bis 10 darstellt,

d eine ganze Zahl von 1 bis 4 darstellt,

k eine ganze Zahl von 1 bis 4 darstellt, wobei d und k insgesamt nicht mehr als die mögliche maximale Anzahl von Substituenten sind, mit denen Ring $A^1$ gegebenenfalls substituiert ist, und

$X^5$ eine direkte Bindung oder ein m-wertiges Atom, eine anorganische Gruppe oder eine organische Gruppe darstellt.

**Revendications**

1. Composition comprenant :

(i) un antioxydant latent (A), dans lequel l'antioxydant latent (A) a un squelette représenté par la formule générale (III) ci-dessous:

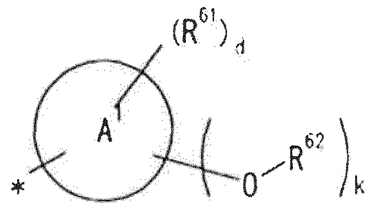

(III)

où

le cycle $A^1$ représente un cycle hydrocarboné ou un hétérocycle à cinq ou six chaînons,
$R^{61}$, indépendamment pour chaque occurrence, représente un atome d'hydrogène, un atome d'halogène, un groupe cyano, un groupe hydroxyle, un groupe nitro, un groupe carboxyle, un groupe alkyle éventuellement substitué ayant 1 à 40 atomes de carbone, un groupe aryle ayant 6 à 20 atomes de carbone, un groupe arylalkyle ayant 7 à 20 atomes de carbone, ou un groupe ayant 2 à 20 atomes de carbone contenant un hétérocycle,
$R^{62}$, indépendamment pour chaque occurrence, représente un groupe alkyle ayant 1 à 20 atomes de carbone, un groupe alcényle ayant 2 à 20 atomes de carbone, un groupe aryle ayant 6 à 20 atomes de carbone, un groupe arylalkyle ayant 7 à 20 atomes de carbone, un groupe ayant 2 à 20 atomes de carbone contenant un hétérocycle, ou un groupe trialkylsilyle,
un groupe méthylène dans le groupe alkyle ou le groupe arylalkyle représenté par $R^{61}$ et $R^{62}$ est éventuellement remplacé par un groupe obtenu en combinant des groupes choisis dans le groupe constitué d'une double liaison carbone-carbone, -O-, - S-, -CO-, -O-CO-, -CO-O-, -O-CO-O-, -O-CO-O-, -S-CO-, -CO-S-, -S-CO-O-, -O-CO-S-, -CO-NH-, -NH-CO-, -NH-CO-O-, -NR'-, -S-S-, et $-SO_2-$ à condition que les atomes d'oxygène ne soient pas adjacents à l'un à l'autre lorsqu'ils sont combinés, R' représentant un atome d'hydrogène ou un groupe alkyle ayant 1 à 8 atomes de carbone,
une pluralité de $R^{61}$ sont facultativement liés ensemble pour former un cycle benzénique ou un cycle naphtalénique,
d représente un nombre entier de 1 à 4, et
k représente un nombre entier de 1 à 4, un total de d et k n'étant pas supérieur au nombre maximum possible de substituants par lesquels le cycle $A^1$ est éventuellement substitué; et

(ii) un initiateur de polymérisation (B) comprenant un ou plusieurs composés d'ester d'oxime représentés par la formule générale (I) ci-dessous:

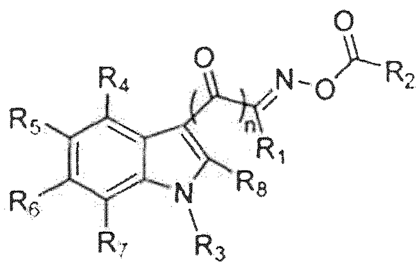

(I)

où

$R^1$ et $R^2$ représentent indépendamment $R^{11}$, $OR^{11}$, $COR^{11}$, $SR^{11}$, $CONR^{12}R^{13}$ ou CN,
$R^{11}$, $R^{12}$ et $R^{13}$ représentent indépendamment un atome d'hydrogène, un groupe alkyle ayant 1 à 20 atomes de carbone, un groupe aryle ayant 6 à 30 atomes de carbone, un groupe arylalkyle ayant 7 à 30 atomes de carbone, ou un groupe ayant 2 à 20 atomes de carbone contenant un hétérocycle ,

un atome d'hydrogène dans le groupe représenté par $R^{11}$, $R^{12}$ et $R^{13}$ est éventuellement en outre remplacé par $R^{21}$, $OR^{21}$, $COR^{21}$, $SR^{21}$, $NR^{22}R^{23}$, $CONR^{22}R^{23}$, $NR^{12}OR^{23}$, $NCOR^{22}OCOR^{23}$, $NR^{22}COR^{21}$, $OCOR^{21}$, $COOR^{21}$, $SCOR^{21}$, $OCSR^{21}$, $COSR^{21}$, $CSOR^{21}$, a un groupe hydroxyle, un groupe nitro, CN, un atome d'halogène, ou $COOR^{21}$,

$R^{21}$, $R^{22}$ et $R^{23}$ représentent indépendamment un atome d'hydrogène, un groupe alkyle ayant 1 à 20 atomes de carbone, un groupe aryle ayant 6 à 30 atomes de carbone, un groupe arylalkyle ayant 7 à 30 atomes de carbone, ou un groupe ayant 2 à 20 atomes de carbone contenant un hétérocycle,

un atome d'hydrogène dans le groupe représenté par $R^{21}$, $R^{22}$ et $R^{23}$ est éventuellement en outre remplacé par un groupe hydroxyle, un groupe nitro, CN, un atome d'halogène, un groupe hydroxyle ou un groupe carboxyle,

un groupe méthylène d'un fragment alkylène dans le groupe représenté par $R^{11}$, $R^{12}$, $R^{13}$, $R^{21}$, $R^{22}$, et $R^{23}$ est facultativement remplacé par -O-, -S-, -COO-, -OCO-, -OCOO-, $-CONR^{24}-$, $-NR^{24}-$, $-NR^{24}CO-$, $-NR^{24}COO-$, $-OCONR^{24}-$, -SCO-, -COS-, -OCS- ou -SCOO-,

$R^{24}$ représente un atome d'hydrogène, un groupe alkyle ayant 1 à 20 atomes de carbone, un groupe aryle ayant 6 à 30 atomes de carbone, un groupe arylalkyle ayant 7 à 30 atomes de carbone, ou un groupe ayant 2 à 20 atomes de carbone contenant un hétérocycle,

un fragment alkyle dans le groupe représenté par $R^{11}$, $R^{12}$, $R^{13}$, $R^{21}$, $R^{22}$, $R^{23}$ et $R^{24}$ a éventuellement une chaîne latérale ramifiée ou est éventuellement un alkyle cyclique,

$R^3$ représente un atome d'hydrogène, un groupe alkyle ayant 1 à 20 atomes de carbone, un groupe aryle ayant 6 à 30 atomes de carbone, un groupe arylalkyle ayant 7 à 30 atomes de carbone, ou un groupe ayant 2 à 20 atomes de carbone contenant un hétérocycle, un fraction alkyle dans le groupe représenté par $R^3$ ayant éventuellement une chaîne latérale ramifiée ou étant éventuellement un alkyle cyclique, et des paires de $R^3$ et $R^7$, $R^3$ et $R^8$, $R^4$ et $R^5$, $R^5$ et $R^6$, et $R^6$ et $R^7$ chacun ensemble formant éventuellement un cycle,

un atome d'hydrogène dans le groupe représenté par $R^3$ est éventuellement en outre remplacé par $R^{21}$, $OR^{21}$, $COR^{21}$, $SR^{21}$, $NR^{22}R^{23}$, $CONR^{22}R^{23}$, $NR^{12}OR^{23}$, $NCOR^{22}OCOR^{23}$, $NR^{22}COR^{21}$, $OCOR^{21}$, $COOR^{21}$, $SCOR^{21}$, $OCSR^{21}$, $COSR^{21}$, $CSOR^{21}$, un groupe hydroxyle, un groupe nitro, CN, un atome d'halogène, ou $COOR^{21}$,

$R^4$, $R^5$, $R^6$ et $R^7$ représentent indépendamment $R^{11}$, $OR^{11}$, $SR^{11}$, $COR^{14}$, $CONR^{15}R^{16}$, $NR^{12}COR^{11}$, $OCOR^{11}$, $COOR^{14}$, $SCOR^{11}$, $OCSR^{11}$, $COSR^{14}$, $CSOR^{11}$, un groupe hydroxyle, CN ou un atome d'halogène, paires de $R^4$ et $R^5$, $R^5$ et $R^6$, et $R^6$ et $R^7$ chacun ensemble formant éventuellement un cycle,

un atome d'hydrogène dans le groupe représenté par $R^4$, $R^5$, $R^6$ et $R^7$ est éventuellement encore remplacé par $R^{21}$, $OR^{21}$, $COR^{21}$, $SR^{21}$, $NR^{22}R^{23}$, $CONR^{22}R^{23}$, $NR^{12}OR^{23}$, $NCOR^{22}OCOR^{23}$, $NR^{22}COR^{21}$, $OCOR^{21}$, $COOR^{21}$, $SCOR^{21}$, $OCSR^{21}$, $COSR^{21}$, $CSOR^{21}$, un groupe hydroxyle, un groupe nitro, CN, un atome d'halogène, ou $COOR^{21}$,

$R^{14}$, $R^{15}$ et $R^{16}$ représentent un atome d'hydrogène ou un groupe alkyle ayant 1 à 20 atomes de carbone, un fragment alkyle dans le groupe représenté par $R^{14}$, $R^{15}$ et $R^{16}$ a éventuellement une chaîne latérale ramifiée ou est éventuellement un alkyle cyclique,

$R^8$ représente $R^{11}$, $OR^{11}$, $SR^{11}$, $COR^{11}$, $CONR^{12}R^{13}$, $NR^{12}COR^{11}$, $OCOR^{11}$, $COOR^{11}$, $SCOR^{11}$, $OCSR^{11}$, $COSR^{11}$, $CSOR^{11}$, un groupe hydroxyle, CN ou un atome d'halogène, et

n représente 0 ou 1.

**2.** Composition selon la revendication 1, dans laquelle l'antioxydant latent (A) est un composé représenté par la formule générale (III-A) ci-dessous :

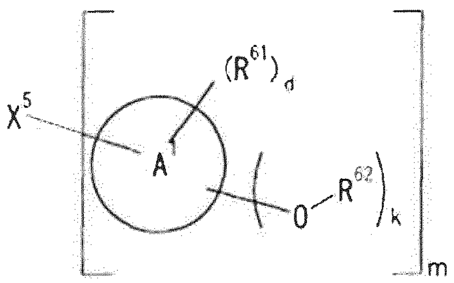

(III-A)

où

le cycle $A^1$ représente un cycle hydrocarboné ou un hétérocycle à cinq ou six chaînons,

$R^{61}$, indépendamment pour chaque occurrence, représente un atome d'hydrogène, un atome d'halogène, un

groupe cyano, un groupe hydroxyle, un groupe nitro, un groupe carboxyle, un groupe alkyle éventuellement substitué ayant 1 à 40 atomes de carbone, un groupe aryle ayant 6 à 20 atomes de carbone, un groupe arylalkyle ayant 7 à 20 atomes de carbone, ou un groupe ayant 2 à 20 atomes de carbone contenant un hétérocycle,
$R^{62}$, indépendamment pour chaque occurrence, représente un groupe alkyle ayant 1 à 20 atomes de carbone, un groupe alcényle ayant 2 à 20 atomes de carbone, un groupe aryle ayant 6 à 20 atomes de carbone, un groupe arylalkyle ayant 7 à 20 atomes de carbone, un groupe ayant 2 à 20 atomes de carbone contenant un hétérocycle, ou un groupe trialkylsilyle,
un groupe méthylène dans le groupe alkyle ou le groupe arylalkyle représenté par $R^{61}$ et $R^{62}$ est éventuellement remplacé par un groupe obtenu en combinant des groupes choisis dans le groupe constitué d'une double liaison carbone-carbone, -O-, - S-, -CO-, -O-CO-, -CO-O-, -O-CO-O-, -O-CO-O-, -S-CO-, -CO-S-, -S-CO-O-, -O-CO-S-, -CO-NH-, -NH-CO-, -NH-CO-O-, -NR'-, -S-S-, et $-SO_2-$ à condition que les atomes d'oxygène ne soient pas adjacents à l'un à l'autre lorsqu'ils sont combinés, R' représentant un atome d'hydrogène ou un groupe alkyle ayant 1 à 8 atomes de carbone,
une pluralité de $R^{61}$ sont éventuellement liés ensemble pour former un cycle benzénique ou un cycle naphtalénique,
m représente un nombre entier de 1 à 10,
d représente un nombre entier de 1 à 4,
k représente un nombre entier de 1 à 4, un total de d et k n'étant pas supérieur au nombre maximum possible de substituants par lesquels le cycle $A^1$ est éventuellement substitué, et
$X^5$ représente une liaison directe ou un atome de valence m, un groupe inorganique ou un groupe organique.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012247591 A
- JP 2014052424 A
- JP S4537377 B
- WO 0052529 A